(19) **Europäisches Patentamt**
**European Patent Office**
**Office européen des brevets**

(11) **EP 3 580 584 B1**

(12) **EUROPEAN PATENT SPECIFICATION**

(45) Date of publication and mention
of the grant of the patent:
**03.03.2021 Bulletin 2021/09**

(21) Application number: **18702724.8**

(22) Date of filing: **07.02.2018**

(51) Int Cl.:
*G01S 17/42* (2006.01)     *G01S 7/481* (2006.01)
*G01S 5/16* (2006.01)     *H01L 51/00* (2006.01)
*H01L 51/42* (2006.01)     *H01L 31/0256* (2006.01)

(86) International application number:
**PCT/EP2018/053070**

(87) International publication number:
**WO 2018/146146 (16.08.2018 Gazette 2018/33)**

(54) **DETECTOR FOR AN OPTICAL DETECTION OF AT LEAST ONE OBJECT**

DETEKTOR ZUR OPTISCHEN DETEKTION VON MINDESTENS EINEM OBJEKT

DÉTECTEUR POUR DÉTECTION OPTIQUE D'AU MOINS UN OBJET

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **08.02.2017 EP 17155265**

(43) Date of publication of application:
**18.12.2019 Bulletin 2019/51**

(73) Proprietor: **trinamiX GmbH**
**67063 Ludwigshafen am Rhein (DE)**

(72) Inventors:
• **LUNGENSCHMIED, Christoph**
**67063 Ludwigshafen am Rhein (DE)**
• **BONSIGNORE, Christian**
**67063 Ludwigshafen am Rhein (DE)**
• **HANDRECK, Anke**
**67063 Ludwigshafen am Rhein (DE)**

• **BRUDER, Ingmar**
**67063 Ludwigshafen am Rhein (DE)**
• **SEND, Robert**
**76137 Karlsruhe (DE)**

(74) Representative: **BASF IP Association**
**BASF SE**
**GBI-C006**
**67056 Ludwigshafen (DE)**

(56) References cited:
**WO-A1-2016/092454     WO-A1-2016/120392**

• **J. ROBERTSON: "High dielectric constant
oxides", THE EUROPEAN PHYSICAL JOURNAL
APPLIED PHYSICS, vol. 28, no. 3, 1 December
2004 (2004-12-01), pages 265-291, XP055054404,
ISSN: 1286-0042, DOI: 10.1051/epjap:2004206**

**Description**

Field of the invention

The invention relates to a detector for an optical detection of at least one object, in particular, for determining a position of at least one object, specifically with regard to a depth, to a width, or both to the depth and the width of the at least one object. Furthermore, the invention relates to a human-machine interface, an entertainment device, a scanning device, a tracking system, and a camera. Further, the invention relates to a method for optical detection of at least one object and to various uses of the detector. Such devices, methods and uses can be employed for example in various areas of daily life, gaming, traffic technology, mapping of spaces, production technology, security technology, medical technology or in the sciences. However, further applications are possible.

Prior art

Various detectors for optically detecting at least one object are known on the basis of optical detectors. WO 2012/110924 A1 discloses an optical detector comprising at least one optical sensor which exhibits at least one sensor region. Herein, the optical sensor is designed to generate at least one sensor signal in a manner dependent on an illumination of the sensor region. According to the so-called "FiP effect", the sensor signal, given the same total power of the illumination, is hereby dependent on a geometry of the illumination, in particular on a beam cross-section of the illumination on the sensor region. The detector furthermore has at least one evaluation device designated to generate at least one item of geometrical information from the sensor signal, in particular at least one item of geometrical information about the illumination and/or the object.

The optical sensors as exemplary disclosed in WO 2012/110924 A1 are selected from the group consisting of an organic solar cell, a dye solar cell, and a dye-sensitized solar cell (DSC), preferably a solid-state dye-sensitized solar cell (ssDSC). Herein, a DSC generally refers to a setup having at least two electrodes, wherein at least one of the electrodes is at least partially transparent, wherein at least one n-semiconducting metal oxide, at least one dye and at least one electrolyte or p-semiconducting material is embedded between the electrodes. In this kind of optical sensors, the sensor signal may be provided in form of an ac photocurrent which is enhanced when modulated light is focused onto the sensor region.

WO 2014/097181 A1 discloses a method and a detector for determining a position of at least one object, by using at least one transversal optical sensor and at least one longitudinal optical sensor. Preferably, a stack of longitudinal optical sensors is employed, in particular to determine a longitudinal position of the object with a high degree of accuracy and without ambiguity. In general, at least two individual "FiP sensors", i.e. a optical sensors based on the FiP-effect, are required in order to determine the longitudinal position of the object without ambiguity, wherein at least one of the FiP sensors is employed for normalizing the longitudinal sensor signal for taking into account possible variations of the illumination power. Further, WO 2014/097181 A1 discloses a human-machine interface, an entertainment device, a tracking system, and a camera, each comprising at least one such detector for determining a position of an object.

WO 2016/092454 A1 discloses a optical detector comprising: at least one optical sensor adapted to detect a light beam and to generate at least one sensor signal, wherein the optical sensor has at least one sensor region, wherein the sensor signal exhibits a non-linear dependency on an illumination of the sensor region by the light beam; at least one image sensor being a pixelated sensor comprising a pixel matrix of image pixels adapted to detect the light beam and to generate at least one image signal, wherein the image signal exhibits a linear dependency on the illumination of the image pixels by the light beam; and at least one evaluation device adapted to evaluate the sensor signal and the image signal. In a preferred embodiment, the optical sensor is a pixelated optical sensor at least partially established by a pixel array comprising a number of individual sensor pixels which constitute the sensor region. Herein, at least one electronic element may be placed in a vicinity of, in particular each of, the sensor pixels on the same surface as the respective sensor pixels, wherein the electronic elements may be adapted to contribute to an evaluation of the signal as provided by the corresponding sensor pixel and might, thus, comprise a capacity, thus, allowing a faster readout of the signals as provided by the individual sensor pixels.

WO 2016/120392 A1 discloses a further kind of optical sensors which may exhibit the FiP effect. Herein, the sensor region of the optical sensor comprises a photoconductive material, preferably selected from lead sulfide (PbS), lead selenide (PbSe), lead telluride (PbTe), cadmium telluride (CdTe), indium phosphide (InP), cadmium sulfide (CdS), cadmium selenide (CdSe), indium antimonide (InSb), mercury cadmium telluride (HgCdTe; MCT), copper indium sulfide (CIS), copper indium gallium selenide (CIGS), zinc sulfide (ZnS), zinc selenide (ZnSe), copper zinc tin sulfide (CZTS), solid solutions and/or doped variants thereof. Herein, the photoconductive material is deposited on an insulating substrate, in particular a ceramic substrate or a transparent or a translucent substrate, such as glass or quartz. In addition, the FiP effect could be observed in hydrogenated amorphous semiconducting materials, in particular in hydrogenated amorphous silicon (a-Si:H), located in the sensor region.

Starting with high κ oxides in capacitors, especially with their capability of replacing thin silicon dioxide layers in CMOS transistors as gate dielectric in order to reduce leakage currents, J. Robertson, High dielectric constant oxides, The European Physical Journal Applied Physics, Vol. 28, No. 3, pages 265-291, 2004, provides a review covering the choice of high κ oxides, their structural and metallurgical behavior, atomic diffusion, deposition, interface structure and reactions, electronic structure, bonding, band offsets, mobility degradation, flat band voltage shifts and electronic defects.

L. Biana, E. Zhua, J. Tanga, W. Tanga, and Fujun Zhang, Progress in Polymer Science 37, 2012, p. 1292-1331, provide a review about conjugated polymers for organic photovoltaic (OPV) cells. Herein, they describe that polymer solar cells (PSCs) have emerged as an alternative photovoltaic technology, in particular, due to a potential of cost-effective production of large-area flexible devices by using solution-processing techniques. Typically, PSCs adopt a bulk-heterojunction (BJH) architecture, in which a photosensitive layer is cast from a mixture solution of a donor polymer and a soluble fullerene-based electron acceptor, such as [6,6]phenyl C61 butyric acid methyl ester (PC60BM) or [6,6]-phenyl-C71-butyric acid methyl ester (PC71BM), and sandwiched between two electrodes. Accordingly, a typical BHJ solar cell comprises an indium tin oxide (ITO) coated glass substrate, covered by a layer of a transparent conductive polymer, usually PEDOT:PSS. A mixture comprising the donor polymer and a fullerene derivative is placed on the top of the PEDOT:PSS layer, and a thin layer of a metal, preferably aluminum (Al) or silver (Ag), is deposited on the photosensitive layer as cathode. Herein, the donor polymer serves as a main solar light absorber and as a hole transporting layer, whereas the small molecule is adapted to transport electrons.

Whereas fullerenes are usually employed as acceptor materials in BHJ OPVs, non-fullerene molecular acceptors are also known. A. Facchetti, Materials Today, Vol. 16, No. 4, 2013, p. 123-132, reviews polymer donor-polymer acceptor (all-polymer) BHJ OPVs, in which an n-type semiconducting polymer is employed as the electron acceptor instead of a fullerene or another small molecule. This kind of BHJ OPVs exhibit a number of advantages, in particular, high absorption coefficients in the visible and near-infrared spectral regions, a more efficient tuning of energy levels, and an increased flexibility in controlling solution viscosity. Further, photosensitive blend compositions are provided herein, wherein each composition comprises a selected donor polymer and a selected acceptor polymer.

Despite the advantages implied by the above-mentioned devices and detectors, there still is a need for improvements with respect to a simple, cost-efficient and, still, reliable spatial detector.

Problem addressed by the invention

Therefore, a problem addressed by the present invention is that of specifying a device and a method for optically detecting at least one object which at least substantially avoid the disadvantages of known devices and methods of this type. In particular, an improved simple, cost-efficient and, still, reliable spatial detector for determining the position of an object in space would be desirable.

More particular, the problem addressed by the present invention is that of providing an optical detector comprising a material within the sensor region which, on one hand, may exhibit a strong non-linear behavior of an extracted ac photocurrent with a variation of a size of an impinging light spot (FIP effect) but which, on the other hand, may allow a facile preparation. In this regard, it would be desirable if larger ac photocurrents may be observable in the optical detector at illumination levels which may be comparative to known FiP devices in order to be able to obtain larger sensor signals. Further, it would also be desirable if a ratio of an in-focus response vs. an out-of-focus response would also be increased in the optical sensor.

Summary of the invention

This problem is solved by the invention with the features of the independent patent claims. Advantageous developments of the invention, which can be realized individually or in combination, are presented in the dependent claims and/or in the following specification and detailed embodiments.

As used herein, the expressions "have", "comprise" and "contain" as well as grammatical variations thereof are used in a non-exclusive way. Thus, the expression "A has B" as well as the expression "A comprises B" or "A contains B" may both refer to the fact that, besides B, A contains one or more further components and/or constituents, and to the case in which, besides B, no other components, constituents or elements are present in A.

In a first aspect of the present invention, a detector for optical detection, in particular, for determining a position of at least one object is disclosed. Herein, the detector for an optical detection of at least one object according to the present invention comprises:

- at least one optical sensor, wherein the optical sensor has at least one sensor region, wherein the optical sensor is designed to generate at least one sensor signal in a manner dependent on an illumination of the sensor region by an incident modulated light beam, wherein the sensor signal is dependent on a modulation frequency of the light beam, wherein the sensor region comprises at least one capacitive device, the capacitive device comprising at least two electrodes, wherein at least one insulating layer and at least one photosensitive layer are embedded between the electrodes, wherein at least one of the electrodes is at least partially optically transparent for the light beam; and

- at least one evaluation device, wherein the evaluation device is designed to generate at least one item of information on a position of the object by evaluating the sensor signal.

The "object" generally may be an arbitrary object, chosen from a living object and a non-living object. Thus, as an example, the at least one object may comprise one or more articles and/or one or more parts of an article. Additionally or alternatively, the object may be or may comprise one or more living beings and/or one or more parts thereof, such as one or more body parts of a human being, e.g. a user, and/or an animal.

As used herein, a "position" generally refers to an arbitrary item of information on a location and/or orientation of the object in space. For this purpose, as an example, one or more coordinate systems may be used, and the position of the object may be determined by using one, two, three or more coordinates. As an example, one or more Cartesian coordinate systems and/or other types of coordinate systems may be used. In one example, the coordinate system may be a coordinate system of the detector in which the detector has a predetermined position and/or orientation. As will be outlined in further detail below, the detector may have an optical axis, which may constitute a main direction of view of the detector. The optical axis may form an axis of the coordinate system, such as a z-axis. Further, one or more additional axes may be provided, preferably perpendicular to the z-axis.

Thus, as an example, the detector may constitute a coordinate system in which the optical axis forms the z-axis and in which, additionally, an x-axis and a y-axis may be provided which are perpendicular to the z-axis and which are perpendicular to each other. As an example, the detector and/or a part of the detector may rest at a specific point in this coordinate system, such as at the origin of this coordinate system. In this coordinate system, a direction parallel or antiparallel to the z-axis may be regarded as a "longitudinal direction", and a coordinate along the z-axis may be considered as "a longitudinal coordinate". An arbitrary direction perpendicular to the longitudinal direction may be considered a "transversal direction", and an x- and/or y-coordinate may be considered as a "transversal coordinate".

Alternatively, other types of coordinate systems may be used. Thus, as an example, a polar coordinate system may be used in which the optical axis forms a z-axis and in which a distance from the z-axis and a polar angle may be used as additional coordinates. Again, a direction parallel or antiparallel to the z-axis may be considered as the longitudinal direction, and a coordinate along the z-axis may be considered as the longitudinal coordinate. Any direction perpendicular to the z-axis may be considered as the transversal direction, and the polar coordinate and/or the polar angle may be considered as the transversal coordinate.

As used herein, the detector for optical detection generally is a device which is adapted for providing at least one item of information on the position of the at least one object. The detector may be a stationary device or a mobile device. Further, the detector may be a stand-alone device or may form part of another device, such as a computer, a vehicle or any other device. Further, the detector may be a hand-held device. Other embodiments of the detector are feasible.

The detector may be adapted to provide the at least one item of information on the position of the at least one object in any feasible way. Thus, the information may e.g. be provided electronically, visually, acoustically or in any arbitrary combination thereof. The information may further be stored in a data storage of the detector or a separate device and/or may be provided via at least one interface, such as a wireless interface and/or a wire-bound interface.

Within this aspect of the present invention, the detector for optical detection, in particular, for determining the position of the at least one object may, specifically, be designated for determining a longitudinal position (depth) of the at least one object, a transversal position (width) of the at least one object, or a spatial position (both the depth and the width) of the at least one object.

Thus, within the first aspect of the present invention, a detector for determining the longitudinal position (depth) of the at least one object is disclosed. The detector for the optical detection of a depth of the at least one object according to the present invention comprises:

- at least one longitudinal optical sensor, wherein the longitudinal optical sensor has at least one sensor region, wherein the longitudinal optical sensor is designed to generate at least one longitudinal sensor signal in a manner dependent on an illumination of the sensor region by an incident modulated light beam, wherein the longitudinal sensor signal, given the same total power of the illumination, is dependent on a beam cross-section of the light beam in the sensor region and on a modulation frequency of the light beam, wherein the sensor region comprises at least one capacitive device, the capacitive device comprising at least two electrodes, wherein at least one insulating layer and at least one photosensitive layer are embedded between the electrodes, wherein at least one of the electrodes is at least partially optically transparent for the light beam; and

- at least one evaluation device, wherein the evaluation device is designed to generate at least one item of information on a longitudinal position of the object by evaluating the longitudinal sensor signal.

Herein, the components listed above may be separate components. Alternatively, two or more of the components as listed above may be integrated into one component. Further, the at least one evaluation device may be formed as a separate evaluation device independent from the longitudinal optical sensor, but may preferably be connected to the longitudinal optical sensor in order to receive the longitudinal sensor signal. Alternatively, the at least one evaluation device may fully or partially be integrated into the longitudinal optical sensor.

The detector according to this aspect of the present invention comprises at least one longitudinal optical sensor. Herein, the longitudinal optical sensor has at least one sensor region, i.e. an area within the longitudinal optical sensor being sensitive to an illumination by an incident light beam. As used herein, the "longitudinal optical sensor" is, generally, a device which is designed to generate at least one longitudinal sensor signal in a manner dependent on an illumination of the sensor region by the light beam, wherein the longitudinal sensor signal, given the same total power of the illumination, is dependent, according to the so-called "FiP effect" on a beam cross-section of the light beam in the sensor region. The longitudinal sensor signal may, thus, generally be an arbitrary signal indicative of the longitudinal position, which may also be denoted as a depth. As an example, the longitudinal sensor signal may be or may comprise a digital and/or an analog signal. As an example, the longitudinal sensor signal may be or may comprise a voltage signal and/or a current signal. Additionally or alternatively, the longitudinal sensor signal may be or may comprise digital data. The longitudinal sensor signal may comprise a single signal value and/or a series of signal values. The longitudinal sensor signal may further comprise an arbitrary signal which is derived by combining two or more individual signals, such as by averaging two or more signals and/or by forming a quotient of two or more signals.

According to the present invention, the FiP effect may be observable by using a capacitive device comprised by the optical sensor. Herein, the capacitive device is comprised by the sensor region which constitutes the area in the optical sensor which is, as defined above, sensitive to the illumination by the incident light beam. As a result, the at least one capacitive device according to the present invention is actually comprised by the sensor region of the optical sensor itself. This feature is in particular contrast to the optical detector as disclosed in WO 2016/092454 A1, wherein at least one electronic element, specifically a capacity, adapted to allow a faster readout of the signals provided by the individual sensor pixels may be placed in a vicinity of, in particular each of, the sensor pixels of the optical sensor, which is a pixelated optical sensor comprising a number of individual sensor pixels constituting the sensor region, on the same surface as the respective sensor pixels. In other words, whereas the capacity in the optical sensor of WO 2016/092454 A1 is located at the periphery of the optical sensor in order not to allow any disturbance of the optical receptivity of the sensor region, wherein the capacity is used for purposes of evaluation of the sensor signal after the sensor signal has already been generated by the optical sensor, the capacitive device according to the present invention is immediately comprised by the sensor region of the optical sensor, wherein the capacitive device is adapted for receiving the incident light beam in order to create and collect charges, whereby the senor signal of the optical sensor may, thus, be generated. After its generation, the sensor signal may, subsequently, be transferred to and evaluated by one or more further devices, such as further capacitors comprised by the evaluation device as described below in more detail.

As used herein, the term "capacitive device" relates to a device which comprises at least two electrodes between which at least one insulating layer and at least one photosensitive layer are located. For this reason, the capacitive device may, thus, alternatively also be denominated as a "photocapacitive device" or a "photoactive capacitor". Consequently, the capacitive device according to the present invention comprises a capacitor, in which a dielectric material is located as intervening medium between the electrodes, wherein each of the electrodes can be considered as storage for a particular charge, i.e. for positive charges or for negative charges. As known from conventional capacitors, applying the dielectric material between the electrodes may prevent the electrodes, on which the particular kind of charges is stored, from accomplishing direct electrical contact, thus, avoiding an occurrence of a short-cut between at least two of the electrodes. In addition, depending on a specific material property of the dielectric material which is usually denominated as "permittivity", the dielectric material between the electrodes of the capacitor may, further, allow storing an increased amount of charge in the capacitor at a given voltage compared to a capacitor having a vacuum located between the electrodes.

In the present optical sensor, the dielectric material is provided in form of at least one insulating layer. As generally used, the term "layer" refers to refers to an element having an elongated shape and a thickness, wherein an extension of the element in a lateral dimension exceeds the thickness of the element, such as by at least a factor of 10, preferably of 20, more preferably of 50 and most preferably of 100 or more. This definition may also be applicable to other kinds of layers, such as a photoconductive layer or a transporting layer. Further, the term "insulating layer" refers to a layer which exhibits a high electrical resistance, thus, leading to a low electrical conductivity within the layer. Generally, the insulating layer may exhibit an electrical conductivity having a value below $10^{-6}$ S/m, preferably below $10^{-8}$ S/m, more preferred below $10^{-10}$ S/cm. Herein, the value of the electrical conductivity determines a capability of a layer to carry an electrical current, wherein the capability is particularly low in the case of the insulating layer. As further used, an "electrical resistance" denotes the reciprocal value of the electrical conductivity for a specific layer.

In a preferred embodiment, the insulating layer may refer to a layer comprising at least one insulating material, which may also be denoted as a "dielectric material". Below, various embodiments are provided for particularly preferred kinds of dielectric materials suitable for being used in or as the insulating layer in accordance with the present invention. Thus, the insulating layer may, in principle, comprise any material which may be suitable for the purpose of providing the dielectric material as required for the capacitive device. However, it may be advantageous that the insulating layer may exhibit at least partially optically transparent properties, in particular, in order to facilitate the incident light beam to traverse the insulating layer, such that the incident light beam may be capable of reaching other partitions of the capacitive device. Alternatively, an optically intransparent insulating layer may also be applicable provided that a path for the light beam may be adapted not to require traversing the insulating layer.

Alternatively or in addition, a layer may also be considered as the insulating layer although it may comprise at least one material that may be considered as a non-insulating material, such as a semiconducting material. However, the non-insulating material may, still, be arranged and/or driven in a manner that a dielectric insulating layer may, nevertheless, be generated. In a particularly preferred embodiment, the insulating layer, thus, comprises an electrically insulating component, in particular, a diode having at least two layers of a semiconducting material or a junction which may adjoin at least one layer of at least one semiconducting material, wherein the electrically insulating component may, preferably, be arranged and/or driven in a fashion that the layer comprising the electrically insulating component may exhibit dielectric properties comparative to an insulating layer. Further electrically insulating components may also be feasible for being used as or in the insulating layer.

In a preferred embodiment of the present invention, the insulating layer may comprise at least one transparent insulating metal-containing compound, wherein the metal-containing compound may, preferably, comprise a metal selected from the group consisting of Al, Ti, Ta, Mn, Mo, Zr, Hf, La, Y, and W. Herein, the at least one metal-containing compound may, preferably, be selected from the group comprising an oxide, a hydroxide, a chalcogenide, a pnictide, a carbide, or a combination thereof. Herein, the term "chalcogenide" refers to a compound which may comprise a group VI element of the periodic table apart from an oxide, i.e. a sulfide, a selenide, and a telluride. In a similar fashion, the term "pnictide" refers to a, preferably binary, compound which may comprise a group V element of the periodic table, i.e. a nitride, a phosphide, arsenide and an antimonide. In particular, the metal-containing compound may, preferably, comprise at least one oxide, at least one hydroxide, or a combination thereof, preferably of Al, Ti, Zr, or Hf. However, other metals and/or metal-containing compounds may also be feasible.

In a preferred embodiment, at least one deposition method may be used for depositing the insulating layer on a substrate or an underlying layer. For this purpose, the deposition method may, in particular, be selected from an atomic layer deposition (ALD), a chemical vapor deposition (CVP), or a combination thereof. Consequently, the insulating layer may, in a particularly preferred embodiment, be or comprise an atomic deposition layer or a chemical vapor deposition layer, wherein the atomic deposition layer may especially be preferred. In other words, the cover layer may, in this particularly preferred embodiment, be obtainable by an ALD process or by a CVD process, the ALD process being especially preferred. Herein, the term "atomic layer deposition", the equivalent terms "atomic layer epitaxy" or "molecular layer deposition" as well as their respective abbreviations "ALD", "ALE" or "MLD" are, generally, used for referring to a deposition process which may comprise a self-limiting process step and a subsequent self-limiting re-action step. Hence, the process which is applied in accordance with the present invention may also be referred to as an "ALD process". For further details referring to the ALD process, reference may be made to by George, Chem. Rev., 110, p. 111-131, 2010. Further, the term "chemical vapor deposition", usually abbreviated to "CVD" refers to a method in which a surface of a substrate or a layer located on a substrate may be exposed to at least one volatile precursor, wherein the precursor may react and/or decompose on the surface in order to generate a desired deposit. In a frequent case, possible by-products may be removed by applying a gas flow above the surface.

In particular, a thin aluminum oxide ($Al_2O_3$) layer may, preferably, be used as the insulating layer, wherein, the term "aluminum oxide layer" or "$Al_2O_3$ layer" as used herein refers to a layer which, as known to the skilled person, may, apart from aluminum and oxide, also comprise hydroxide entities. Herein, the thin aluminum oxide ($Al_2O_3$) layer may exhibit a thickness of 1 nm to 1000 nm, preferably of 10 nm to 250 nm, in particular of only 20 nm to 150 nm. For the purposes of the present invention, the $Al_2O_3$ layer may, preferably, be provided by using atomic layer deposition (ALD), in particular at an applied temperature of 50 °C to 250°C, preferably of 60 °C to 200 °C. Especially, the insulating layer may be provided by low-temperature ALD, wherein the low-temperature ALD may be performed at a temperature of 50 °C to 120 °C, preferably of 60 °C to 100 °C. As demonstrated below in more detail, the aluminum oxide layer provided by atomic layer deposition ($Al_2O_3$ (ALD) layer) was found to exhibit excellent insulating properties even at the above-mentioned reduced thickness while this advantage could be achieved by a facile preparation of the insulating layer.

As alternatives, other dielectric compounds, in particular transparent insulating metal oxide oxides such as zirconium dioxide ($ZrO_2$), silicon oxides ($SiO_x$, such as $SiO_2$), titanium dioxide ($TiO_2$), hafnium oxide ($HfO_2$), tantalum pentoxide ($Ta_2O_5$), lanthanum oxide ($La_2O_3$), or yttrium oxide ($Y_2O_3$), but also other dielectric compounds such as strontium titanate ($SrTiO_3$), cesium carbonate ($CsCO_3$), hafnium silicate ($HfSiO_4$), or silicon nitride ($Si_3N_4$), or a combination of the mentioned dielectric compounds, may also be suited for providing the insulating layer for the capacitive device. Further suitable dielectric compounds may also be found in J. Robertson, High dielectric constant oxides, Eur. Phys. J. Appl. Phys. 28, 265-291 (2004) or in J.A. Kittl et al., High-k Dielectrics for Future Generation Memory Devices, Microelectronic Engineering 86 (2009) 1789-1795. Alternatively, the insulating layer may comprise a film of a transparent organic dielectric material, in particular, selected from polyethylenimine ethoxylate (**PEIE**) polyethylenimine (**PEI**), 2,9-dimethyl-4,7-diphenylphenanthroline (**BCP**), poly(vinylalcohol) (**PVA**), poly(methylmethacrylate) (**PMMA**), tris-(8-hydroxyquinoline)aluminum (**Alq3**), or (3-(4-biphenylyl)- 4-phenyl-5-(4-tert-butylphenyl)-1,2,4-triazole) (**TAZ**). However, other materials may also be feasible. Particularly depending on the electric resistivity of the dielectric material as used for the insulating layer and the method for depositing the dielectric material, the insulating layer may, typically, have a thickness of 1 nm to 1000 nm, preferably of 10 nm to 250 nm, in particular of only 20 nm to 150 nm.

Further, the insulating layer may be or comprise a laminate having at least two adjacent layers, wherein the adjacent layers may, in particular, differ by their respective composition in a manner that one, both, some, or all of the adjacent layers may comprise an individual dielectric material. By way of example, the laminate may comprise an aluminum oxide layer and a zirconium dioxide provided as a stack of adjacent layers. However, other combinations may also be possible.

In addition to the insulating layer, the capacitive device according to the present invention, additionally, comprises at least one photosensitive layer. As used herein, the term "photosensitive layer" relates to a material which is susceptible to an influence of the incident light beam. In particular, upon illumination of the photosensitive layer by the incident light beam, an amount of charge carriers is generated in the photosensitive layer, wherein the amount of the charge carriers which are generated depends on the illumination of the photosensitive layer by the incident light beam. Not wishing to be bound by theory, the charge carriers generated within the photosensitive layer can, subsequently, be collected by the corresponding electrode which is designed to collect the respective type of charge carriers, i.e. electrons or holes. However, since the capacitive device, as explained above, exhibits the characteristics of a capacitor by having a dielectric material embedded between the electrodes, providing a direct incident light beam having a constant amplitude may not be sufficient to achieve a collection of the generated charge carriers by all electrodes since the insulating layer which acts as the dielectric may prevent a transport of charges from the photosensitive layer where they are generated by the incident light beam to the corresponding electrode. However, as known from capacitors, this situation may essentially change when a modulated light beam is applied to the photosensitive layer. Consequently, the incident modulated light beam may, thus, be considered as an alternating light beam which may be capable of generating the charge carriers in an alternating fashion which may give rise to an alternating current as generated in the capacitive device. Thus, the capacitive device having the photosensitive layer which can be considered as active portion of the sensor region allows the longitudinal optical sensor to generate the at least one longitudinal sensor signal in a manner that it depends on the illumination of the sensor region by an incident modulated light beam. As a result, the detector comprising the capacitive device exhibits the FiP effect. Accordingly, the longitudinal sensor signal as provided by the capacitive device may, thus, be in form of an ac photocurrent which decreases when the incident modulated incident light beam is focused onto the photosensitive layer as the active portion of the sensor region comprised by the longitudinal optical sensor.

Preferably, the at least one photosensitive layer in the capacitive device of the optical detector according to the present invention may be provided in form of one or more of

- at least one layer comprising at least one photoconductive material, wherein the photoconductive material is provided in a nanoparticulate form;
- at least two individual photoconductive layers comprising at least one photoconductive material and provided as a stack of adjacent layers, wherein the photoconductive layers are adapted to generate a junction at the boundary between the adjacent layers;
- at least one semiconductor absorber layer, preferably, a layer comprising an amorphous silicon, in particular, hydrogenated amorphous silicon (a-Si:H); and
- at least one organic photosensitive layer comprising at least one donor material and at least one acceptor material, wherein the donor material and the acceptor material in the organic photosensitive layer may, preferably, be arranged as a single layer comprising the donor material and the acceptor material or, alternatively, in form of at least two individual layers each comprising one of the donor material and of the acceptor material. However, further kinds of photosensitive materials may also feasible.

In a preferred embodiment, the at least one photosensitive layer in the capacitive device may, thus, comprise a photoconductive material. As used herein, the term "photoconductive material" refers to a material which is capable of sustaining an electrical current and, therefore, exhibits a specific electrical conductivity, wherein the electrical conductivity is dependent on the illumination of the material. For the purposes of the present invention, the photoconductive material may, preferably, comprise an inorganic photoconductive material, an organic photoconductive material, a combination thereof and/or a solid solution thereof and/or a doped variant thereof. As used herein, the term "solid solution" refers to a state of the photoconductive material in which at least one solute may be comprised in a solvent, whereby a homogeneous phase is formed and wherein the crystal structure of the solvent may, generally, be unaltered by the presence of the solute. As further used herein, the term "doped variant" may refer to a state of the photoconductive material in which single atoms apart from the constituents of the material itself are introduced onto sites within the crystal which are occupied by intrinsic atoms in the undoped state. For a selection of further photoconductive materials which may be applicable in the photosensitive layer of the capacitive device according to the present invention, reference may be made to the disclosure as provided by WO 2016/120392 A1.

In this regard, the inorganic photoconductive material may, in particular, comprise one or more of selenium, tellurium, a selenium-tellurium alloy, a metal oxide, a group IV element, particularly silicon, or a group IV compound, i.e. a chemical compound with at least one group IV element, a group III-V compound, i.e. a chemical compound with at least one group III element and at least one group V element, a group II-VI compound, i.e. a chemical compound with, on one hand, at least one group II element or at least one group XII element and, on the other hand, at least one group VI element, and/or a chalcogenide. Herein, the chalcogenide may, preferably be selected from a group comprising sulfide chalcogenides, selenide chalcogenides, telluride chalcogenides, ternary chalcogenides, quaternary and higher chalcogenides, may preferably be appropriate to be used as the photoconductive material in the sensor region of the longitudinal optical sensor. However, other inorganic photoconductive materials may equally be appropriate.

With regard to the III-V compound, this kind of semiconducting material may be selected from a group comprising indium antimonide (InSb), boron nitride (BN), boron phosphide (BP), boron arsenide (BAs), aluminum nitride (AlN), aluminum phosphide (AlP), aluminum arsenide (AlAs), aluminum antimonide (AlSb), indium nitride (InN), indium phosphide (InP), indium arsenide (InAs), indium antimonide (InSb), gallium nitride (GaN), gallium phosphide (GaP), gallium arsenide (GaAs), and gallium antimonide (GaSb). Further, solid solutions and/or doped variants of the mentioned compounds or of other compounds of this kind may also be feasible.

With regard to the II-VI compound, this kind of semiconducting material may be selected from a group comprising cadmium sulfide (CdS), cadmium selenide (CdSe), cadmium telluride (CdTe), zinc sulfide (ZnS), zinc selenide (ZnSe), zinc telluride (ZnTe), mercury sulfide (HgS), mercury selenide (HgSe), mercury telluride (HgTe), cadmium zinc telluride (CdZnTe), mercury cadmium telluride (HgCdTe), mercury zinc telluride (HgZnTe), and mercury zinc selenide (CdZnSe). However, other II-VI compounds may be feasible. Further, solid solutions of the mentioned compounds or of other compounds of this kind may also be applicable.

With regard to chalcogenides, the sulfide chalcogenide may, in particular, be selected from a group comprising lead sulfide (PbS), cadmium sulfide (CdS), zinc sulfide (ZnS), mercury sulfide (HgS), silver sulfide ($Ag_2S$), manganese sulfide (MnS), bismuth trisulfide ($Bi_2S_3$), antimony trisulfide ($Sb_2S_3$), arsenic trisulfide ($As_2S_3$), tin (II) sulfide (SnS), tin (IV) disulfide ($SnS_2$), indium sulfide ($In_2S_3$), copper sulfide (CuS or $Cu_2S$), cobalt sulfide (CoS), nickel sulfide (NiS), molybdenum disulfide ($MoS_2$), iron disulfide ($FeS_2$), and chromium trisulfide ($CrS_3$).

In particular, the selenide chalcogenide may be selected from a group comprising lead selenide (PbSe), cadmium selenide (CdSe), zinc selenide (ZnSe), bismuth triselenide ($Bi_2Se_3$), mercury selenide (HgSe), antimony triselenide ($Sb_2Se_3$), arsenic triselenide ($As_2Se_3$), nickel selenide (NiSe), thallium selenide (TlSe), copper selenide (CuSe or $Cu_2Se$), molybdenum diselenide ($MoSe_2$), tin selenide (SnSe), and cobalt selenide (CoSe), and indium selenide ($In_2Se_3$). Further, solid solutions and/or doped variants of the mentioned compounds or of other compounds of this kind may also be feasible.

In particular, the telluride chalcogenide may be selected from a group comprising lead telluride (PbTe), cadmium telluride (CdTe), zinc telluride (ZnTe), mercury telluride (HgTe), bismuth tritelluride ($Bi_2Te_3$), arsenic tritelluride ($As_2Te_3$), antimony tritelluride ($Sb_2Te_3$), nickel telluride (NiTe), thallium telluride (TlTe), copper telluride (CuTe), molybdenum ditelluride ($MoTe_2$), tin telluride (SnTe), and cobalt telluride (CoTe), silver telluride ($Ag_2Te$), and indium telluride ($In_2Te_3$). Further, solid solutions and/or doped variants of the mentioned compounds or of other compounds of this kind may also be feasible.

In particular, the ternary chalcogenide may be selected from a group comprising mercury cadmium telluride (HgCdTe; MCT), mercury zinc telluride (HgZnTe), mercury cadmium sulfide (HgCdS), lead cadmium sulfide (PbCdS), lead mercury sulfide (PbHgS), copper indium disulfide (CIS), cadmium sulfoselenide (CdSSe), zinc sulfoselenide (ZnSSe), thallous sulfoselenide (TlSSe), cadmium zinc sulfide (CdZnS), cadmium chromium sulfide ($CdCr_2S_4$), mercury chromium sulfide ($HgCr_2S_4$), copper chromium sulfide ($CuCr_2S_4$), cadmium lead selenide (CdPbSe), copper indium diselenide ($CuInSe_2$), indium gallium arsenide (InGaAs), lead oxide sulfide ($Pb_2OS$), lead oxide selenide ($Pb_2OSe$), lead sulfoselenide (PbSSe), arsenic selenide telluride ($As_2Se_2Te$), indium gallium phosphide (InGaP), gallium arsenide phosphide (GaAsP), aluminum gallium phosphide (AlGaP), cadmium selenite ($CdSeO_3$), cadmium zinc telluride (CdZnTe), and cadmium zinc selenide (CdZnSe), further combinations by applying compounds from the above listed binary chalcogenides and/or binary III-V-compounds. Further, solid solutions and/or doped variants of the mentioned compounds or of other compounds of this kind may also be feasible.

With regard to quaternary and higher chalcogenides, this kind of material may be selected from a quaternary and higher chalcogenide which may be known to exhibit suitable photoconductive properties. In particular, a compound having a composition of Cu(In, Ga)S/$Se_2$ (CIGS), of $Cu_2ZnSn(S/Se)_4$ (CZTS; CZTSe) or an alloy thereof may be feasible for this purpose.

In a particularly preferred embodiment, the photoconductive material used for the photosensitive layer may be provided in form of a colloidal film which comprises quantum dots. This state of the photoconductive material which may exhibit slightly or significantly modified chemical and/or physical properties with respect to a homogeneous layer of the same material may, thus, also be denoted as colloidal quantum dots (CQD). As used herein, the term "quantum dots" refers to a state of the photoconductive material in which the photoconductive material may comprise electrically conducting particles, such as electrons or holes, which are confined in all three spatial dimensions to a small volume that is usually denominated as a "dot". Herein, the quantum dots may exhibit a size which can, for simplicity, be considered as diameter of a sphere that might approximate the mentioned volume of the particles. In this preferred embodiment, the quantum dots of the photoconductive material may, in particular, exhibit a size from 1 nm to 100 nm, preferably from 2 nm to 100 nm, more preferred from 2 nm to 15 nm. Consequently, the thin film which comprises the quantum dots of the photoconductive material, may exhibits a thickness from 1 nm to 100 nm, preferably from 2 nm to 100 nm, more preferred from 2 nm to 15 nm, provided that the quantum dots actually comprised in a specific thin film may exhibit a size being below the thickness of the specific thin film. In practice, the quantum dots may comprise nanometer-scale semiconductor crystals which might be capped with surfactant molecules and dispersed in a solution in order to form the colloidal film. Herein, the surfactant molecules may be selected to allow determining an average distance between the individual quantum dots within the colloidal film, in particular, as a result from the approximate spatial extension of the selected surfactant molecules. Further, depending on the synthesis of ligands, quantum dots may exhibit hydrophilic or hydrophobic properties. The CQD can be produced by applying a gas-phase, a liquid-phase, or a solid-phase approach. Hereby, various ways for a synthesis of the CQD are possible, in particular by employing known processes such as thermal spraying, colloidal synthesis, or plasma synthesis. However, other production processes may also be feasible.

Further in this preferred embodiment, the photoconductive material may, preferably, be selected from one of the photoconductive materials as mentioned above, more particular, from the group comprising lead sulfide (PbS), lead selenide (PbSe), lead telluride (PbTe), cadmium telluride (CdTe), indium phosphide (InP), cadmium sulfide (CdS), cadmium selenide (CdSe), indium antimonide (InSb), mercury cadmium telluride (HgCdTe; MCT), copper indium sulfide (CIS), copper indium gallium selenide (CIGS), zinc sulfide (ZnS), zinc selenide (ZnSe), a perovskite structure materials $ABC_3$, wherein A denotes an alkaline metal or an organic cation, B = Pb, Sn, or Cu, and C a halide, and copper zinc tin sulfide (CZTS). Further, solid solutions and/or doped variants of the mentioned compounds or of other compounds of this kind may also be feasible. Core shell structures of the materials of this kind of materials may also be feasible. However, other photoconductive materials may also be feasible.

In a further preferred embodiment, the at least one photosensitive layer in the capacitive device may, as further mentioned above, comprise at least two individual photoconductive layers provided as a stack of adjacent layers, thereby generating a junction, in particular a homojunction or, preferably, a heterojunction at a boundary between the adjacent layers. According to the present invention, this kind of arrangement may, in particular, be achieved by providing adjacent layers of semiconducting materials, wherein the adjacent layers comprise, in the case of the "homojunction", the same kind of semiconducting material, however, with a different type of doping, such a an n-type and a p-type semiconducting material, or, in the case of the "hetereojunction", different kinds of semiconducting materials, wherein in each case the adjacent layers may be separated from each other by a boundary, an interface and/or a junction. As used herein, any of the terms "boundary", "interface" and "junction" may refer to a scaling behavior of the involved materials, i.e. the semiconducting materials located at two sides of the junction, with respect to their electrically conducting properties. Herein, the scaling behavior which, in particular, occurs within the junction of the involved materials comprises an alteration of a value of their electrically conducting properties. Whereas in theory the scaling behavior may be described by a non-continuous function, in the real junction always a continuous transition may be observed. In particular, the resistive behavior within the junction may comprise a nonlinear form. In a preferred embodiment, the nonlinear behavior of the electrical resistance within the junction may, thus, be tailored in order to cause a linear dependence of the photocurrent with respect to the focus spot diameter. This result, however, describes nothing else but the FiP effect which can, thus, also be observed in the optical detector according to the present invention, i.e. the optical detector comprising the at least one junction in the photosensitive layer of the capacitive device. In general, two adjacent layers of photoconductive materials forming a boundary can be used for this purpose, such as selected from the photoconductive materials as described above in more detail. As will be demonstrated in the Figures below in more detail, adjacent layers comprising cadmium sulfide (CdS) and cadmium telluride (CdTe) or cadmium sulfide (CdS) and copper zinc tin sulfide (CZTS), respectively, turned out to be particularly suited for this purpose. As an alternative, copper zinc tin selenide (CZTSe), the corresponding sulfur-selenium alloy CZTSSe, or a further quaternary chalcogenide photoconductive $I_2$-II-IV-$VI_4$ compound may also be used. Further alternatives may include copper indium gallium selenide (CIGS) or other chalcogenide photoconductors which are known as thin-film solar cell absorber layers.

In a further preferred embodiment, the at least one photosensitive layer in the capacitive device may comprise at least one semiconducting absorber layer, in particular amorphous silicon, which can, preferably, be obtained by depositing it as a layer, especially as a thin film, onto an appropriate substrate. However, other methods may be applicable. Further, the amorphous silicon may, most preferably, be passivated by using hydrogen, by which application a number of dangling bonds within the amorphous silicon may be reduced by several orders of magnitude. As a result, hydrogenated amorphous silicon, usually abbreviated to "a-Si:H", may exhibit a low amount of defects, thus, allowing using it for optical devices. However, as used herein, the term "amorphous silicon" may also refer to hydrogenated amorphous silicon, unless explicitly indicated. As alternatives, an amorphous alloy of silicon and carbon (a-SiC), preferably a hydrogenated amorphous silicon carbon alloy (a-SiC:H), or an amorphous alloy of germanium and silicon (a-GeSi), preferably a hydrogenated amorphous germanium silicon alloy (a-GeSi:H) may also be used. Herein, a-GeSi:H may, preferably, be produced by using $SiH_4$, $GeH_4$, and $H_2$ as process gases within a common reactor, wherein other production methods may be feasible. As further alternatives for the semiconducting absorber layer, crystalline silicon (c-Si) or microcrystalline silicon ($\mu$c-Si), preferably hydrogenated microcrystalline silicon ($\mu$c-Si:H), may also be applicable. Herein, the hydrogenated microcrystalline silicon ($\mu$c-Si:H) may, preferably, be produced from a gaseous mixture of $SiH_4$ and $H_2$. As a result, a two-phase material on a substrate comprising microcrystallites having a typical size of 5 nm to 30 nm and being located between ordered columns of the substrate material spaced apart 10 nm to 200 nm with respect to each other may be obtained. However, other production methods may also be applicable.

In a further preferred embodiment, the at least one photosensitive layer may comprise at least one organic photosensitive layer having at least one donor material and at least one acceptor material. Herein, the donor material and the acceptor material in the organic photosensitive layer may, in a preferred embodiment, be arranged as a single layer which may comprise both the donor material and the acceptor material or, as an alternative embodiment, in form of at least two individual layers, wherein each of the individual layers comprises one of the donor material and of the acceptor material. As will be demonstrated below, additional layers adapted to complement the at least two individual layers may also be feasible.

According to this embodiment, at least one electron donor material comprising a donor polymer, in particular an organic donor polymer, and, on the other hand, at least one electron acceptor material, in particular, an acceptor small-molecule, preferably selected from the group comprising a fullerene-based electron acceptor material, tetracyanoquinodimethane (TCNQ), a perylene derivate, an acceptor polymer, and inorganic nanocrystals, may, preferably, be used. However, other materials may also be feasible. In a particular embodiment, the electron donor material may, thus, comprise a donor polymer while the electron acceptor material may comprise an acceptor polymer, thus providing a basis for an all-polymer photosensitive layer. In a particular embodiment, a copolymer which may, simultaneously, be constituted from one of the donor polymers and from one of the acceptor polymers and which may, therefore, also be denominated as a "push-pull copolymer" based on the respective function of each of the constituents of the copolymer.

Preferably, the electron donor material and the electron acceptor material may be comprised within the photosensitive layer in form of a mixture. As generally used, the term "mixture" relates to a blend of two or more individual compounds, wherein the individual compounds within the mixture maintain their chemical identity. In a particularly preferred embodiment, the mixture employed in the photosensitive layer according to the present invention may comprise the electron donor material and the electron acceptor material in a ratio from 1:100 to 100:1, more preferred from 1:10 to 10:1, in particular in a ratio of from 1:2 to 2:1, such as 1:1. However, other ratios of the respective compounds may also be applicable, in particular depending on the kind and number of individual compounds being involved. Preferably, the electron donor material and the electron acceptor material as comprised in form of the mixture within the photosensitive layer may constitute an interpenetrating network of donor and acceptor domains, wherein interfacial areas between the donor and acceptor domains may be present, and wherein percolation pathways may connect the domains to the electrodes, in particular, the donor domains to the electrode which assumes a function of an anode and the acceptor domains to the electrode which assumes the function of the cathode. As used herein, the term "donor domain" refers to a region within the photosensitive layer in which the electron donor material may predominantly, particularly completely, be present. Similarly, the term "acceptor domain" refers to a region within the photosensitive layer in which the electron acceptor material may predominantly, in particular completely, be present. Herein, the domains may exhibit areas, which are denominated as the "interfacial areas", which allow a direct contact between the different kinds of regions, whereby a bulk heterojunction may, thus, be generated within the photosensitive layer. Further, the term "percolation pathways" refers to conductive paths within the photosensitive layer along which a transport of electrons or holes, respectively, may predominantly take place.

As mentioned above, the at least one electron donor material may, preferably, comprise a donor polymer, in particular an organic donor polymer. As used herein, the term "polymer" refers to a macromolecular composition generally comprising a large number of molecular repeat units which are usually denominated as "monomers" or "monomeric units". For the purposes of the present invention, however, a synthetic organic polymer may be preferred. Within this regard, the term "organic polymer" refers to the nature of the monomeric units which may, generally, be attributed as organic chemical compounds. As used herein, the term "donor polymer" refers to a polymer which may particularly be adapted to provide electrons as the electron donor material.

Preferably, the donor polymer may comprise a conjugated system, in which delocalized electrons may be distributed over a group of atoms being bonded together by alternating single and multiple bonds, wherein the conjugated system may be one or more of cyclic, acyclic, and linear. Thus, the organic donor polymer may, preferably, be selected from one or more of the following polymers:

- poly[3-hexylthiophene-2,5.diyl] (**P3HT**),
- poly[3-(4-n-octyl)-phenylthiophene] (**POPT**),
- poly[3-10-n-octyl-3-phenothiazine-vinylenethiophene-co-2,5-thiophene] (**PTZV-PT**), poly[4,8-bis[(2-ethylhexyl)oxy]benzo[1,2-*b:*4,5-*b*']dithiophene-2,6-diyl][3-fluoro-2-[(2-ethylhexyl)carbonyl]thieno[3,4-*b*]thiophenediyl] (**PTB7**),
- poly[thiophene-2,5-diyl-*alt*-[5,6-bis(dodecyloxy)benzo[c][1,2,5]thiadiazole]-4,7-diyl] (**PBT-T1**),
- poly[2,6-(4,4-bis-(2-ethylhexyl)-4*H*-cyclopenta[2,1-*b*;3,4-*b*']dithiophene)-*alt*-4,7(2,1,3-benzothiadiazole)] (**PCPDTBT**),
- poly[5,7-bis(4-decanyl-2-thienyl)-thieno(3,4-*b*)diathiazolethiophene-2,5] (**PDDTT**),
- poly[N-9'-heptadecanyl-2,7-carbazole-alt-5,5-(4',7'-di-2-thienyl-2',1',3'-benzothiadiazole)] (**PCDTBT**), or
- poly[(4,4'-bis(2-ethylhexyl)dithieno[3,2-*b*;2',3'-*d*]silole)-2,6-diyl-*alt*-(2,1,3-benzothiadiazole)-4,7-diyl] (**PSBTBT**),
- poly[3-phenyl hydrazone thiophene] (**PPHT**),
- poly[2-methoxy-5-(2-ethylhexyloxy)-1,4-phenylenevinylene] (**MEH-PPV**),
- poly[2-methoxy-5-(2'-ethylhexyloxy)-1,4-phenylene-1,2-ethenylene-2,5-dimethoxy-1,4-phenylene-1,2-ethenylene] (**M3EH-PPV**),
- poly[2-methoxy-5-(3',7'-dimethyloctyloxy)-1,4-phenylenevinylene] (**MDMO-PPV**),
- poly[9,9-di-octylfluorene-co-bis-N,N-4-butylphenyl-bis-N,N-phenyl-1,4-phenylenediamine] (**PFB**),

or a derivative, a modification, or a mixture thereof.

However, other kinds of donor polymers or further electron donor materials may also be suitable, in particular polymers which are sensitive in the infrared spectral range, especially above 1000 nm, preferably diketopyrrolopyrrol polymers, in particular, the polymers as described in EP 2 818 493 A1, more preferably the polymers denoted as "P-1" to "P-10" therein; benzodithiophene polymers as disclosed in WO 2014/086722 A1, especially diketopyrrolopyrrol polymers comprising benzodithiophene units; dithienobenzofuran polymers according to US 2015/0132887 A1, especially dithienobenzofuran polymers comprising diketopyrrolopyrrol units; phenantro[9, 10-B]furan polymers as described in US 2015/0111337 A1, especially phenantro-[9, 10-B]furan polymers which comprise diketopyrrolopyrrol units; and polymer compositions comprising diketopyrrolopyrrol oligomers, in particular, in an oligomer-polymer ratio of 1:10 or 1:100, such as disclosed in US 2014/0217329 A1.

As further mentioned above, the electron acceptor material may, preferably, comprise a fullerene-based electron acceptor material. As generally used, the term "fullerenes" refers to cage-like molecules of pure carbon, including Buckminster fullerene (C60) and the related spherical fullerenes. In principle, the fullerenes in the range of from C20 to C2000 may be used, the range C60 to C96 being preferred, particularly C60, C70 and C84. Mostly preferred are fullerenes which are chemically modified, in particular one or more of:

- [6,6]-phenyl-C61-butyric acid methyl ester (**PC60BM**),
- [6,6]-Phenyl-C71-butyric acid methyl ester (**PC70BM**),
- [6,6]-phenyl C84 butyric acid methyl ester (**PC84BM**), or
- an indene-C60 bisadduct (**ICBA**),
  but also dimers comprising one or two C60 or C70 moieties, in particular
- a diphenylmethanofullerene (**DPM**) moiety comprising one attached oligoether (**OE**) chain (**C70-DPM-OE**), or
- a diphenylmethanofullerene (**DPM**) moiety comprising two attached oligoether (**OE**) chains (**C70-DPM-OE2**),

or a derivative, a modification, or a mixture thereof. However, **TCNQ**, or a perylene derivative may also be suitable.

Alternatively or in addition, the electron acceptor material may, preferably, comprise inorganic nanocrystals, in particular, selected from cadmium selenide (CdSe), cadmium sulfide (CdS), copper indium sulfite (CuInS$_2$), or lead sulfide (PbS). Herein, the inorganic nanocrystals may be provided in form of spherical or elongate particles which may comprise a size from 2 nm to 20 nm, preferably from 2 nm to 10 nm, and which may from a blend with a selected donor polymer, such as a composite of CdSe nanocrystals and **P3HT** or of PbS nanoarticles and **MEH-PPV.** However, other kinds of blends may also be suitable.

Alternatively or in addition, the electron acceptor material may, preferably, comprise an acceptor polymer. As used herein, the term "acceptor polymer" refers to a polymer which may particularly be adapted to accept electrons as the electron acceptor material. Generally, conjugated polymers based on cyanated poly(phenylenevinylene), benzothiadiazole, perylene or naphthalenediimide are preferred for this purpose. In particular, the acceptor polymer may, preferably, be selected from one or more of the following polymers:

- a cyano-poly[phenylenevinylene] (**CN-PPV**), such as **C6-CN-PPV** or **C8-CN-PPV,**
- poly[5-(2-(ethylhexyloxy)-2-methoxycyanoterephthalyliden] (**MEH-CN-PPV**),
- poly[oxa-1,4-phenylene-1,2-(1-cyano)-ethylene-2,5-dioctyloxy-1,4-phenylene-1,2-(2-cyano)-ethylene-1,4-phenylene] (**CN-ether-PPV**),

- poly[1,4-dioctyloxyl-p-2,5-dicyanophenylenevinylene] (**DOCN-PPV**),
- poly[9,9'-dioctylfluoreneco-benzothiadiazole] (**PF8BT**),

or a derivative, a modification, or a mixture thereof. However, other kinds of acceptor polymers may also be suitable.

For more details concerning the mentioned compounds which may be used as the donor polymer or the electron acceptor material, reference may be made to the above-mentioned review articles by L. Biana, E. Zhua, J. Tanga, W. Tanga, and F. Zhang, Progress in Polymer Science 37, 2012, p. 1292-1331, A. Facchetti, Materials Today, Vol. 16, No. 4, 2013, p. 123-132, and S. Günes and N. S. Sariciftci, Inorganica Chimica Acta 361, 2008, p. 581-588, as well as the respective references cited therein. Further compounds are described in the dissertation of F.A. Sperlich, Electron Paramagnetic Resonance Spectroscopy of Conjugated Polymers and Fullerenes for Organic Photovoltaics, Julius-Maximilians-Universitat Würzburg, 2013, and the references cited therein.

In an alternative embodiment, the organic photosensitive layer in the capacitive device may comprise an individual donor material layer and an individual acceptor material layer each comprising one of the donor material and of the acceptor material, respectively. In particular, the donor material layer and the acceptor material layer may be stacked on top of each other and being separated by a junction, which, due to the different kinds of materials, may form a heterojunction. Herein, each of the respective layers may exhibit a thick ness of 10 nm to 1000 nm, preferably of 10 nm to 100 nm.

In a preferred embodiment, the acceptor material layer may comprise one or more evaporated small organic molecule as the acceptor material, wherein the evaporated small organic molecule is, preferably, selected from C60 (buckminsterfullerene), C70, or a perylene derivative, preferably a perylene diimide derivative, in particular, 3,4,9,10-Perylenetetracarboxylic Bisbenzimidazole (**PTCBI**). Further evaporated small organic molecules which may be used as the acceptor material can be found, for example, in J.E. Anthony, A. Facchetti, M. Heeny, S.R. Marder, and X. Zhan, n-Type Organic Semiconductors in Organic Electronics, Adv. Mater. 2010, 22, pp 3876-3892.

In a preferred embodiment, the donor material layer may, also, comprise one or more evaporated small organic molecule as the donor material, wherein the evaporated small organic molecule is, preferably, selected from a phthalocyanine derivative, preferably copper phthalocyanine (**CuPc**) or zinc phthalocyanine (**ZnPc**), in particular fluorinated zinc phthalocyanine derivative (**F4ZnPc**); from an oligothiophene, preferably dicyanovinyl-terthiophene, from an oligothiophene derivative, preferably α, α'-bis(dicyanovinyl)quinquethiophene (**DCV5T**), from a 4,4-difluoro-4-bora-3a,4a-diazas-indacene (**BODIPY**) or an aza-**BODIPY** derivative; from a squaraine derivative, from a diketopyrrolopyrrol derivative, or from a benzdithiophene derivative. Particularly interesting materials are described in T.-Y. Li, T. Meyer, Z. Ma, J. Benduhn, C. Körner, O. Zeika, K. Vandewal, and L. Leo, Small Molecule Near-Infrared Boron Dipyrromethene Donors for Organic Tandem Solar Cells, J. Am. Chem. Soc. 2017, 139, 13636-13639. For further information, reference may be made to C. Uhrich, R. Schueppel, A. Petrich, M. Pfeiffer, K. Leo, E. Brier, P. Kilickiran, and P. Baeuerle, Organic Thin-Film Photovoltaic Cells Based on Oligothiophenes with Reduced Bandgap, Adv. Funct. Mater. 2007, 17, pp 2991-2999, or to R. Gresser, M. Hummert, H. Hartmann, K. Leo, and M. Riede, Synthesis and Characterization of Near-Infrared Absorbing Benzannulated Aza-BODIPY Dyes, Chem. Eur. J. 2011, 17, pp 2939- 2947, A. Mishra and P. Bauerle, Small Molecule Organic Semiconductors on the Move: Promises for Future Solar Energy Technology, Angew. Chem. Int. Ed. 2012, 51, 2020 - 2067, or H. Yao, L. Ye, H. Zhang, S. Li, S. Zhang and J. Hou, Molecular Design of Benzodithiophene-Based Organic Photovoltaic Materials, Chem. Rev. 2016, 116, 7397-7457.

Herein, the donor material layer may comprise a blend of the phthalocyanine derivative and a further small organic molecule, in particular, a F4ZnPc:C60 blend, i.e. a layer comprising a blend of **F4ZnPc** and buckminsterfullerene. For further details concerning **F4ZnPc** and the F4ZnPc:C60 layer, reference may, in particular, be made to M. Riede, C. Uhrich, J. Widmer, R. Timmreck, D. Wynands, G. Schwartz, W.-M. Gnehr, D. Hildebrandt, A. Weiss, J. Hwang, S. Sundarraj, Peter Erk, Martin Pfeiffer, and K. Leo, Efficient Organic Tandem Solar Cells based on Small Molecules, Adv. Funct. Mater. 2011, 21, pp 3019-3028 or J. Meiss, A. Merten, M. Hein, C. Schuenemann, S. Schafer, M. Tietze, C. Uhrich, M. Pfeiffer, K. Leo, and M. Riede, Fluorinated Zinc Phthalocyanine as Donor for Efficient Vacuum-Deposited Organic Solar Cells, Adv. Funct. Mater. 2012, 22, pp 405-414. However, further kinds of materials may also be applicable for the organic photosensitive layer.

In addition to the organic photosensitive layer, the capacitive device may, further, comprise a charge-carrier extracting layer, such as a hole extracting layer or an electron extracting layer, which, as described above, is adapted for facilitating extraction and transport of the respective charge carriers from the organic photosensitive layer where they are generated to an adjacent electrode. Preferred examples for the hole extraction layer include 9,9-bis[4-(N,N-bis-biphenyl-4-yl-amino)phenyl]-9H-fluorene (**BPAPF**) and N,N'-diphenyl-N,N'-bis(4'-(N,N-bis(naphth-1-yl)-amino)-biphenyl-4-yl)-benzidine (**DiNPB**), while Bathophenantroline (**BPhen**) is considered as a preferred example for a material being suitable for the electron extraction layer. However, further material may also be applicable.

In addition, further layers may be introduced into the capacitive device for increasing its function. In particular, a further n-doped acceptor layer may be introduced between the insulating layer and the acceptor material layer while a p-doped extraction layer, wherein a dopant may, preferably be provided by an additional p-dopant layer, may be introduced between the hole extracting layer and the second electrode. Also, an additional n-dopant layer may similarly be used for n-doping of a layer. Introducing the further n-doped acceptor layer may be used for adjusting a distance from transparent electrode layer to the reflecting second electrode, in particular, in order to improve a matching of a phase of the incident light beam and of a light beam being reflected at the second electrode, thus, optimizing the performance of the capacitive layer with regard to the power of the illumination within the organic photosensitive layer. A comparative effect is described by R. Schueppel, R. Timmreck, N. Allinger, T. Mueller, M. Furno, C. Uhrich, K. Leo, and M. Riede, Controlled current matching in small molecule organic tandem solar cells using doped spacer layers, J. Appl. Phys. 107, 044503, 2010, in tandem solar cells.

As further mentioned above, both the insulating layer and the photosensitive layer are embedded between two or more electrodes comprised by the capacitive device. As generally used, the term "electrode" refers to a highly electrically conducting material, wherein an electrical conductance may be in a metallic or a highly-conducting semiconducting range, which stays in contact with a poorly conducting or a non-conducting material. In particular for the purpose of facilitating the light beam which may impinge the capacitive device to arrive at the photosensitive layer, at least one of the electrodes, in particular, the electrode which may be located within the path of the incident light beam, may at least partially be optically transparent. Preferably, the at least partially optically transparent electrode may comprise at least one transparent conductive oxide (TCO), in particular at least one of indium-doped tin oxide (ITO), fluorine-doped tin oxide (FTO), or aluminum-doped zinc oxide (AZO). However, other kinds of optically transparent materials which may be suited as electrode material may also be applicable. Further, in particular when using a minimum of optically transparent material but to increase a mechanical stability of the at least partially optically transparent electrode, an optically transparent substrate can at least partially be covered with the at least partially optically transparent electrode. Herein, the optically transparent substrate may particularly be selected from a glass substrate, from a quartz substrate, or from a substrate comprising an optically transparent but electrically insulating polymer, such as polyethylene terephthalate (**PET**).By this kind of setup it may, thus, be possible to obtain a thin electrode layer on the transparent substrate which together may, nevertheless, exhibit sufficient mechanical stability.

Besides the at least one optically transparent electrode, the remaining one or more electrodes, in particularly the one or more electrodes which are located outside the path of the light beam impinging on the capacitive device, may be optically intransparent and, preferably, reflective in order to increase the illumination within the photosensitive layer. In this particular embodiment, the at least one optically intransparent electrode may, preferably, comprise a metal electrode, in particular one or more of a silver (Ag) electrode, a platinum (Pt) electrode, a gold (Au) electrode, an aluminum (Al) electrode, or a molybdenum (Mo) electrode. Again, in particular when using a minimum of the optically intransparent material but to increase the mechanical stability of the optically intransparent electrode, the metal electrode may comprise a thin layer of the metal being deposited onto a substrate. Preferably, the thin metal layer may exhibit a thickness of 10 nm to 1000 nm, preferably of 50 nm to 500 nm, in particular of 100 nm to 250 nm. Herein, the substrate may also be optically intransparent, wherein, however, an at least partially optically transparent substrate might also be applicable.

When designing a particular embodiment of the capacitive device according to the present invention, the skilled person may consider arranging the having intransparent, partially transparent or transparent optical properties in a fashion that the incident light beam can actually reach the photosensitive layer within the capacitive device of the optical detector. Thus, those layers which are arranged within a path of the incident light beam may, preferably, be transparent, i.e. they may exhibit a transmittance which may be capable of decreasing the illumination power of the incident light beam as little as possible over at least a partition of a spectral range of the incident light beam. As generally used, the term "transmittance" refers to a fraction of an incident illumination power which may be transmitted through a layer. By way of example, the incident light beam may, first, traverse a transparent substrate (such as a glass substrate) and, subsequently, a transparent electrode (e.g. comprising a TCO) until it may reach the photosensitive layer. As a further example, the incident light beam may, first, traverse a transparent substrate and a transparent electrode and, subsequently, a transparent insulating layer (such as an $Al_2O_3$ or a $ZrO_2$ layer) until it may reach the photosensitive layer. Further examples which may incorporate additional layers and/or alternative arrangements may also be conceivable.

In a particularly preferred embodiment of the capacitive device as used within the optical sensor according to the present invention, at least one charge-carrier transporting layer may be located between the photosensitive layer and at least one of the electrodes. As generally used, the term "charge-carrier transporting layer" refers to a material which is adapted to facilitate transport of a specific type of charge carriers, i.e. electrons or holes, on a path through the material, in particular on their path from a first adjacent material to a second adjacent material which both adjoin the charge-carrier transporting layer. As an alternative, the charge-carrier transporting layer may also be denoted as a "charge-carrier extracting layer". As general, the charge carriers which may be transported or extracted within the capacitive device may be electrons or holes. Not wishing to be bound by theory, the described effect of facilitating the transport of the specific type of charge carriers on their path from the first adjacent material to the second adjacent material may be achieved by adjusting energy levels of the first adjacent material and the second adjacent material by employing the charge-carrier transporting layer.

In a particularly preferred embodiment, the charge-carrier transporting layer may be or comprise a hole transporting layer or a hole extracting layer. Herein, the hole-transporting layer may, preferably, be selected from the group consisting of

- a transition metal oxide, in particular molybdenum oxide ($MoO_3$) or nickel oxide ($NiO_2$);
- a poly-3,4-ethylenedioxythiophene (**PEDOT**), preferably **PEDOT** electrically doped with at least one counter ion, more preferably **PEDOT** doped with sodium polystyrene sulfonate (**PEDOT:PSS**);
- a polyaniline (**PANI**); and
- a polythiophene (**PT**).

However, other kinds of materials and combinations of these materials among themselves and/or with the mentioned materials may also be applicable.

Further, the capacitive device may, additionally, comprise one or more further layers which may be adapted for one or more specific purposes.

For the purpose of facilitating a production of the capacitive device suitable for the optical sensor according to the present invention, the photosensitive layer and/or the charge-carrier transporting layer may be provided by using a deposition method, preferably by a coating method, more preferred by a spin-coating method, a slot-coating method, a blade-coating method, or, alternatively, by evaporation. Thus, the resulting layer may, preferably, be a spin-cast layer, a slot-coated layer, a blade-coated layer, or a layer obtained by evaporation. Further, as mentioned above, one or more of the electrodes within the capacitive device may be provided as thin layers on a corresponding substrate. For this purpose, the respective electrode material may also be deposited onto the corresponding substrate by using a suitable deposition method, such as a coating or evaporation method.

In particular for the reasons as mentioned above, the at least one incident light beam impinging the sensor region is a modulated light beam. Accordingly, the detector according to the present invention may comprise at least one modulation device which may be capable of generating the modulated light beam traveling from the object to the detector and, thus, modulates the illumination of the object and/or at least one sensor region of the detector, such as at least one sensor region of the at least one longitudinal optical sensor. Preferably, the modulation device may be employed for generating a periodic modulation, such as by employing a periodic beam interrupting device. By way of example, the detector can be designed to bring about a modulation of the illumination of the object and/or at least one sensor region of the detector, such as at least one sensor region of the at least one longitudinal optical sensor, with a frequency of 0.05 Hz to 1 MHz, such as 0.1 Hz to 10 kHz. Within this regard, the term "modulation of the illumination" is understood to refer to a process in which a total power of the illumination is varied, preferably periodically, in particular with a single modulation frequency or, simultaneously and/or consecutively, with a plurality of modulation frequencies. In particular, a periodic modulation can be effected between a maximum value and a minimum value of the total power of the illumination. Herein, the minimum value can be 0, but can also exceed 0, such that, by way of example, complete modulation does not have to be effected. In a particularly preferential manner, the at least one modulation may be or may comprise a periodic modulation, such as a sinusoidal modulation, a square modulation, or a triangular modulation of the affected light beam. Further, the modulation may be a linear combination of two or more sinusoidal functions, such as a squared sinusoidal function, or a $\sin(t^2)$ function, where t denotes time. In order to demonstrate particular effects, advantages and feasibility of the present invention the square modulation is, in general, employed herein as an exemplary shape of the modulation which representation is, however, not intended to limit the scope of the present invention to this specific shape of the modulation. By virtue of this example, the skilled person may rather easily recognize how to adapt the related parameters and conditions when employing a different shape of the modulation.

Further, the modulation may be an even or an odd function, or alternatively, it may be particularly beneficial to use functions that are neither even or odd, such as short strong pulses followed by a period in which the light source is switched off (off-time), where the duration of the off-time is multiple times such as two, three, four, five, or more times longer than the duration of the pulse (on-time). A short on-time in combination with a longer off-time may be beneficial, as the off-time can be used for noise statistics, measurements of background light, measurement of disturbing modulated or unmodulated light sources or the like, while a short on-time may be beneficial, as the light intensity of the pulse may be much higher to induce a higher sensor signal, while the mean light intensity that is generally considered in eye safety considerations and eye safety regulations stays constant when compared to a rectangular function. Further, without being bound by this theory, depending on how charges are generated and how the FiP-effect is induced, a strong pulse with a short on-time in combination with a longer off-time may be beneficial to increase charge recombination to increase non-linearity and thus result in a better signal to noise for the non-linear FiP-signal. Further, shorter pulses shift the modulation frequency to higher frequencies that may be easier to extract from capacitive devices.

The modulation can be effected for example in a beam path between the object and the optical sensor, for example by the at least one modulation device being arranged in said beam path. Alternatively or additionally, however, the modulation can also be effected in a beam path between an optional illumination source as described below for illuminating the object and the object, for example by the at least one modulation device being arranged within said beam path. A combination of these possibilities may also be conceivable. For this purpose, the at least one modulation device can comprise, for example, a beam chopper or some other type of periodic beam interrupting device, such as comprising at least one interrupter blade or interrupter wheel, which preferably rotates at constant speed and which can, thus, periodically interrupt the illumination. Alternatively or additionally, however, it is also possible to use one or a plurality of different types of modulation devices, for example modulation devices based on an electro-optical effect and/or an acousto-optical effect. Once again alternatively or additionally, the at least one optional illumination source itself can also be designed to generate a modulated illumination, for example by the illumination source itself having a modulated intensity and/or total power, for example a periodically modulated total power, and/or by said illumination source being embodied as a pulsed illumination source, for example as a pulsed laser. Thus, by way of example, the at least one modulation device can also be wholly or partly integrated into the illumination source. Further, alternatively or in addition, the detector may comprise at least one optional transfer device, such as a tunable lens, which may itself be designed to modulate the illumination, for example by modulating, in particular by periodically modulating, the total intensity and/or total power of an incident light beam which impinges the at least one transfer device in order to traverse it before impinging the at least one longitudinal optical sensor. Various possibilities are feasible.

Further, given the same total power of the illumination, the sensor signal may, thus, be dependent on the modulation frequency of the modulation of the illumination. For potential embodiments of the longitudinal optical sensor and the longitudinal sensor signal, including its dependency on the beam cross-section of the light beam within the sensor region and on the modulation frequency, reference may be made to the optical sensor as disclosed in WO 2012/110924 A1 and 2014/097181 A1. Within this respect, the detector can be designed in particular to detect at least two sensor signals in the case of different modulations, in particular at least two longitudinal sensor signals at respectively different modulation frequencies. The evaluation device can be designed to generate the geometrical information from the at least two longitudinal sensor signals. As described in WO 2012/110924 A1 and WO 2014/097181 A1, it may be possible to resolve ambiguities and/or it is possible to take account of the fact that, for example, a total power of the illumination is generally unknown.

As used herein, the term "evaluation device" generally refers to an arbitrary device designed to generate the items of information, i.e. the at least one item of information on the position of the object. As an example, the evaluation device may be or may comprise one or more integrated circuits, such as one or more application-specific integrated circuits (ASICs), and/or one or more data processing devices, such as one or more computers, preferably one or more microcomputers and/or microcontrollers. Additional components may be comprised, such as one or more preprocessing devices and/or data acquisition devices, such as one or more devices for receiving and/or preprocessing of the sensor signals, such as one or more AD-converters and/or one or more filters. As used herein, the sensor signal may generally refer to one of the longitudinal sensor signal or to the transversal sensor signal. Further, the evaluation device may comprise one or more data storage devices. Further, as outlined above, the evaluation device may comprise one or more interfaces, such as one or more wireless interfaces and/or one or more wire-bound interfaces.

The at least one evaluation device may be adapted to perform at least one computer program, such as at least one computer program performing or supporting the step of generating the items of information. As an example, one or more algorithms may be implemented which, by using the sensor signals as input variables, may perform a predetermined transformation into the position of the object.

The evaluation device may particularly comprise at least one data processing device, in particular an electronic data processing device, which can be designed to generate the items of information by evaluating the sensor signals. Thus, the evaluation device is designed to use the sensor signals as input variables and to generate the items of information on the longitudinal position and/or on the transversal position of the object by processing these input variables. The processing can be done in parallel, subsequently or even in a combined manner. The evaluation device may use an arbitrary process for generating these items of information, such as by calculation and/or using at least one stored and/or known relationship. Besides the sensor signals, one or a plurality of further parameters and/or items of information can influence said relationship, for example at least one item of information about a modulation frequency. The relationship can be determined or determinable empirically, analytically or else semi-empirically. Particularly preferably, the relationship comprises at least one calibration curve, at least one set of calibration curves, at least one function or a combination of the possibilities mentioned. One or a plurality of calibration curves can be stored for example in the form of a set of values and the associated function values thereof, for example in a data storage device and/or a table. Alternatively or additionally, however, the at least one calibration curve can also be stored for example in parameterized form and/or as a functional equation. Separate relationships for processing the sensor signals into the items of information may be used. Alternatively, at least one combined relationship for processing the sensor signals is feasible. Various possibilities are conceivable and can also be combined.

By way of example, the evaluation device can be designed in terms of programming for the purpose of determining the items of information. The evaluation device can comprise in particular at least one computer, for example at least one microcomputer. Furthermore, the evaluation device can comprise one or a plurality of volatile or nonvolatile data memories. As an alternative or in addition to a data processing device, in particular at least one computer, the evaluation device can comprise one or a plurality of further electronic components which are designed for determining the items of information, for example an electronic table and in particular at least one look-up table and/or at least one application-specific integrated circuit (ASIC).

The detector has, as described above, at least one evaluation device. In particular, the at least one evaluation device can also be designed to completely or partly control or drive the detector, for example by the evaluation device being designed to control at least one illumination source and/or to control at least one modulation device of the detector as described below in more detail. The evaluation device can be designed, in particular, to carry out at least one measurement cycle in which one or a plurality of sensor signals, such as a plurality of sensor signals, are picked up, for example a plurality of sensor signals of successively at different modulation frequencies of the illumination.

The evaluation device is designed, as described above, to generate at least one item of information on the position of the object by evaluating the at least one sensor signal. The position of the object can be static or may even comprise at least one movement of the object, for example a relative movement between the detector or parts thereof and the object or parts thereof. In this case, a relative movement can generally comprise at least one linear movement and/or at least one rotational movement. Items of movement information can for example also be obtained by comparison of at least two items of information picked up at different times, such that for example at least one item of location information can also comprise at least one item of velocity information and/or at least one item of acceleration information, for example at least one item of information about at least one relative velocity between the object or parts thereof and the detector or parts thereof. In particular, the at least one item of location information can generally be selected from: an item of information about a distance between the object or parts thereof and the detector or parts thereof, in particular an optical path length; an item of information about a distance or an optical distance between the object or parts thereof and the optional transfer device or parts thereof; an item of information about a positioning of the object or parts thereof relative to the detector or parts thereof; an item of information about an orientation of the object and/or parts thereof relative to the detector or parts thereof; an item of information about a relative movement between the object or parts thereof and the detector or parts thereof; an item of information about a two-dimensional or three-dimensional spatial configuration of the object or of parts thereof, in particular a geometry or form of the object. Generally, the at least one item of location information can therefore be selected for example from the group consisting of: an item of information about at least one location of the object or at least one part thereof; information about at least one orientation of the object or a part thereof; an item of information about a geometry or form of the object or of a part thereof, an item of information about a velocity of the object or of a part thereof, an item of information about an acceleration of the object or of a part thereof, an item of information about a presence or absence of the object or of a part thereof in a visual range of the detector.

The at least one item of location information can be specified for example in at least one coordinate system, for example a coordinate system in which the detector or parts thereof rest. Alternatively or additionally, the location information can also simply comprise for example a distance between the detector or parts thereof and the object or parts thereof. Combinations of the possibilities mentioned are also conceivable.

As described above, the detector according to the present invention may, preferably, comprise a single individual longitudinal optical sensor. However, in a particular embodiment, such as when the different longitudinal optical sensors may exhibit different spectral sensitivities with respect to the incident light beam, the detector may comprise two or more longitudinal optical sensors, wherein each longitudinal optical sensor may be adapted to generate at least one longitudinal sensor signal. As an example, the sensor regions or the sensor surfaces of the longitudinal optical sensors may, thus, be oriented in parallel, wherein slight angular tolerances might be tolerable, such as angular tolerances of no more than 10°, preferably of no more than 5°. Herein, preferably all of the longitudinal optical sensors of the detector, which may, preferably, be arranged in form of a stack along the optical axis of the detector, may be transparent. Thus, the light beam may pass through a first transparent longitudinal optical sensor before impinging on the other longitudinal optical sensors, preferably subsequently. Thus, the light beam from the object may subsequently reach all longitudinal optical sensors present in the optical detector.

Further, the detector according to the present invention may comprise a stack of optical sensors as disclosed in WO 2014/097181 A1, in particular in a combination of one or more longitudinal optical sensors with one or more transversal optical sensors. As an example, one or more transversal optical sensors may be located on a side of the at least one longitudinal optical sensor facing towards the object. Alternatively or additionally, one or more transversal optical sensors may be located on a side of the at least one longitudinal optical sensor facing away from the object. Again, additionally or alternatively, one or more transversal optical sensors may be interposed in between at least two longitudinal optical sensors arranged within the stack. Further, the stack of optical sensors may be a combination of a single individual longitudinal optical sensor with a single individual transversal optical sensor. However, an embodiment which may only comprise a single individual longitudinal optical sensor and no transversal optical sensor may still be advantageous, such as in a case in which determining solely the depth of the object may be desired.

As mentioned above, the detector for optical detection, in particular, for determining the position of the at least one object may, specifically, be designated for determining a longitudinal position (depth) of the at least one object, a transversal position (width) of the at least one object, or a spatial position (both the depth and the width) of the at least one object.

Thus, further within the first aspect of the present invention, a detector for determining the transversal position (width) of the at least one object, which may also be denominated as "transversal optical sensor", is disclosed. It may be mentioned that the transversal optical sensor can be used as an alternative to the longitudinal optical sensor as described herein or in addition to the longitudinal optical sensor as described herein. As a further alternative, the longitudinal optical sensor as described herein can be used in addition to a known transversal optical sensor, such as in addition to a known position sensitive device (PSD), such as disclosed in WO 2012/110924 A1, WO 2014/097181 A1, or WO 2016/120392 A1.

The detector for the optical detection of the width of the at least one object according to the present invention comprises:

- at least one transversal optical sensor, wherein the transversal optical sensor has at least one sensor region, wherein the sensor region comprises at least one capacitive device, the capacitive device comprising at least two electrodes, wherein at least one insulating layer and at least one photosensitive layer are embedded between the electrodes, wherein at least one of the electrodes is at least partially optically transparent for the light beam, wherein one of the electrodes is an electrode layer having a low electrical conductivity designated to determine a position at which the incident light beam impinged the sensor region, wherein the transversal optical sensor is designed to generate at least one transversal sensor signal dependent on the position at which the incident light beam impinged the sensor region and on a modulation frequency of the light beam; and
- at least one evaluation device, wherein the evaluation device is designed to generate at least one item of information on a transversal position of the object by evaluating the transversal sensor signal.

As used herein, the term "transversal optical sensor" generally refers to a device which is adapted to determine a transversal position of at least one light beam traveling from the object to the detector. With regard to the term "position", reference may be made to the definition above. Thus, preferably, the transversal position may be or may comprise at least one coordinate in at least one dimension perpendicular to an optical axis of the detector. As an example, the transversal position may be a position of a light spot generated by the light beam in a plane perpendicular to the optical axis, such as on a light-sensitive sensor surface of the transversal optical sensor. As an example, the position in the plane may be given in Cartesian coordinates and/or polar coordinates. Other embodiments are feasible. For further details of the transversal optical sensor, reference may be made to WO 2014/097181 A1.

In accordance with the present invention, the sensor region of the transversal optical sensor comprises at least one capacitive device having at least two electrodes, wherein at least one insulating layer and at least one photosensitive layer are embedded between the electrodes. In order to allow the incident light beam to reach the at least one photosensitive layer, at least one of the electrodes is at least partially optically transparent for the incident light beam. This arrangement is, again, in in particular contrast to the optical detector as disclosed in WO 2016/092454 A1 as described above in more detail.

Further, one of the electrodes in the transversal optical sensor is an electrode layer having a low electrical conductivity, thus, allowing the electrode layer determining a transversal position at which the incident light beam impinged the sensor region. Thus, the electrode layer may exhibit a sheet resistance of 100 $\Omega$/sq to 20 000 $\Omega$/sq, preferably of 100 $\Omega$/sq to 10 000 $\Omega$/sq, more preferred 125 of $\Omega$/sq to 1000 $\Omega$/sq, specifically of 150 of $\Omega$/sq to 500 $\Omega$/sq. As generally used, the unit "$\Omega$/sq" is dimensionally equal to the SI unit $\Omega$ but exclusively reserved for the sheet resistance. By way of example, a square sheet having the sheet resistance of 10 $\Omega$/sq has an actual resistance of 10 $\Omega$, regardless of the size of the square. As a result of the sheet resistance being in the indicated range, the capacitive device may act as the transversal detector by using a similar approach as in a known position-sensitive device (PSD). This feature can be employed for this purpose by using modulated light which may be capable of inducing an ac current through the insulator layer. Further, the electrode layer may also be selected to exhibit at least partially optically transparent properties and may, thus, comprise a layer of a transparent electrically conducting organic polymer. In particular, poly(3,4-ethylene-dioxythiophene) (PEDOT) or a dispersion of PEDOT and a polystyrene sulfonic acid (PEDOT:PSS) may be selected for this purpose. On the other hand, in case the other electrode may already be at least partially transparent so that the beam bath may not traverse the electrode layer, a larger variety of different materials, including optically intransparent materials, may be employed for the electrode layer.

Thus, the transversal optical sensor is designated to provide at least one transversal sensor signal. Herein, the transversal sensor signal may generally be an arbitrary signal indicative of the transversal position. As an example, the transversal sensor signal may be or may comprise a digital and/or an analog signal. As an example, the transversal sensor signal may be or may comprise a voltage signal and/or a current signal. Additionally or alternatively, the transversal sensor signal may be or may comprise digital data. The transversal sensor signal may comprise a single signal value and/or a series of signal values. The transversal sensor signal may further comprise an arbitrary signal which may be derived by combining two or more individual signals, such as by averaging two or more signals and/or by forming a quotient of two or more signals. Further, the at least one transversal sensor signal is dependent on the position at which the incident light beam impinged the sensor region and on a modulation frequency of the incident light beam.

In particular, for the purpose of recording the transversal optical signal, the transversal optical sensor may comprise a split electrode having at least two partial electrodes. Thus, the transversal sensor signal can indicate a position of a light spot generated by the light beam within the photosensitive layer of the transversal optical sensor as long as the conductive layer at which the split electrode is located may exhibit a higher electrical resistance compared to the electrical resistance of the corresponding split electrode. Generally, as used herein, the term "partial electrode" refers to an electrode out of a plurality of electrodes, adapted for measuring at least one current and/or voltage signal, preferably independent from other partial electrodes. Thus, in case a plurality of partial electrodes is provided, the respective electrode is adapted to provide a plurality of electric potentials and/or electric currents and/or voltages via the at least two partial electrodes, which may be measured and/or used independently. Further, in particular for allowing a better electronic contact, the split electrode having the at least two partial electrodes which may each comprise a metal contact may be arranged on top of one of the conductive layers, preferably, on top of the second conductive layer which may comprise the layer of the electrically conducting polymer. Herein, the split electrode may, preferably, comprise evaporated metal contacts, additionally, arranged on top of the second conductive layer which may comprise the layer of the electrically conducting polymer, wherein the evaporated metal contacts may, in particular, comprise one or more of silver, aluminum, platinum, titanium, chromium, or gold. The metal contact may, preferably, be one of an evaporated contact or a sputtered contact or, alternatively, a printed contact or a coated contact, for which manufacturing a conductive ink may be employed. However, other kinds of arrangements may also be feasible.

The transversal optical sensor may further be adapted to generate the transversal sensor signal in accordance with the electrical currents through the partial electrodes. Thus, a ratio of electric currents through two horizontal partial electrodes may be formed, thereby generating an x-coordinate, and/or a ratio of electric currents through to vertical partial electrodes may be formed, thereby generating a y-coordinate. The detector, preferably the transversal optical sensor and/or the evaluation device, may be adapted to derive the information on the transversal position of the object from at least one ratio of the currents through the partial electrodes. Other ways of generating position coordinates by comparing currents through the partial electrodes are feasible.

The partial electrodes may generally be defined in various ways, in order to determine a position of the light beam in the photosensitive layer. Thus, two or more horizontal partial electrodes may be provided in order to determine a horizontal coordinate or x-coordinate, and two or more vertical partial electrodes may be provided in order to determine a vertical coordinate or y-coordinate. In particular, in order to maintain as much area as possible for measuring the transversal position of the light beam, the partial electrodes may be provided at a rim of the transversal optical sensor, wherein an interior space of the transversal optical sensor is covered by the second conductive layer. Preferably, the split electrode may comprise four partial electrodes which are arranged at four sides of a square or a rectangular transversal optical sensor. Alternatively, the transversal optical sensor may be of a duo-lateral type, wherein the duo-lateral transversal optical sensor may comprise two separate split electrodes each being located at one of the two conductive layers which embed the photosensitive layer, wherein each of the two conductive layers may exhibit a higher electrical resistance compared to the corresponding split electrode. However, other embodiments may also be feasible, in particular, depending on the form of the transversal optical sensor. As described above, the second conductive layer material may, preferably, be a transparent electrode material, such as a transparent conductive oxide and/or, most preferably, a transparent conductive polymer, which may exhibit a higher electrical resistance compared to the split electrode.

By using the transversal optical sensor, wherein one of the electrodes is the split electrode with the two or more partial electrodes, currents through the partial electrodes may be dependent on a position of the light beam within the photosensitive layer, which may, thus, also be denoted as the "sensor region". This kind of effect may generally be due to the fact that Ohmic losses or resistive losses may occur for an electrical charge carrier on the way from a position of the impinging light onto the photosensitive layer to the partial electrodes. Thus, due to the Ohmic losses on the way from the position of generation and/or modification of the charge carriers to the partial electrodes through the first conductive layer, the respective currents through the partial electrodes depend on the position of the generation and/or modification of the charge carriers and, thus, to the position of the light beam in the photosensitive layer. In order to accomplish a closed circuit for the electrons and/or holes, the second conductive layer as described above may, preferably, be employed. For further details with regard to determining the position of the light beam, reference may be made to the preferred embodiments below, to the disclosure of WO 2014/097181 A1 or WO 2016/120392 A1.

Further embodiments of the present invention referred to the nature of the light beam which propagates from the object to the detector. As used herein, the term "light" generally refers to electromagnetic radiation in one or more of the visible spectral range, the ultraviolet spectral range and the infrared spectral range. Therein, the term visible spectral range generally refers to a spectral range of 380 nm to 780 nm. The term infrared (IR) spectral range generally refers to electromagnetic radiation of 780 nm to 1000 $\mu$m, wherein the range of 780 nm to 1.5 $\mu$m is usually denominated as near infrared (NIR) spectral range, the range of 1.5 $\mu$m to 15 $\mu$m as mid infrared range (MidIR), and the range from 15 $\mu$m to 1000 $\mu$m as far infrared (FIR) spectral range. The term ultraviolet spectral range generally refers to electromagnetic radiation 1 nm to 380 nm, especially of 100 nm to 380 nm. Preferably, light as used with respect to the present invention is infrared light, in particular, light in the NIR spectral range.

The term "light beam" generally refers to an amount of light emitted into a specific direction. Thus, the light beam may be a bundle of the light rays having a predetermined extension in a direction perpendicular to a direction of propagation of the light beam. Preferably, the light beam may be or may comprise one or more Gaussian light beams which may be characterized by one or more Gaussian beam parameters, such as one or more of a beam waist, a Rayleigh-length or any other beam parameter or combination of beam parameters suited to characterize a development of a beam diameter and/or a beam propagation in space.

The light beam might be admitted by the object itself, i.e. might originate from the object. Additionally or alternatively, another origin of the light beam is feasible. Thus, as will be outlined in further detail below, one or more illumination sources might be provided which illuminate the object, such as by using one or more primary rays or beams, such as one or more primary rays or beams having a predetermined characteristic. In the latter case, the light beam propagating from the object to the detector might be a light beam which is reflected by the object and/or a reflection device connected to the object.

As outlined above, the at least one longitudinal sensor signal, given the same total power of the illumination by the light beam, is, according to the FiP effect, dependent on a beam cross-section of the light beam in the sensor region of the at least one longitudinal optical sensor. As used herein, the term beam cross-section generally refers to a lateral extension of the light beam or a light spot generated by the light beam at a specific location. In case a circular light spot is generated, a radius, a diameter or a Gaussian beam waist or twice the Gaussian beam waist may function as a measure of the beam cross-section. In case non-circular light-spots are generated, the cross-section may be determined in any other feasible way, such as by determining the cross-section of a circle having the same area as the non-circular light spot, which is also referred to as the equivalent beam cross-section. Within this regard, it may be possible to employ the observation of an extremum, i.e. a maximum or a minimum, of the longitudinal sensor signal, in particular a global extremum, under a condition in which the corresponding material, such as a photovoltaic material, may be impinged by a light beam with the smallest possible cross-section, such as when the material may be located at or near a focal point as affected by an optical lens. In case the extremum is a maximum, this observation may be denominated as the "positive FiP-effect", while in case the extremum is a minimum, this observation may be denominated as the "negative FiP-effect". As demonstrated in an example below, the optical sensor comprising the capacitive device having the photosensitive layer within the sensor region according to the present invention, exhibits the FiP effect, in particular, the negative FiP effect.

Thus, irrespective of the material actually comprised in the sensor region but given the same total power of the illumination of the sensor region by the light beam, a light beam having a first beam diameter or beam cross-section may generate a first longitudinal sensor signal, whereas a light beam having a second beam diameter or beam-cross section being different from the first beam diameter or beam cross-section generates a second longitudinal sensor signal being different from the first longitudinal sensor signal. As described in WO 2012/110924 A1, by comparing the longitudinal sensor signals, at least one item of information on the beam cross-section, specifically on the beam diameter, may be generated. Accordingly, the longitudinal sensor signals generated by the longitudinal optical sensors may be compared, in order to gain information on the total power and/or intensity of the light beam and/or in order to normalize the longitudinal sensor signals and/or the at least one item of information on the longitudinal position of the object for the total power and/or total intensity of the light beam. Thus, as an example, a minimum value of the longitudinal optical sensor signals may be detected, and all longitudinal sensor signals may be divided by this minimum value, thereby generating normalized longitudinal optical sensor signals, which, then, may be transformed by using the above-mentioned known relationship, into the at least one item of longitudinal information on the object. Other ways of normalization are feasible, such as a normalization using a mean value of the longitudinal sensor signals and dividing all longitudinal sensor signals by the mean value. Other options are possible.

This embodiment may, particularly, be used by the evaluation device in order to resolve an ambiguity in the known relationship between a beam cross-section of the light beam and the longitudinal position of the object. Thus, even if the beam properties of the light beam propagating from the object to the detector are known fully or partially, it is known that, in many beams, the beam cross-section narrows before reaching a focal point and, afterwards, widens again. Thus, before and after the focal point in which the light beam has the narrowest beam cross-section, along the axis of propagation of the light beam positions occur in which the light beam has the same cross-section. Thus, as an example, at a distance z0 before and after the focal point, the cross-section of the light beam is identical. Thus, in case the optical detector only comprises a single longitudinal optical sensor, a specific cross-section of the light beam might be determined, in case the overall power or intensity of the light beam is known. By using this information, the distance z0 of the respective longitudinal optical sensor from the focal point might be determined. However, in order to determine whether the respective longitudinal optical sensor may be located before or behind the focal point, additional information is required, such as a history of movement of the object and/or the detector and/or information on whether the detector is located before or behind the focal point.

In case one or more beam properties of the light beam propagating from the object to the detector are known, the at least one item of information on the longitudinal position of the object may thus be derived from a known relationship between the at least one longitudinal sensor signal and a longitudinal position of the object. The known relationship may be stored in the evaluation device as an algorithm and/or as one or more calibration curves. As an example, specifically for Gaussian beams, a relationship between a beam diameter or beam waist and a position of the object may easily be derived by using the Gaussian relationship between the beam waist and a longitudinal coordinate. Thus, as described in WO 2014/097181 A1 and also according to the present invention, the evaluation device may be adapted to compare the beam cross-section and/or the diameter of the light beam with known beam properties of the light beam in order to determine the at least one item of information on the longitudinal position of the object, preferably from a known dependency of a beam diameter of the light beam on at least one propagation coordinate in a direction of propagation of the light beam and/or from a known Gaussian profile of the light beam.

In addition to the at least one longitudinal coordinate of the object, at least one transversal coordinate of the object may be determined. Thus, generally, the evaluation device may further be adapted to determine at least one transversal coordinate of the object by determining a position of the light beam on the at least one transversal optical sensor, which may be a pixelated, a segmented or a large-area transversal optical sensor, as further outlined also in WO 2014/097181 A1.

In addition, the detector may comprise at least one transfer device, such as an optical lens, in particular one or more refractive lenses, particularly converging thin refractive lenses, such as convex or biconvex thin lenses, and/or one or more convex mirrors, which may further be arranged along the common optical axis. Most preferably, the light beam which emerges from the object may in this case travel first through the at least one transfer device and thereafter through the single transparent longitudinal optical sensor or the stack of the transparent longitudinal optical sensors until it may finally impinge on an imaging device. As used herein, the term "transfer device" refers to an optical element which may be configured to transfer the at least one light beam emerging from the object to optical sensors within the detector, i.e. the at least two longitudinal optical sensors and the at least one optional transversal optical sensor. Thus, the transfer device can be designed to feed light propagating from the object to the detector to the optical sensors, wherein this feeding can optionally be effected by means of imaging or else by means of non-imaging properties of the transfer device. In particular the transfer device can also be designed to collect the electromagnetic radiation before the latter is fed to the transversal and/or longitudinal optical sensor.

In addition, the at least one transfer device may have imaging properties. Consequently, the transfer device comprises at least one imaging element, for example at least one lens and/or at least one curved mirror, since, in the case of such imaging elements, for example, a geometry of the illumination on the sensor region can be dependent on a relative positioning, for example a distance, between the transfer device and the object. As used herein, the transfer device may be designed in such a way that the electromagnetic radiation which emerges from the object is transferred completely to the sensor region, for example is focused completely onto the sensor region, in particular if the object is arranged in a visual range of the detector.

In addition, the transfer device may also be employed for modulating light beams, such as by using a modulating transfer device. Herein, the modulating transfer device may be adapted to modulate the frequency and/or the intensity of an incident light beam before the light beam might impinge on the longitudinal optical sensor. Herein, the modulating transfer device may comprise means for modulating light beams and/or may be controlled by the modulation device, which may be a constituent part of the evaluation device and/or may be at least partially implemented as a separate unit.

Further, the detector may comprise at least one imaging device, i.e. a device capable of acquiring at least one image. The imaging device can be embodied in various ways. Thus, the imaging device can be for example part of the detector in a detector housing. Alternatively or additionally, however, the imaging device can also be arranged outside the detector housing, for example as a separate imaging device. Alternatively or additionally, the imaging device can also be connected to the detector or even be part of the detector. In a preferred arrangement, the stack of the transparent longitudinal optical sensors and the imaging device are aligned along a common optical axis along which the light beam travels. Thus, it may be possible to locate an imaging device in the optical path of the light beam in a manner that the light beam travels through the stack of the transparent longitudinal optical sensors until it impinges on the imaging device. However, other arrangements are possible.

As used herein, an "imaging device" is, generally, understood as a device which can generate a one-dimensional, a two-dimensional, or a three-dimensional image of the object or of a part thereof. In particular, the detector, with or without the at least one optional imaging device, can be completely or partly used as a camera, such as an IR camera, or an RGB camera, i.e. a camera which is designed to deliver three basic colors which are designated as red, green, and blue, on three separate connections. Thus, as an example, the at least one imaging device may be or may comprise at least one imaging device selected from the group consisting of: a pixelated organic camera element, preferably a pixelated organic camera chip; a pixelated inorganic camera element, preferably a pixelated inorganic camera chip, more preferably a CCD-chip or CMOS-chip; a monochrome camera element, preferably a monochrome camera chip; a multicolor camera element, preferably a multicolor camera chip; a full-color camera element, preferably a full-color camera chip. The imaging device may be or may comprise at least one device selected from the group consisting of a monochrome imaging device, a multi-chrome imaging device and at least one full color imaging device. A multi-chrome imaging device and/or a full color imaging device may be generated by using filter techniques and/or by using intrinsic color sensitivity or other techniques, as the skilled person will recognize. Other embodiments of the imaging device are also possible.

The imaging device may be designed to image a plurality of partial regions of the object successively and/or simultaneously. By way of example, a partial region of the object can be a one-dimensional, a two-dimensional, or a three-dimensional region of the object which is delimited for example by a resolution limit of the imaging device and from which electromagnetic radiation emerges. In this context, imaging should be understood to mean that the electromagnetic radiation which emerges from the respective partial region of the object is fed into the imaging device, for example by means of the at least one optional transfer device of the detector. The electromagnetic rays can be generated by the object itself, for example in the form of a luminescent radiation. Alternatively or additionally, the at least one detector may comprise at least one illumination source for illuminating the object.

In particular, the imaging device can be designed to image sequentially, for example by means of a scanning method, in particular using at least one row scan and/or line scan, the plurality of partial regions sequentially. However, other embodiments are also possible, for example embodiments in which a plurality of partial regions is simultaneously imaged. The imaging device is designed to generate, during this imaging of the partial regions of the object, signals, preferably electronic signals, associated with the partial regions. The signal may be an analogue and/or a digital signal. By way of example, an electronic signal can be associated with each partial region. The electronic signals can accordingly be generated simultaneously or else in a temporally staggered manner. By way of example, during a row scan or line scan, it is possible to generate a sequence of electronic signals which correspond to the partial regions of the object, which are strung together in a line, for example. Further, the imaging device may comprise one or more signal processing devices, such as one or more filters and/or analogue-digital-converters for processing and/or preprocessing the electronic signals.

Light emerging from the object can originate in the object itself, but can also optionally have a different origin and propagate from this origin to the object and subsequently toward the optical sensors. The latter case can be affected for example by at least one illumination source being used. The illumination source can be embodied in various ways. Thus, the illumination source can be for example part of the detector in a detector housing. Alternatively or additionally, however, the at least one illumination source can also be arranged outside a detector housing, for example as a separate light source. The illumination source can be arranged separately from the object and illuminate the object from a distance. Alternatively or additionally, the illumination source can also be connected to the object or even be part of the object, such that, by way of example, the electromagnetic radiation emerging from the object can also be generated directly by the illumination source. By way of example, at least one illumination source can be arranged on and/or in the object and directly generate the electromagnetic radiation by means of which the sensor region is illuminated. This illumination source can for example be or comprise an ambient light source and/or may be or may comprise an artificial illumination source. By way of example, at least one infrared emitter and/or at least one emitter for visible light and/or at least one emitter for ultraviolet light can be arranged on the object. By way of example, at least one light emitting diode and/or at least one laser diode can be arranged on and/or in the object. The illumination source can comprise in particular one or a plurality of the following illumination sources: a laser, in particular a laser diode, although in principle, alternatively or additionally, other types of lasers can also be used; a light emitting diode; an incandescent lamp; a neon light; a flame source; an organic light source, in particular an organic light emitting diode; a structured light source. Alternatively or additionally, other illumination sources can also be used. It is particularly preferred if the illumination source is designed to generate one or more light beams having a Gaussian beam profile, as is at least approximately the case for example in many lasers. For further potential embodiments of the optional illumination source, reference may be made to one of WO 2012/110924 A1 and WO 2014/097181 A1. Still, other embodiments are feasible.

The at least one optional illumination source generally may emit light in at least one of: the ultraviolet spectral range, preferably of 200 nm to 380 nm; the visible spectral range, i.e. of 380 nm to 780 nm; the infrared spectral range, preferably of 780 nm to 15 $\mu$m. Most preferably, the at least one illumination source is adapted to emit light in the NIR spectral range, preferably in the range of 780 nm to 1500 nm. Herein, it is particularly preferred when the illumination source may exhibit a spectral range which may be related to the spectral sensitivities of the optical sensors, particularly in a manner to ensure that the optical sensor which may be illuminated by the respective illumination source may provide a sensor signal with a high intensity which may, thus, enable a high-resolution evaluation with a sufficient signal-to-noise-ratio.

In a further aspect of the present invention, an arrangement comprising at least two detectors according to any of the preceding embodiments is proposed. Herein, the at least two detectors preferably may have identical optical properties but might also be different with respect from each other. In addition, the arrangement may further comprise at least one illumination source. Herein, the at least one object might be illuminated by using at least one illumination source which generates primary light, wherein the at least one object elastically or inelastically reflects the primary light, thereby generating a plurality of light beams which propagate to one of the at least two detectors. The at least one illumination source may form or may not form a constituent part of each of the at least two detectors. By way of example, the at least one illumination source itself may be or may comprise an ambient light source and/or may be or may comprise an artificial illumination source. This embodiment is preferably suited for an application in which at least two detectors, preferentially two identical detectors, are employed for acquiring depth information, in particular, for the purpose to providing a measurement volume which extends the inherent measurement volume of a single detector.

As an example useful for understanding the present invention, a human-machine interface for exchanging at least one item of information between a user and a machine is proposed. The human-machine interface as proposed may make use of the fact that the above-mentioned detector in one or more of the embodiments mentioned above or as mentioned in further detail below may be used by one or more users for providing information and/or commands to a machine. Thus, preferably, the human-machine interface may be used for inputting control commands.

The human-machine interface comprises at least one detector according to the present invention, such as according to one or more of the embodiments disclosed above and/or according to one or more of the embodiments as disclosed in further detail below, wherein the human-machine interface is designed to generate at least one item of geometrical information of the user by means of the detector wherein the human-machine interface is designed to assign the geometrical information to at least one item of information, in particular to at least one control command.

As a further example, an entertainment device for carrying out at least one entertainment function is disclosed. As used herein, an entertainment device is a device which may serve the purpose of leisure and/or entertainment of one or more users, in the following also referred to as one or more players. As an example, the entertainment device may serve the purpose of gaming, preferably computer gaming. Additionally or alternatively, the entertainment device may also be used for other purposes, such as for exercising, sports, physical therapy or motion tracking in general. Thus, the entertainment device may be implemented into a computer, a computer network or a computer system or may comprise a computer, a computer network or a computer system which runs one or more gaming software programs.

The entertainment device comprises at least one human-machine interface according to the present invention, such as according to one or more of the embodiments disclosed above and/or according to one or more of the embodiments disclosed below. The entertainment device is designed to enable at least one item of information to be input by a player by means of the human-machine interface. The at least one item of information may be transmitted to and/or may be used by a controller and/or a computer of the entertainment device.

As a further example, a tracking system for tracking the position of at least one movable object is provided. As used herein, a tracking system is a device which is adapted to gather information on a series of past positions of the at least one object or at least one part of an object. Additionally, the tracking system may be adapted to provide information on at least one predicted future position of the at least one object or the at least one part of the object. The tracking system may have at least one track controller, which may fully or partially be embodied as an electronic device, preferably as at least one data processing device, more preferably as at least one computer or microcontroller. Again, the at least one track controller may comprise the at least one evaluation device and/or may be part of the at least one evaluation device and/or might fully or partially be identical to the at least one evaluation device.

The tracking system comprises at least one detector according to the present invention, such as at least one detector as disclosed in one or more of the embodiments listed above and/or as disclosed in one or more of the embodiments below. The tracking system further comprises at least one track controller. The tracking system may comprise one, two or more detectors, particularly two or more identical detectors, which allow for a reliable acquisition of depth information about the at least one object in an overlapping volume between the two or more detectors. The track controller is adapted to track a series of positions of the object, each position comprising at least one item of information on a position of the object at a specific point in time.

The tracking system may further comprise at least one beacon device connectable to the object. For a potential definition of the beacon device, reference may be made to WO 2014/097181 A1. The tracking system preferably is adapted such that the detector may generate an information on the position of the object of the at least one beacon device, in particular to generate the information on the position of the object which comprises a specific beacon device exhibiting a specific spectral sensitivity. Thus, more than one beacon exhibiting a different spectral sensitivity may be tracked by the detector of the present invention, preferably in a simultaneous manner. Herein, the beacon device may fully or partially be embodied as an active beacon device and/or as a passive beacon device. As an example, the beacon device may comprise at least one illumination source adapted to generate at least one light beam to be transmitted to the detector. Additionally or alternatively, the beacon device may comprise at least one reflector adapted to reflect light generated by an illumination source, thereby generating a reflected light beam to be transmitted to the detector.

As a further example, a scanning system for determining at least one position of at least one object is provided. As used herein, the scanning system is a device which is adapted to emit at least one light beam being configured for an illumination of at least one dot located at at least one surface of the at least one object and for generating at least one item of information about the distance between the at least one dot and the scanning system. For the purpose of generating the at least one item of information about the distance between the at least one dot and the scanning system, the scanning system comprises at least one of the detectors according to the present invention, such as at least one of the detectors as disclosed in one or more of the embodiments listed above and/or as disclosed in one or more of the embodiments below.

Thus, the scanning system comprises at least one illumination source which is adapted to emit the at least one light beam being configured for the illumination of the at least one dot located at the at least one surface of the at least one object. As used herein, the term "dot" refers to a small area on a part of the surface of the object which may be selected, for example by a user of the scanning system, to be illuminated by the illumination source. Preferably, the dot may exhibit a size which may, on one hand, be as small as possible in order to allow the scanning system determining a value for the distance between the illumination source comprised by the scanning system and the part of the surface of the object on which the dot may be located as exactly as possible and which, on the other hand, may be as large as possible in order to allow the user of the scanning system or the scanning system itself, in particular by an automatic procedure, to detect a presence of the dot on the related part of the surface of the object.

For this purpose, the illumination source may comprise an artificial illumination source, in particular at least one laser source and/or at least one incandescent lamp and/or at least one semiconductor light source, for example, at least one light-emitting diode, in particular an organic and/or inorganic light-emitting diode. On account of their generally defined beam profiles and other properties of handleability, the use of at least one laser source as the illumination source is particularly preferred. Herein, the use of a single laser source may be preferred, in particular in a case in which it may be important to provide a compact scanning system that might be easily storable and transportable by the user. The illumination source may thus, preferably be a constituent part of the detector and may, therefore, in particular be integrated into the detector, such as into the housing of the detector. In a preferred embodiment, particularly the housing of the scanning system may comprise at least one display configured for providing distance-related information to the user, such as in an easy-to-read manner. In a further preferred embodiment, particularly the housing of the scanning system may, in addition, comprise at least one button which may be configured for operating at least one function related to the scanning system, such as for setting one or more operation modes. In a further preferred embodiment, particularly the housing of the scanning system may, in addition, comprise at least one fastening unit which may be configured for fastening the scanning system to a further surface, such as a rubber foot, a base plate or a wall holder, such comprising as magnetic material, in particular for increasing the accuracy of the distance measurement and/or the handleablity of the scanning system by the user.

In a particularly preferred embodiment, the illumination source of the scanning system may, thus, emit a single laser beam which may be configured for the illumination of a single dot located at the surface of the object. By using at least one of the detectors according to the present invention at least one item of information about the distance between the at least one dot and the scanning system may, thus, be generated. Hereby, preferably, the distance between the illumination system as comprised by the scanning system and the single dot as generated by the illumination source may be determined, such as by employing the evaluation device as comprised by the at least one detector. However, the scanning system may, further, comprise an additional evaluation system which may, particularly, be adapted for this purpose. Alternatively or in addition, a size of the scanning system, in particular of the housing of the scanning system, may be taken into account and, thus, the distance between a specific point on the housing of the scanning system, such as a front edge or a back edge of the housing, and the single dot may, alternatively, be determined.

Alternatively, the illumination source of the scanning system may emit two individual laser beams which may be configured for providing a respective angle, such as a right angle, between the directions of an emission of the beams, whereby two respective dots located at the surface of the same object or at two different surfaces at two separate objects may be illuminated. However, other values for the respective angle between the two individual laser beams may also be feasible. This feature may, in particular, be employed for indirect measuring functions, such as for deriving an indirect distance which may not be directly accessible, such as due to a presence of one or more obstacles between the scanning system and the dot or which may otherwise be hard to reach. By way of example, it may, thus, be feasible to determine a value for a height of an object by measuring two individual distances and deriving the height by using the Pythagoras formula. In particular for being able to keep a predefined level with respect to the object, the scanning system may, further, comprise at least one leveling unit, in particular an integrated bubble vial, which may be used for keeping the predefined level by the user.

As a further alternative, the illumination source of the scanning system may emit a plurality of individual laser beams, such as an array of laser beams which may exhibit a respective pitch, in particular a regular pitch, with respect to each other and which may be arranged in a manner in order to generate an array of dots located on the at least one surface of the at least one object. For this purpose, specially adapted optical elements, such as beam-splitting devices and mirrors, may be provided which may allow a generation of the described array of the laser beams.

Thus, the scanning system may provide a static arrangement of the one or more dots placed on the one or more surfaces of the one or more objects. Alternatively, illumination source of the scanning system, in particular the one or more laser beams, such as the above described array of the laser beams, may be configured for providing one or more light beams which may exhibit a varying intensity over time and/or which may be subject to an alternating direction of emission in a passage of time. Thus, the illumination source may be configured for scanning a part of the at least one surface of the at least one object as an image by using one or more light beams with alternating features as generated by the at least one illumination source of the scanning device. In particular, the scanning system may, thus, use at least one row scan and/or line scan, such as to scan the one or more surfaces of the one or more objects sequentially or simultaneously.

As a further example, a stereoscopic system for generating at least one single circular, three-dimensional image of at least one object is provided. As used herein, the stereoscopic system as disclosed above and/or below may comprise at least two of the FiP sensors as the optical sensors, wherein a first FiP sensor may be comprised in a tracking system, in particular in a tracking system according to the present invention, while a second FiP sensor may be comprised in a scanning system, in particular in a scanning system according to the present invention. Herein, the FiP sensors may, preferably, be arranged in separate beam paths in a collimated arrangement, such as by aligning the FiP sensors parallel to the optical axis and individually displaced perpendicular to the optical axis of the stereoscopic system. Thus, the FiP sensors may be able to generate or increase a perception of depth information, especially, by obtaining the depth information by a combination of the visual information derived from the individual FiP sensors which have overlapping fields of view and are, preferably, sensitive to an individual modulation frequency. For this purpose, the individual FiP sensors may, preferably, be spaced apart from each other by a distance from 1 cm to 100 cm, preferably from 10 cm to 25 cm, as determined in the direction perpendicular to the optical axis. In this preferred embodiment, the tracking system may, thus, be employed for determining a position of a modulated active target while the scanning system which is adapted to project one or more dots onto the one or more surfaces of the one or more objects may be used for generating at least one item of information about the distance between the at least one dot and the scanning system. In addition, the stereoscopic system may further comprise a separate position sensitive device being adapted for generating the item of information on the transversal position of the at least one object within the image as described elsewhere in this application.

Besides allowing stereoscopic vision, further particular advantages of the stereoscopic system which are primarily based on a use of more than one optical sensor may, in particular, include an increase of the total intensity and/or a lower detection threshold. Further, whereas in a conventional stereoscopic system which comprises at least two conventional position sensitive devices corresponding pixels in the respective images have to be determined by applying considerable computational effort, in the stereoscopic system according to the present invention which comprises at least two FiP sensors the corresponding pixels in the respective images being recorded by using the FiP sensors, wherein each of the FiP sensors may be operated with a different modulation frequency, may apparently be assigned with respect to each other.

Thus, it may be emphasized that the stereoscopic system according to the present invention may allow generating the at least one item of information on the longitudinal position of the object as well as on the transversal position of the object with reduced effort.

For further details of the stereoscopic system, reference may be made to the description of the tracking system and the scanning system, respectively.

As a further example, a camera for imaging at least one object is disclosed. The camera comprises at least one detector according to the present invention, such as disclosed in one or more of the embodiments given above or given in further detail below. Thus, the detector may be part of a photographic device, specifically of a digital camera. Specifically, the detector may be used for 3D photography, specifically for digital 3D photography. Thus, the detector may form a digital 3D camera or may be part of a digital 3D camera. As used herein, the term "photography" generally refers to the technology of acquiring image information of at least one object. As further used herein, a "camera" generally is a device adapted for performing photography. As further used herein, the term "digital photography" generally refers to the technology of acquiring image information of at least one object by using a plurality of light-sensitive elements adapted to generate electrical signals indicating an intensity of illumination, preferably digital electrical signals. As further used herein, the term "3D photography" generally refers to the technology of acquiring image information of at least one object in three spatial dimensions. Accordingly, a 3D camera is a device adapted for performing 3D photography. The camera generally may be adapted for acquiring a single image, such as a single 3D image, or may be adapted for acquiring a plurality of images, such as a sequence of images. Thus, the camera may also be a video camera adapted for video applications, such as for acquiring digital video sequences.

Thus, generally, the example refers to a camera, specifically a digital camera, more specifically a 3D camera or digital 3D camera, for imaging at least one object. As outlined above, the term imaging, as used herein, generally refers to acquiring image information of at least one object. The camera comprises at least one detector according to the present invention. The camera, as outlined above, may be adapted for acquiring a single image or for acquiring a plurality of images, such as image sequence, preferably for acquiring digital video sequences. Thus, as an example, the camera may be or may comprise a video camera. In the latter case, the camera preferably comprises a data memory for storing the image sequence.

In a further aspect of the present invention, a method for determining a position of at least one object is disclosed. The method makes use of at least one detector according to the present invention, such as of at least one detector according to one or more of the embodiments disclosed above or disclosed in further detail below. Thus, for optional embodiments of the method, reference might be made to the description of the various embodiments of the detector.

The method comprises the following steps, which may be performed in the given order or in a different order. Further, additional method steps might be provided which are not listed. Further, two or more or even all of the method steps might be performed simultaneously, at least partially. Further, two or more or even all of the method steps might be performed twice or even more than twice, repeatedly.

The method according to the present invention comprises the following steps:

- generating at least one sensor signal by using at least one optical sensor having a sensor region, wherein the sensor signal is dependent on an illumination of the sensor region of the optical sensor by an incident modulated light beam, wherein the sensor signal is further dependent on a modulation frequency of the light beam, wherein the sensor region comprises at least one capacitive device, the capacitive device comprising at least two electrodes, wherein at least one insulating layer and at least one photosensitive layer are embedded between the electrodes wherein at least one of the electrodes is at least partially optically transparent for the light beam; and
- evaluating the sensor signal of the optical sensor by determining an item of information on the position of the object from the sensor signal.

For further details concerning the method according to the present invention, reference may be made to the description of the optical detector as provided above and/or below.

In a further aspect of the present invention, a use of a detector according to the present invention is disclosed. Therein, a use of the detector for a purpose of determining a position of an object, in particular a lateral position of an object, is proposed, wherein the detector may, preferably, be used concurrently as at least one longitudinal optical sensor or combined with at least one additional longitudinal optical sensor, in particular, for a purpose of use selected from the group consisting of: a position measurement, in particular in traffic technology; an entertainment application; a security application; a human-machine interface application; a tracking application; a scanning application; a stereoscopic vision application; a photography application; an imaging application or camera application; a mapping application for generating maps of at least one space; a homing or tracking beacon detector for vehicles; a position measurement of objects with a thermal signature (hotter or colder than background); a machine vision application; a robotic application.

Further uses of the optical detector according to the present invention may also refer to combinations with applications already been known, such as determining the presence or absence of an object; extending optical applications, e.g. camera exposure control, auto slide focus, automated rear view mirrors, electronic scales, automatic gain control, particularly in modulated light sources, automatic headlight dimmers, night (street) light controls, oil burner flame outs, or smoke detectors; or other applications, such as in densitometers, e.g. determining the density of toner in photocopy machines; or in colorimetric measurements.

Further, the devices according to the present invention may be used for infra-red detection applications, heat-detection applications, thermometer applications, heat-seeking applications, flame-detection applications, fire-detection applications, smoke-detection applications, temperature sensing applications, spectroscopy applications, or the like. Further, devices according to the present invention may be used in photocopy or xerography applications. Further, devices according to the present invention may be used to monitor exhaust gas, to monitor combustion processes, to monitor pollution, to monitor industrial processes, to monitor chemical processes, to monitor food processing processes, to assess water quality, to assess air quality, or the like. Further, devices according to the present invention may be used for quality control, temperature control, motion control, exhaust control, gas sensing, gas analytics, motion sensing, chemical sensing, or the like.

Preferably, for further potential details of the optical detector, the method for determining a position of at least one object, the human-machine interface, the entertainment device, the tracking system, the camera and the various uses of the detector, in particular with regard to the transfer device, the transversal optical sensor, the longitudinal optical sensor, the evaluation device, the modulation device, the illumination source, and the imaging device, specifically with respect to the potential materials, setups and further details, reference may be made to one or more of WO 2012/110924 A1, WO 2014/097181 A1, and WO 2016/120392 A1, the full content of all of which is herewith included by reference.

The above-described detector, the method, the human-machine interface and the entertainment device and also the proposed uses have considerable advantages over the prior art. Thus, generally, a simple and, still, efficient detector for an accurate determining a position of at least one object in space may be provided. Therein, as an example, three-dimensional coordinates of an object or a part thereof may be determined in a fast and efficient way.

As compared to devices known in the art, in particular, with FiP devices which employ dye-sensitized solar cells (DSC), larger ac photocurrents may be observable in the optical detector according to the present invention at comparative illumination levels. Thus, larger sensor signals may be obtained. The same can be true for the ratio of the in-focus response vs. the out-of-focus response while the frequency response (band width) may exhibit a similar behavior. For representative examples see the Figures below.

Brief description of the figures

Further optional details and features of the invention are evident from the description of preferred exemplary embodiments which follows in conjunction with the dependent claims. In this context, the particular features may be implemented alone or with features in combination. The invention is not restricted to the exemplary embodiments. The exemplary embodiments are shown schematically in the figures. Identical reference numerals in the individual figures refer to identical elements or elements with identical function, or elements which correspond to one another with regard to their functions.

Specifically, in the figures:

| | |
|---|---|
| Figure 1 | illustrates a preferred exemplary embodiment of a detector for optical detection of at least one object according to the present invention in a schematic fashion, wherein the detector comprises at least one longitudinal optical sensor having a sensor region comprising at least one capacitive device; |
| Figures 2A and 2B | each illustrate a cross section of a particularly preferred exemplary setup of the capacitive device for application in a longitudinal optical sensor in a schematic fashion; |
| Figures 3A to 3N | illustrate cross sections of two preferred examples of a first exemplary embodiment of the capacitive device for application in a longitudinal optical sensor in a schematic fashion (Figures 3A and 3B), the photocurrent as a function of distance of the sensor region to the object (Figures 3C, 3G, 3J, 3K and 3N), the photocurrent as a function of a modulation frequency of an incident modulated light beam (Figures 3D, 3H, 3I, 3L and 3M), and a current vs. voltage characterization of the capacitive device (Figures 3E and 3F); |
| Figures 4A to 4G | illustrate a cross section of a preferred example of a second exemplary embodiment of the capacitive device for application in a longitudinal optical sensor in a schematic fashion (Figure 4A), the photocurrent as a function of distance of the sensor region to the object (Figures 4B to 4E), and the photocurrent as a function of a modulation frequency of an incident modulated light beam (Figures 4F and 4G); |
| Figures 5A to 5I | illustrate cross sections of two preferred examples of a third exemplary embodiment of the capacitive device 134 for application in a longitudinal optical sensor in a schematic fashion (Figures 5A and 5B), the photocurrent as a function of distance of the sensor region to the object (Figures 5C to 5G), and the photocurrent as a function of a modulation frequency of an incident modulated light beam (Figures 5H and 5I); |
| Figures 6A to 6E | illustrate a cross section of a preferred example of a fourth exemplary embodiment of the capacitive device for application in a longitudinal optical sensor in a schematic fashion (Figure 6A), the photocurrent as a function of distance of the sensor region to the object (Figures 6B and 6C), and the photocurrent as a function of a modulation frequency of an incident modulated light beam (Figures 6D and 6E); |
| Figures 7A to 7I | illustrate cross sections of two preferred examples of a fifth exemplary embodiment of the capacitive device for application in a longitudinal optical sensor in a schematic fashion (Figures 7A and 7B), the photocurrent as a function of distance of the sensor region to the object (Figures 7C, 7E and 7H), the photocurrent as a function of a modulation frequency of an incident modulated light beam (Figures 7D, 7F and 7I), and a current vs. voltage characterization of the capacitive device (Figure 7G); |
| Figure 8 | shows an exemplary embodiment of the optical detector and of a detector system, a human-machine interface, an entertainment device, a tracking system, and a camera in a schematic fashion, each comprising the optical detector according to the present invention; |

Figure 9A to 9C      illustrate a cross section of a preferred example of a sixth exemplary embodiment of the capacitive device for application in a transversal optical sensor in a schematic fashion (Figure 9A) and a number of measurement point positions as determined by using the detector according to the present invention compared with actual positions otherwise available (Figures 9B and 9C); and

Figures 10A to 10C      illustrate cross sections of preferred examples of a seventh exemplary embodiment of the capacitive device in a transversal optical sensor in a schematic fashion.

Exemplary embodiments

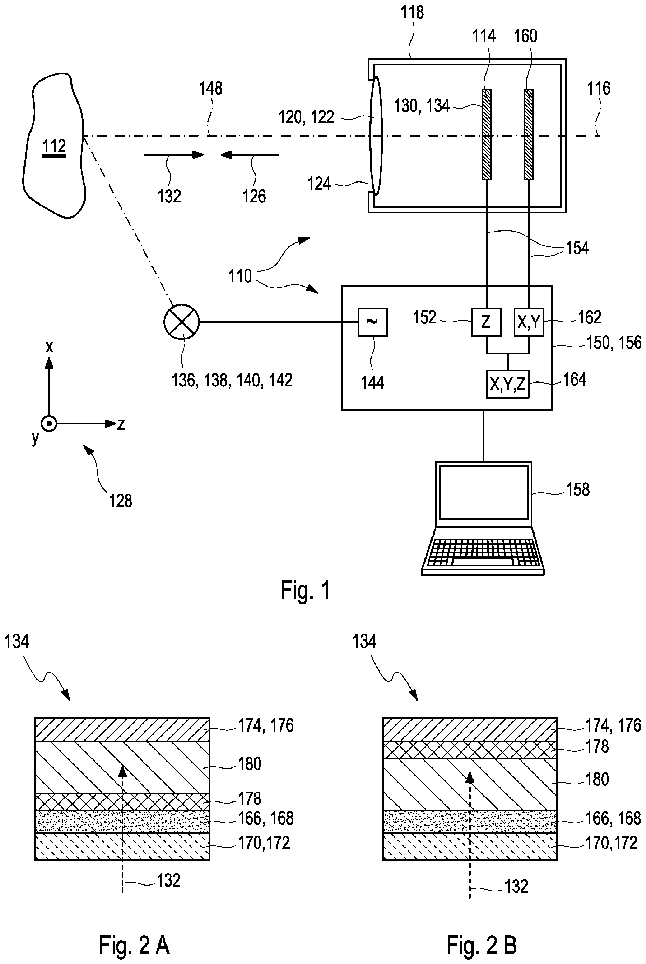

Figure 1 illustrates, in a highly schematic illustration, a first exemplary embodiment of a detector 110 according to the present invention for determining a position of at least one object 112. However, other embodiments are feasible. In general, the Figures and the various elements as displayed therein are not to scale.

The detector 110 as schematically depicted in Figure 1 comprises at least one longitudinal optical sensor 114, which, in this particular embodiment, is arranged along an optical axis 116 of the detector 110. Specifically, the optical axis 116 may be an axis of symmetry and/or rotation of the setup of the optical sensors 114. The optical sensors 114 may be located inside a housing 118 of the detector 110. Further, at least one transfer device 120 may be comprised, preferably a refractive lens 122. An opening 124 in the housing 118, which may, particularly, be located concentrically with regard to the optical axis 116, preferably, defines a direction of view 126 of the detector 110. A coordinate system 128 may be defined, in which a direction parallel or antiparallel to the optical axis 116 is defined as a longitudinal direction, whereas directions perpendicular to the optical axis 116 may be defined as transversal directions. In the coordinate system 128, symbolically depicted in Figure 1, the longitudinal direction is denoted by "z" while the transversal directions are denoted by "x" and "y", respectively. However, other types of coordinate systems 128 may also be feasible.

Further, the longitudinal optical sensor 114 is designed to generate at least one longitudinal sensor signal in a manner dependent on an illumination of a sensor region 130 comprised by the longitudinal optical sensor 114 by an incident modulated light beam 132. Thus, according to the FiP effect, the longitudinal sensor signal, given the same total power of the illumination, is dependent on a beam cross-section of the light beam 132 in the respective sensor region 130 and on a modulation frequency of the modulated light beam 132. According to the present invention and in particular contrast to the optical detector as disclosed in WO 2016/092454 A1, the sensor region 130 of the longitudinal optical 110 sensor comprises at least one capacitive device 134, in particular, in one of the preferred embodiments which are described in Figures 2A, 2B, 3A, 3B, 4A, 5A, 5B, 6A, 7A, 7B, 10A, 10B or 10C or a combination thereof in more detail.

The modulated light beam 132 for illumining the sensor region 130 of the longitudinal optical sensor 114 may be generated by a light-emitting object 112 being capable of providing the illumination in a modulated manner. Alternatively or in addition, the light beam 132 may be generated by a separate illumination source 136, which may include an ambient light source and/or an artificial light source 138, such as a light-emitting diode (LED) 140, which may be adapted to illuminate the object 112 in a fashion that the object 112 may be able to reflect at least a part of the light generated by the illumination source 136 in a manner that the light beam 132 may reach the sensor region 130 of the longitudinal optical sensor 114, preferably by entering the housing 118 of the optical detector 110 through the opening 124 along the optical axis 116.

Thus, the illumination source 136 may be a modulated light source 142, wherein one or more modulation properties of the illumination source may be controlled by at least one modulation device 144. Alternatively or in addition, the modulation may be effected in a first beam path 146 between the illumination source and the object 112 and/or in a second beam path 148 between the object 112 and the longitudinal optical sensor 114. Further possibilities may be conceivable. In this particular embodiment, it may be advantageous to take into account one or more of the modulation properties, in particular the modulation frequency, when evaluating the sensor signal of the transversal optical sensor 114 for determining the at least one item of information on the position of the object 112 in an evaluation device 150.

The evaluation device 150 is, generally, designed to generate at least one item of information on a position of the object 112 by evaluating the sensor signal of the longitudinal optical sensor 114. Herein, the evaluation device 150 may comprise one or more electronic devices and/or one or more software components, in order to evaluate the sensor signals, which are symbolically denoted by a longitudinal evaluation unit 152 (denoted by "z"). For this purpose, the evaluation device 150 may, preferably, be adapted to determine the at least one item of information on the longitudinal position of the object 112 by comparing more than one longitudinal sensor signals of the longitudinal optical sensor 114. As explained above, the longitudinal sensor signal as provided by the longitudinal optical sensor 114 upon impingement by the modulated light beam 132 depends on an illumination of the sensor region 130 by the light beam 132, wherein the longitudinal sensor signal, given the same total power of the illumination, is dependent on a beam cross-section of the light beam 132 in the sensor region 130 and on a modulation frequency of the light beam 132. As for example explained in WO 2012/110924 A1 in more detail, the evaluation device 150 may, thus, be adapted to determine the at least one item of information on the longitudinal position of the object 112 by comparing more than one longitudinal sensor signals of the longitudinal optical sensor 114.

Generally, the evaluation device 150 may be part of a data processing device and/or may comprise one or more data processing devices. The evaluation device 150 may be fully or partially integrated into the housing 118 and/or may fully or partially be embodied as a separate device which is electrically connected in a wireless or wire-bound fashion, such as via one or more signal leads 154, to the longitudinal optical sensor 114. The evaluation device 150 may further comprise one or more additional components, such as one or more electronic hardware components and/or one or more software components, such as one or more measurement units and/or one or more evaluation units (not depicted in Figure 1) and/or one or more controlling units, such as the modulation device 144 being adapted to control the modulation properties of the modulated light source 142. Further, the evaluation device 150 may be a computer 156 and/or may comprise a computer system comprising a data processing device 158. However, other embodiments may also be feasible.

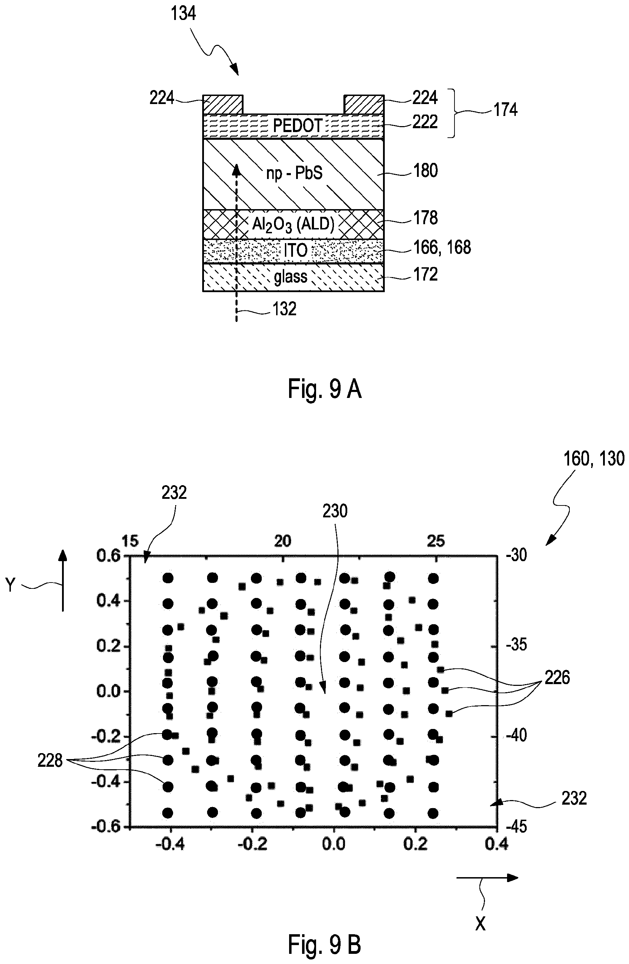

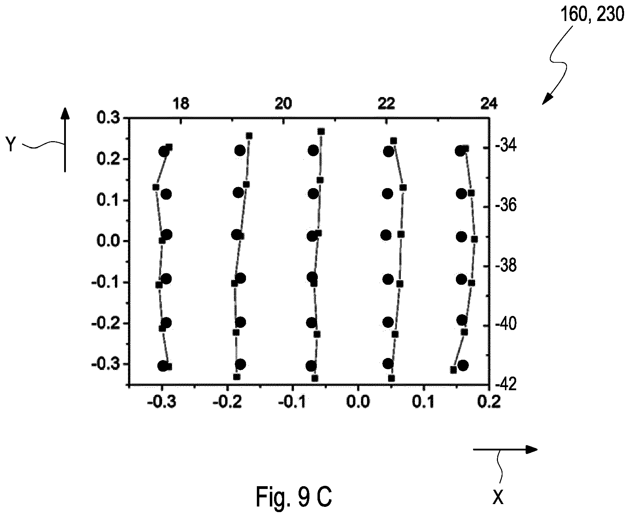

In the preferred embodiment of Figure 1, the optical detector 110 further comprises at least one transversal optical sensor 160 which, in this particular embodiment, is also arranged along an optical axis 116 of the detector 110. Herein, the transversal optical sensor 160 may, preferably, be adapted to determine a transversal position of the modulated light beam 132 traveling from the object 112 to the optical detector 110. Herein, the transversal position may be a position in at least one dimension perpendicular an optical axis 116 of the optical detector 110, in this particular embodiment denoted by "x" and "y", respectively, according to the coordinate system 128. The transversal optical sensor 160 as used here may, preferably, exhibit a setup as illustrated below in the exemplary embodiment of Figure 9. However, other setups may also be feasible, such as by using a known position sensitive device (PSD), in particular a photodetector as, for example, disclosed in WO 2012/110924 A1 or WO 2014/097181 A1, or a photoconductor as, for example, disclosed in WO 2016/120392 A1. However, other setups of the transversal optical sensor 160 may also be applicable here.

For the purpose of determining the transversal position, the transversal optical sensor 160 may further be adapted to generate at least one transversal sensor signal. The transversal sensor signal may be transmitted in a wireless or wire-bound fashion, such as via one or more signal leads 154, to the evaluation device 150, which may further be designed to generate at least one item of information on a transversal position of the object 112 by evaluating the transversal sensor signal. For this purpose, the evaluation device 150 may further comprise one or more electronic devices and/or one or more software components, in order to evaluate the sensor signals, which are symbolically denoted by a transversal evaluation unit 162 (denoted by "z"). Further, by combining results derived by the evolution units 152, 162, position information 164, preferably three-dimensional position information, symbolically denoted here by "x, y, z", may thus be generated.

The optical detector 110 may have a straight beam path or a tilted beam path, an angulated beam path, a branched beam path, a deflected or split beam path or other types of beam paths. Further, the light beam 132 may propagate along each beam path or partial beam path once or repeatedly, unidirectionally or bidirectionally. Thereby, the components listed above or the optional further components listed in further detail below may fully or partially be located in front of the longitudinal optical sensors 114 and/or behind the longitudinal optical sensors 114.

Figures 2A and 2B each illustrate a cross section of an exemplary setup of a preferred example of the capacitive device 134, in particular for use in the longitudinal optical sensor 114, in a highly schematic fashion. As depicted in Figure 2A, the capacitive device 134 has an optically transparent first electrode 166. Preferably, the capacitive device 134 may be arranged in a manner that the optically transparent first electrode 166 may be located towards the incident modulated light beam 132. The optically transparent first electrode 166 may comprise a layer of one or more transparent conductive oxides 168 (TCO), in particular indium-doped tin oxide (ITO). However, other kinds of optically transparent materials, such as fluorine-doped tin oxide (FTO) or aluminum-doped zinc oxide (AZO), may also be suitable for this purpose. In order to be able to using a minimum of the optically transparent oxide 168 but still keep the optically transparent first electrode 166 mechanically stable, the optically transparent oxide 168 may be placed on top of an optically transparent substrate 170, in particular on top of a glass substrate 172, preferably by using a deposition method, such as a coating or an evaporation method. Alternatively, a quartz substrate or a substrate comprising an optically transparent but electrically insulating polymer, such as polyethylene terephthalate (PET), may also be used for this purpose.

Further, the capacitive device 134 has a second electrode 174, which may be optically intransparent, thus, allowing the modulated light beam 132 to be reflected here. Accordingly, the capacitive device 134 may be arranged in a manner that the optically intransparent second electrode 174 may be located away from the incident modulated light beam 132. However, in other embodiments, the second electrode 174 may also be at least partially transparent for the incident modulated light beam 132.

In order to provide the longitudinal optical sensor 114, the second electrode 174 may, in this particular embodiment, comprise a metal electrode 176, such as a silver (Ag) electrode, a platinum (Pt) electrode, a gold (Au) electrode, an aluminum (Al) electrode, or a molybdenum (Mo) electrode. However, other kinds of metals may also be feasible. Preferably, the metal electrode 176 may comprise a thin layer of metal which may be deposited onto a substrate, such as a further layer.

In order to provide the transversal optical sensor 160, the second electrode 174 may comprise a low electrical conductivity electrode which may be adapted to allow determining the position at which the charge was actually generated which can, reasonably, be considered as the position at which the incident light beam impinged the sensor region 130. For this purpose, the second electrode 174 may, additionally, be equipped with the at least one split electrode. For further details, reference may be made to the description of Figure 9A below.

Further, the capacitive device 134 according to the present invention comprises an insulating layer 178 which may be provided in form of a dielectric material being located as intervening medium between the first electrode 166 and the second electrode 174. However, the insulating layer 178 may, alternatively or in addition, be provided in form of an electrically insulating component (not depicted here), such as a diode or an arrangement having a junction. Applying the insulating layer 178 having dielectric properties between the first electrode 166 and the second electrode 174 may be particularly advantageous since it may prevent the first electrode 166 and the second electrode 174 from achieving a direct electrical contact, thus, avoiding a short-cut between the first electrode 166 and the second electrode 174. In addition, depending on a permittivity of the insulating layer 178, the insulating layer 178 between the first electrode 166 and the second electrode 174 may, further, allow storing an increased amount of charge in the capacitive device 134 at a given voltage compared to a capacitive device which would have a vacuum located between its electrodes.

In the exemplary embodiment of Figure 2A, the insulating layer 178 is an optically at least partially transparent insulating layer in order to allow the incident light beam 132 to at least partially traverse the insulating layer 178. Thus, the insulating layer 178 may, preferably, exhibit a transmittance which may be capable of decreasing the illumination power of the incident light beam 132 as little as possible over a spectral range of the incident light beam 132. As described elsewhere in this document in more detail, the insulating layer 178 which may exhibit optically at least partially transparent properties may, preferably, be chosen to be a transparent metal oxide, in particular, comprising a layer of aluminum oxide $Al_2O_3$ or zirconium dioxide $ZrO_2$. However, other kinds of materials may also be used for the insulating layer 178.

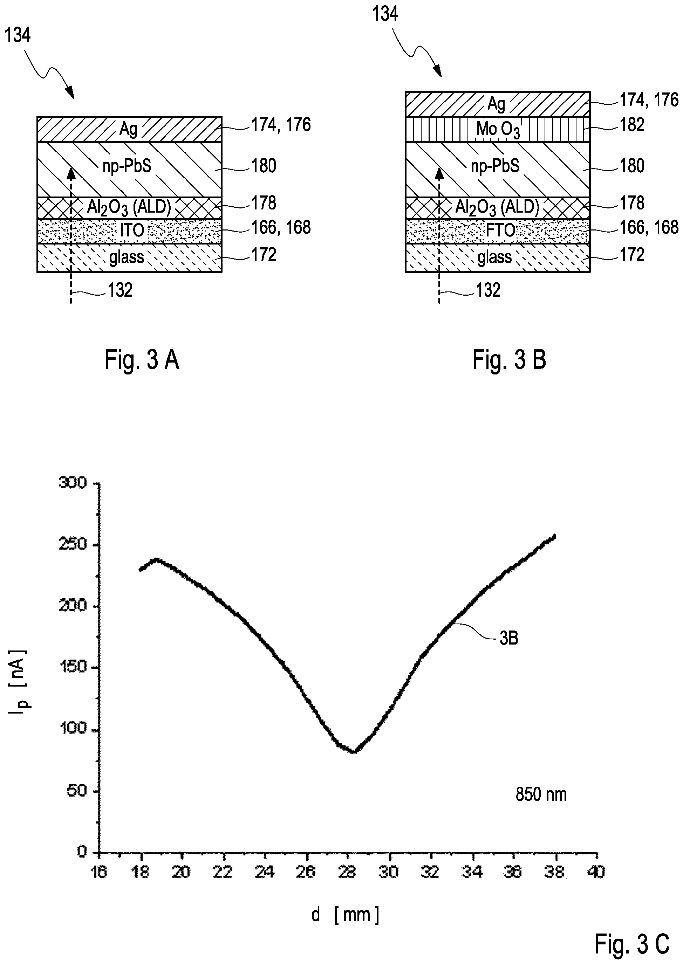

In addition to the insulating layer 178, the capacitive device 134 according to the present invention, additionally, has at least one photosensitive layer 180 which comprises at least one material which is susceptible to an influence of the incident modulated light beam 132. As described elsewhere in this document, upon illumination of the photosensitive layer 180 by the incident modulated light beam 132, an amount of charge carriers is generated in the photosensitive layer 180, wherein the amount of the charge carriers which are generated in this fashion depends on the illumination of the photosensitive layer 180 and the frequency of modulation of the incident modulated light beam 132. Herein, the incident modulated light beam 132 may be considered as an alternating light beam being capable of generating the charge carriers in an alternating fashion, thus, giving rise to an alternating current (ac) in the capacitive device 134. As a result, the capacitive device 134 having the photosensitive layer 180 as described here allows the longitudinal optical sensor 114 to generate the at least one ac longitudinal sensor signal depending on both the illumination of the sensor region 130 and the frequency of modulation of the incident modulated light beam 132. Accordingly, the detector 110 comprising the capacitive device 134 exhibits the FiP effect which means that the longitudinal sensor signal provided by the capacitive device 134 may, thus, be in form of an ac photocurrent which decreases when the incident modulated incident light beam 134 is focused onto the photosensitive layer 180 as the sensor region 130 of the longitudinal optical sensor 114. As described elsewhere in this document in more detail, such as in the embodiments as schematically depicted in any one of Figures 3A, 3B, 4A, 5A, 5B, 6A, 7A, 7B, 9A, 10A, 10B or 10C, or a combination thereof, the photosensitive layer 180 may be implemented by using various setups.

In contrast to Figure 2A, in the exemplary embodiment of the capacitive device 134 as depicted in Figure 2B the incident modulated light beam 132, after having traversed the first transparent electrode 166, first impinges the photosensitive layer 180 before it may reach the insulating layer 178. Consequently, the insulating layer 178 may, in this particular embodiment, be or comprise an intransparent insulating layer which can, additionally, be capable of reflecting the incident light beam 132 into the photosensitive layer 180, thus, increasing the intensity of the light within the photosensitive layer 180. However, the insulating layer 178 may, nevertheless, also be or comprise a transparent insulating layer, in which case the incident light beam 132 may be reflected by the adjacent second electrode 174 into the photosensitive layer 180, thereby being capable of providing a comparative advantage. The arrangement as shown in Figure 2B may, thus, allow using a wider range of materials for the insulating layer 178.

Figures 3A and 3B each illustrate a cross section of a preferred example of a setup of a first exemplary embodiment of the capacitive device 134, in particular for use in the longitudinal optical sensor 114, in a schematic fashion while Figures 3C to 3N provide experimental results obtained for the capacitive device 134 as arranged accordingly.

According to Figures 3A and 3B, the first exemplary embodiment of the capacitive device 134 comprises the glass substrate 172 which is coated by the layer of the transparent conductive oxide (TCO) 168 comprising indium-doped tin oxide (ITO) in the example of Figure 3A and fluorine-doped tin oxide (FTO) in the example of Figure 3B. However, both materials can also be used in both examples. Alternatively, a layer of aluminum-doped zinc oxide (AZO) or of another TCO may also be used as the transparent conductive oxide 168. As an alternative to the glass substrate 172, a quartz substrate or a substrate comprising an optically transparent and electrically insulating polymer, such as polyethylene terephthalate (PET), may also be feasible.

Further, the capacitive device 134 in the first exemplary embodiment comprises a thin insulating aluminum oxide ($Al_2O_3$) layer having a thickness of approximately 120 nm as the insulating layer 178, wherein the $Al_2O_3$ layer which has been provided in this example by applying atomic layer deposition (ALD) at around 200 °C directly onto the ITO coated glass substrate 172. As will be demonstrated below in more detail, the $Al_2O_3$ (ALD) layer which has been found to exhibit excellent insulating properties even at thicknesses of 1 nm to 1000 nm, preferably of 10 nm to 250 nm, in particular of 20 nm to 150 nm, may allow for a facile preparation of a photoactive capacitor by additionally using a suitable material as the photosensitive layer 180.

For this purpose, the capacitive device 134 comprises, in addition to the thin insulating $Al_2O_3$ (ALD) layer, a layer of nanoparticulate lead sulfide (np-PbS) which acts as the photosensitive layer 180 in the capacitive device 134. Alternatively, the nanoparticulate lead sulfide may also be denominated as "PbS nanoparticles" or as "PbS quantum dots", abbreviated to "PbS-QDs". In this particular example, the photosensitive layer 180 comprises np-PbS, wherein the PbS nanoparticles exhibited a spherical shape combined with a narrow particle size distribution having a maximum at the particle size of 8 nm. These kinds of PbS nanoparticles are known to cover the infrared wavelength range of 1000 to 1600 nm in emission, wherein the absorption properties of the nanoparticles are determined by their particle size and a particle size of 8 nm is expected to achieve absorption around 1550 nm. The np-PbS was deposited from a suspension in octane by spin-coating (50 mg/ml np-PbS in octane, spun cast at 4000 rpm).

In order to facilitate a transport of the charge carriers generated in the photosensitive layer 180 from their place of generation within the photosensitive layer 180 to the adjacent metal electrode 176, the capacitive device 134 in the further example as illustrated in Figure 3B further comprises a charge-carrier transporting layer 182 which is particularly configured for this purpose. In this embodiment, the charge-carrier transporting layer 182 comprises a hole transporting layer of molybdenum oxide ($MoO_3$). Thus, a thin layer of approximately 15 nm $MoO_3$ was deposited onto the np-PbS photosensitive layer 180 prior to depositing the thin layer of approximately 200 nm silver (Ag) onto the thin $MoO_3$ layer. Possible material alternatives for the charge-carrier transporting layer 182 may be nickel oxide ($NiO_2$), a poly-3,4-ethylenedioxythiophene (**PEDOT**), preferably **PEDOT** electrically doped with at least one counter ion, more preferably **PEDOT** doped with sodium polystyrene sulfonate (**PEDOT:PSS**), a polyaniline (**PANI**), or a polythiophene (**PT**). As a further alternative, a charge-carrier extraction layer (not depicted here) may also be feasible for facilitating the transport of the charge carriers generated in the photosensitive layer 180 from their place of generation to the electrode.

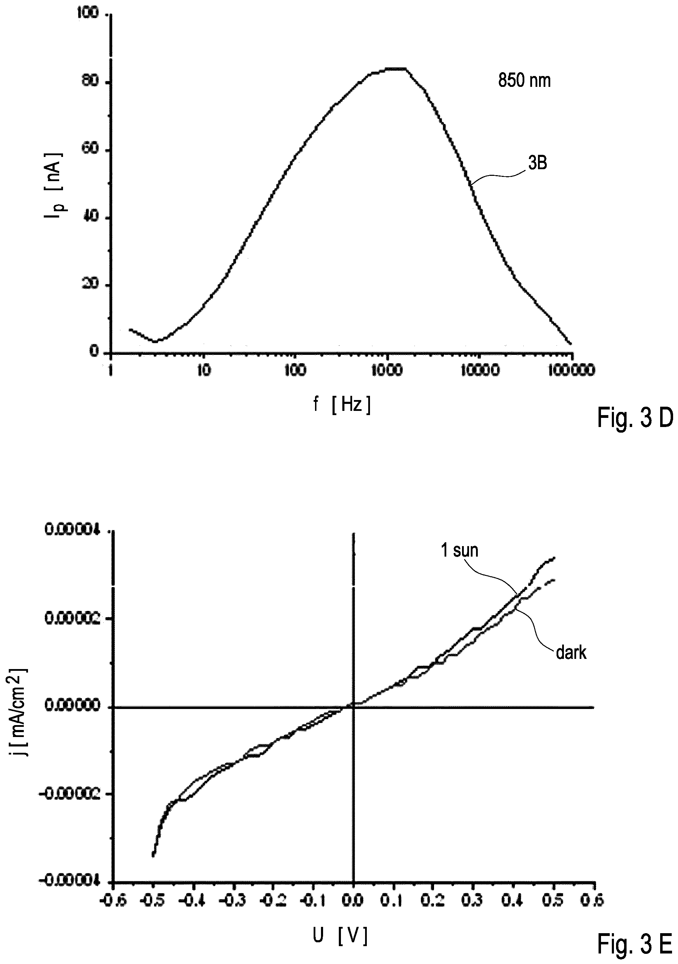

As a result, the incident modulated light beam 132 may generate holes as the charge carriers in the photosensitive layer 180 in the detector 110 comprising the capacitive device 134 of the first embodiment according to both examples of Figures 3A and 3B, wherein the amount of the charge carriers may vary with both the beam cross-section of the light beam 132 in the np-PbS layer and the modulation frequency of the incident modulated light beam 132. While the first effect can be seen in a variation of the alternating current (ac) photocurrent $I_p$ in nA with a distance $d$ of the sensor region 130 to the object 112 in mm as depicted in Figure 3C, the latter effect is illustrated in Figure 3D which displays the variation of the ac photocurrent $I_p$ in nA with the modulation frequency of the incident modulated light beam 132 in Hz. Consequently, the capacitive device 134 according to this exemplary embodiment exhibits a strong non-linear behavior of the extracted ac photocurrent $I_p$ with the variation of the size of the impinging light spot, denoted as the "FIP effect".

In contrast to known FIP devices based on photodiodes or photoconductors, where a decrease of the FIP signal with increasing modulation frequency of the incident light beam 132 can typically be observed, the frequency response of the FIP signal as recorded according to Figure 3D for the example of Figure 3B firstly increases with increasing modulation frequency until a maximum value for the FIP signal is achieved at in a region around 1 kHz to 5 kHz whereupon the FIP signal decreases for further increasing modulation frequencies of the incident light beam 132. The initial increase of the FIP signal with increasing modulation frequencies of the incident light beam 132 can be attributed to a capacitive nature of the capacitive device 134 as comprised by the longitudinal optical sensor 114 according to the present invention.

Further, Figure 3E displays a current vs. voltage characterization of the capacitive device 134 according to the example of Figure 3B. Herein, a variation of a density $j$ of the photocurrent $I_p$ in mA/cm$^2$ is shown with respect to the variation of a voltage Uin V as applied across the capacitive device 134. Thus, a pronounced non-linearity between an incident photon density and an ac photocurrent $I_p$ can been observed in this exemplary embodiment, while a direct current (dc) photocurrent has been found to be negligible. As mentioned above, no photocurrent $I_p$ can be detected at dc light conditions while modulated light, however, yields an appreciable photocurrent $I_p$.

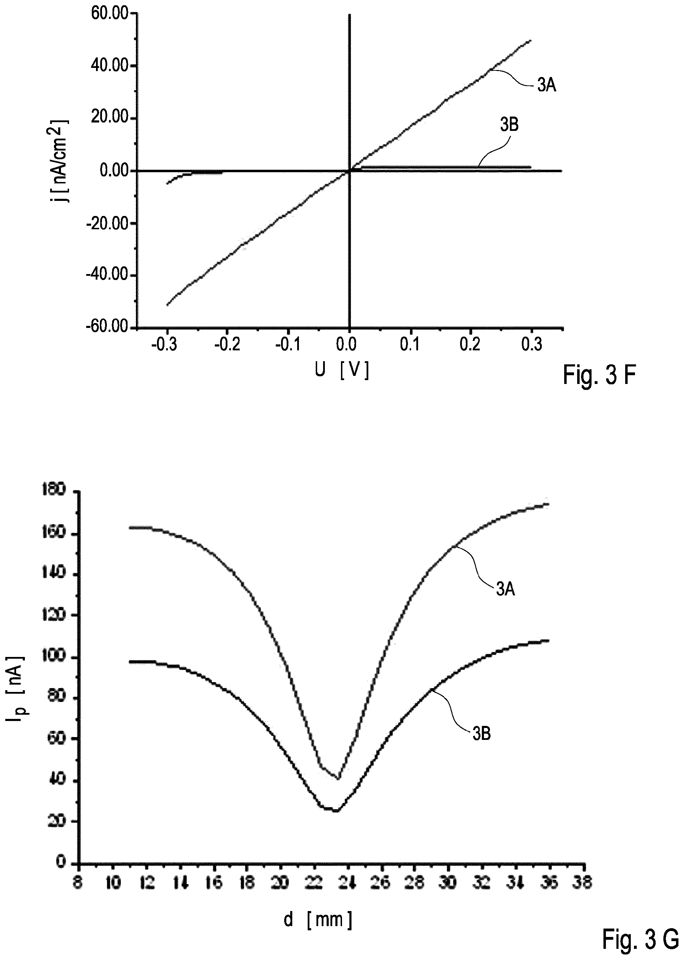

Similarly, Figure 3F displays a comparison of the current vs. voltage characterizations for both examples according to Figures 3A and 3B simulated at one sun white light illumination. Herein, no appreciable dc photocurrent $I_p$ is detected at short circuit conditions, thus leading to a vanishing of the current density $j$, too. A parallel resistance in the example of Figure 3A with only Ag electrodes is significantly larger (3.4 MΩ) compared to the example of Figure 3B with both the $MoO_3$ charge-carrier transporting layer 182 and the Ag electrodes (0.4 MΩ)

Further, for obtaining the experimental results as presented in Figures 3G to 3I the light emitting diode (LED) 140 was operated at a wavelength of 850 nm, a modulation frequency of 375 Hz, and an illumination power of 165 µW. A 50 mm objective was employed at a distance of 83 cm to the LED 140. Compared to a focused state 184 in which the focus is located in the sensor region 130, a defocused state 186 was obtained by moving the LED 140 about 12.5 mm.

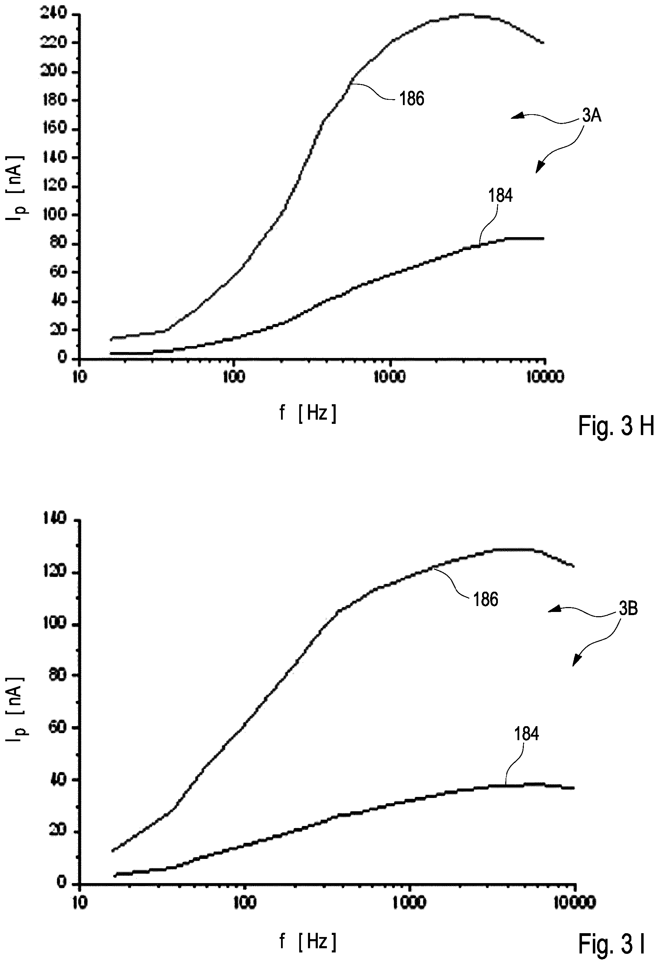

In particular, Figure 3G illustrates a comparison of the variation of the alternating current (ac) photocurrent $I_p$ in nA with a distance $d$ of the sensor region 130 to the object in mm for both examples of Figures 3A and 3B. Further, Figures 3H and 3I each display a comparison of the variation of the ac photocurrent $I_p$ in nA with the modulation frequency of the incident modulated light beam 132 in Hz for both the focused state 184 and the defocused state 186 for the example of Figure 3A (Figure 3H) and for the example of Figure 3B (Figure 3I), respectively.

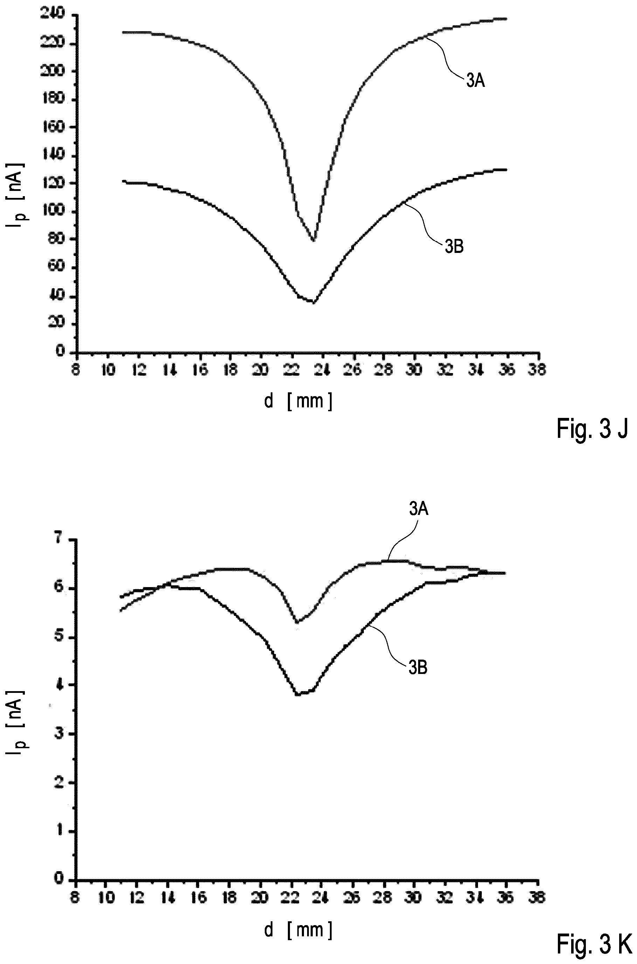

Further, Figure 3J shows the comparison of the variation of the alternating current (ac) photocurrent $I_p$ in nA with a distance $d$ of the sensor region 130 to the object in mm for both examples of Figures 3A and 3B at the maximum value of the FIP signal which was achieved by operating the LED 140 at wavelength of 850 nm and a modulation frequency of 3777 Hz.

Further, for obtaining the experimental results as presented in Figures 3K to 3M the LED 140 was operated at a wavelength of 1550 nm, a modulation frequency of 375 Hz, and an unknown illumination power. A 50 mm objective was employed at a distance of 20.5 cm to the LED 140. Again, then defocused state 186 was obtained by moving the LED 140 about 12.5 mm with regard to the focused state 184.

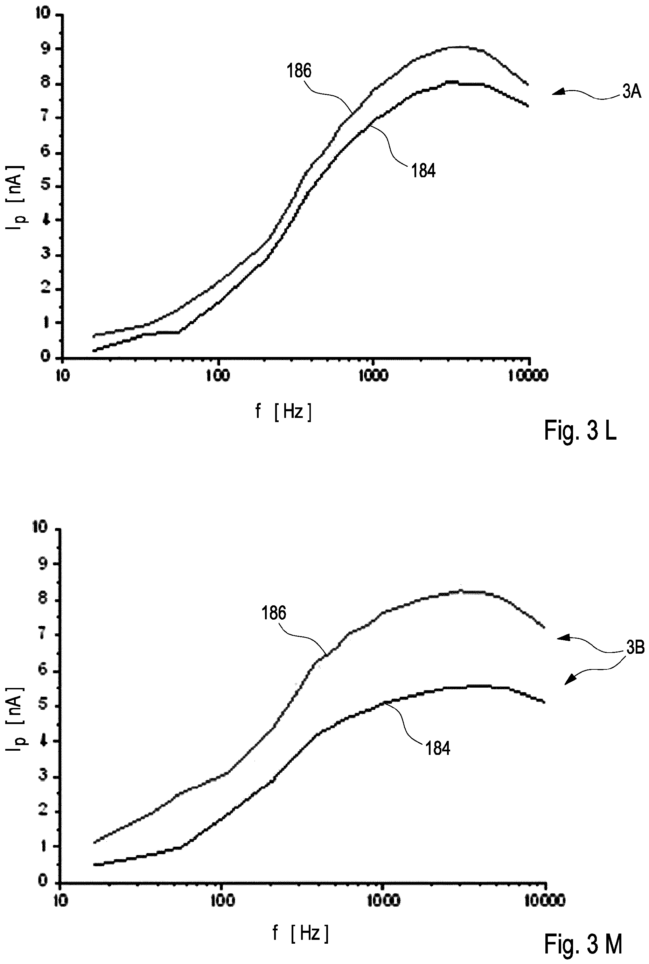

In particular, Figure 3K illustrates a comparison of the variation of the alternating current (ac) photocurrent $I_p$ in nA with a distance $d$ of the sensor region 130 to the object in mm for both examples of Figures 3A and 3B. Further, Figures 3L and 3M each display a comparison of the variation of the ac photocurrent $I_p$ in nA with the modulation frequency of the incident modulated light beam 132 in Hz for both the focused state 184 and the defocused state 186 for the example of Figure 3A (Figure 3L) and for the example of Figure 3B (Figure 3M), respectively.

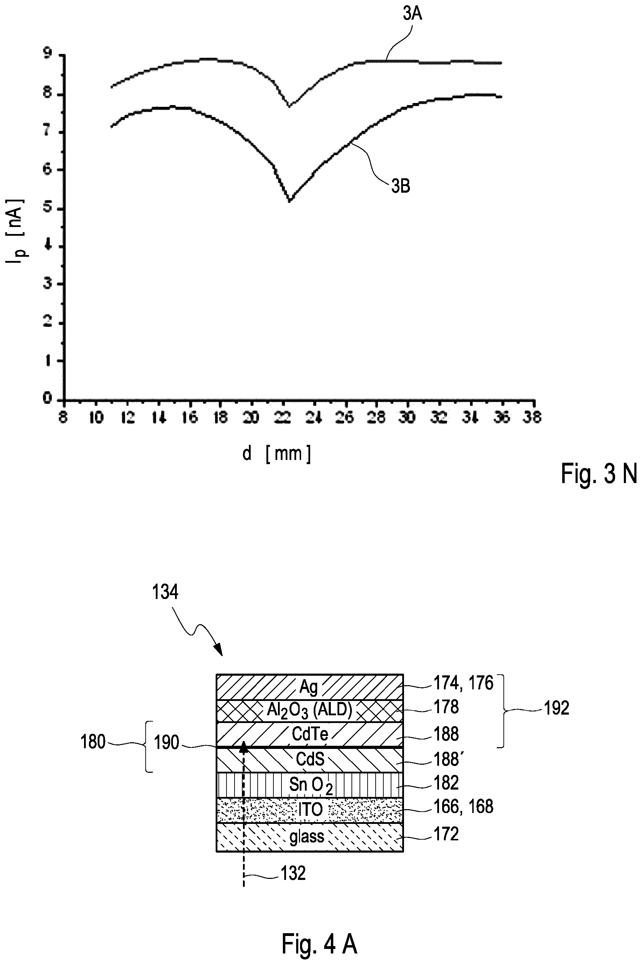

Further, Figure 3N shows the comparison of the variation of the alternating current (ac) photocurrent $I_p$ in nA with a distance $d$ of the sensor region 130 to the object in mm for both examples of Figures 3A and 3B at the maximum value of the FIP signal which was achieved by operating the LED 140 at wavelength of 1550 nm and a modulation frequency of 3777 Hz.

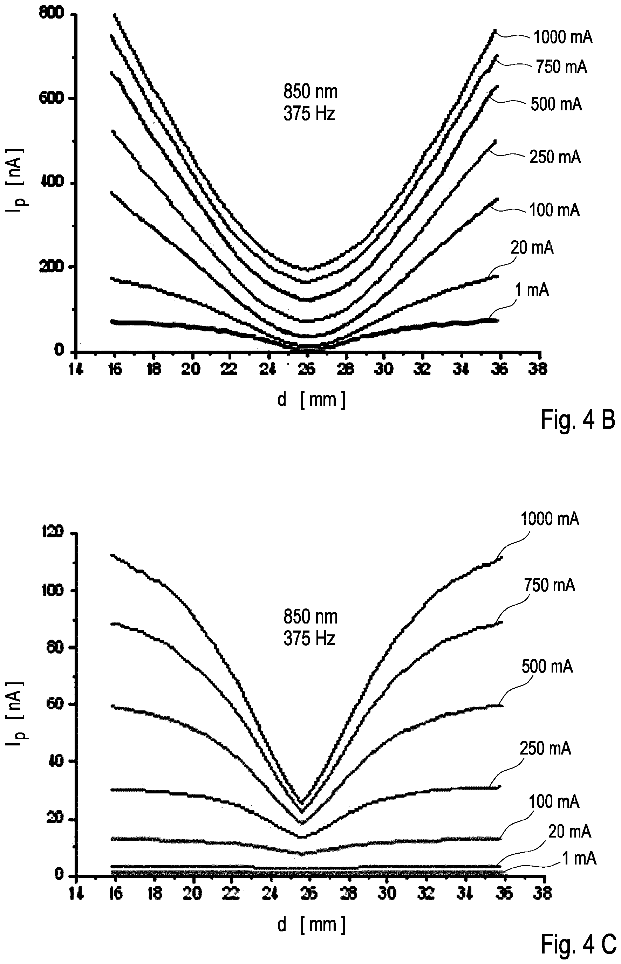

Figure 4A illustrates a cross section of a second preferred exemplary embodiment of the capacitive device 134, in particular for use in the longitudinal optical sensor 114, in a schematic fashion while Figures 4B to 4G provide experimental results obtained for the capacitive device 134 exhibiting an arrangement according to this embodiment.

The second exemplary embodiment of the capacitive device 134 according to Figure 4A again comprises the glass substrate 172 which is coated by the layer of the transparent conductive oxide (TCO) 168 comprising indium-doped tin oxide (ITO). As mentioned above, a layer of fluorine-doped tin oxide (FTO), aluminum-doped zinc oxide (AZO), or of another TCO may alternatively be used as the transparent conductive oxide 168 coating the glass substrate 172 or, as an alternative, a quartz substrate or an optically transparent and electrically insulating polymer, such as polyethylene terephthalate (**PET**).

In contrast to the exemplary embodiment of Figures 3A and 3B, the photosensitive layer 180 in the second exemplary embodiment of Figure 4A exhibits a different arrangement having a more complex structure. Herein, the photosensitive layer 180 comprises two individual photoconductive layers 188, 188', wherein a boundary between the two individual photoconductive layers 188, 188' forms a junction 190 which is adapted to generate the charge carriers upon illumination by the incident light beam 132. As shown in Figure 4A, the two individual photoconductive layers 188, 188' comprise cadmium sulfide (CdS) and cadmium telluride (CdTe) which have been provided by a deposition at approximately 300 °C. However, other kinds of suitable photoconductive materials may also be used for the purposes of the present invention.

In order to facilitate the transport of the charge carriers generated in the photosensitive layer 180 from their place of generation within the junction 190 provided by the two individual photoconductive layers 188, 188' to the adjacent electrode, which here exemplarily comprises the transparent conductive oxide (TCO) 168 indium-doped tin oxide (ITO), the capacitive device 134 in the embodiment of Figure 4A further comprises a charge-carrier transporting layer 182 which is particularly configured for this purpose. Since it may be advantageous that the charge-carrier transporting layer 182 in the embodiment as depicted in Figure 4A may at least be partially transparent to the incident light beam 132 in order to allow the incident light beam 132 to impinge the junction 190, the charge-carrier transporting layer 182 may, thus, comprise a transparent material, preferably a transparent oxide, in particular tin dioxide ($SnO_2$). During preparation, the $SnO_2$ deposited onto the ITO layer has been activated by a treatment with cadmium chloride ($CdCl_2$) at approximately 400 °C for about 45 min. However other kinds of materials which exhibit suitable charge-carrier transporting and optical properties as well as other production methods for generating this layer may also be feasible.

Further, the capacitive device 134 in the second exemplary embodiment also comprises a thin insulating aluminum oxide ($Al_2O_3$) layer having a thickness of approximately 80 nm as the insulating layer 178, wherein the $Al_2O_3$ layer has been provided in this example by applying low temperature atomic layer deposition (ALD) at a temperature of around 60 °C directly onto the CdS layer.

Further, the capacitive device 134 in this embodiment comprises the metal electrode 176 as the second electrode 174. Herein, a thin layer of approximately 200 nm silver (Ag) was deposited on the thin insulating aluminum oxide ($Al_2O_3$) layer photosensitive layer 180. As mentioned above, platinum (Pt), gold (Au), or aluminum (Al) could also be used here as alternative electrode materials in the second electrode 174.

As a result, the capacitive device 134 of this embodiment constitutes a metal-insulator-semiconductor (MIS) device 192 which comprises the Ag electrode 176, the thin insulating $Al_2O_3$ (ALD) layer 178 and the CdTe photosensitive layer 180. As shown in Figures 4B to 4G, a strong non-linear behavior of the ac photocurrent $I_p$ with a variation of the size of the impinging light spot can be observed, thus providing clear evidence of an occurrence of the FIP effect in the capacitive device 134 according to this second exemplary embodiment.

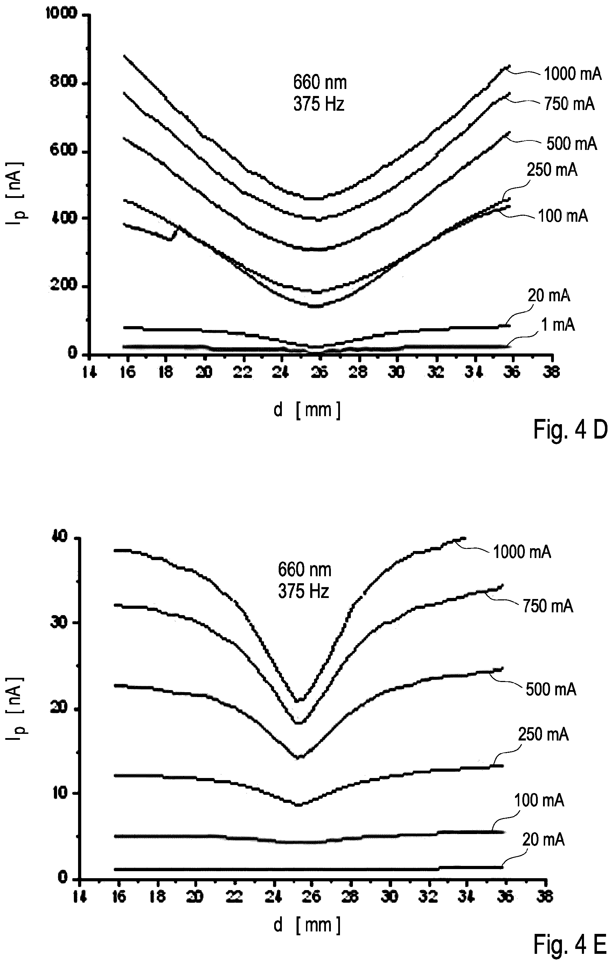

Figures 4B to 4E each illustrate the photocurrent $I_p$ in nA of the detector 110 comprising the capacitive device 134 of this second embodiment as a function of distance $d$ of the sensor region 130 to the object 112 in mm, wherein each curve represents the variation of the photocurrent $I_p$ for a preset current as indicated in the corresponding Figure, wherein each preset current is used to operate the LED 140 being provided in order to illuminate the photosensitive layer 180 of the corresponding the capacitive device 134. The modulation frequency for the incident modulated light beam 132 was chosen as 375 Hz in all of Figures 4B to 4E. While a wavelength of 660 nm was provided by the LED 140 to record the curves as displayed in Figures 4B and 4C, the LED 140 provided a wavelength of 850 nm in order to acquire the curves as shown in Figures 4D and 4E. Whereas the curves as displayed in Figures 4B and 4D are recorded by using a bare LED 140, a diffuser disk was employed for recording the curves as shown in Figures 4C and 4E, respectively. Herein, the diffuser disk is adapted to allow having a larger light spot in the sensor region 130 at lower illumination power, thus, resulting in a less concentrated illumination when imaged onto the sensor region 130.

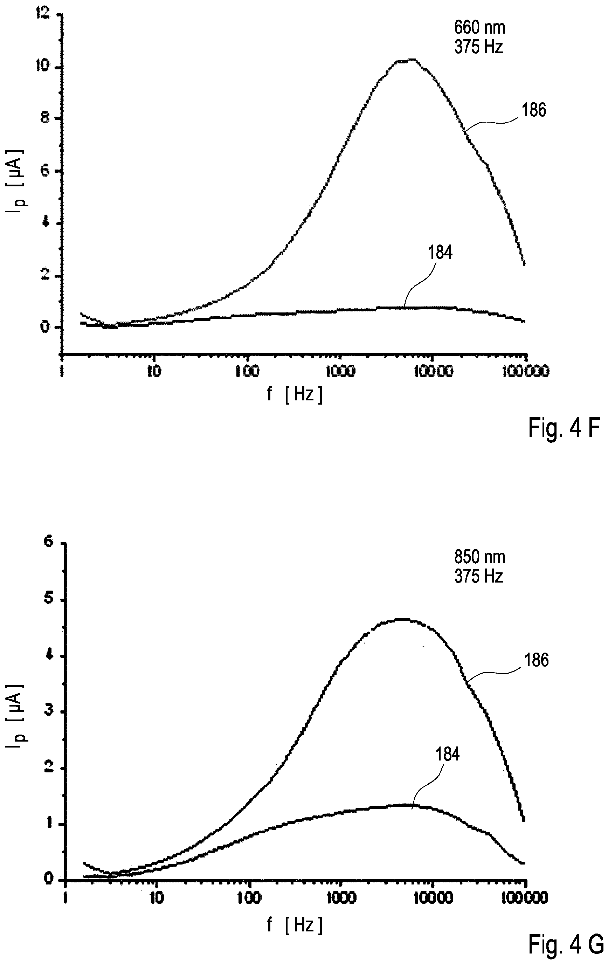

Further, Figures 4F and 4G each display a comparison of the variation of the ac photocurrent $I_p$ in μA with the modulation frequency of the incident modulated light beam 132 in Hz between the focused state 184 and the defocused state 186. Herein, the defocused state 186 was obtained by moving the LED 140, which was located about 82 cm away from a 50 mm objective in the focused state 184, about 12 mm from the focus. Herein, the curves in Figure 4F are recorded at the wavelength of 660 nm while the curves in Figure 4G are recorded at the wavelength of 850 nm.

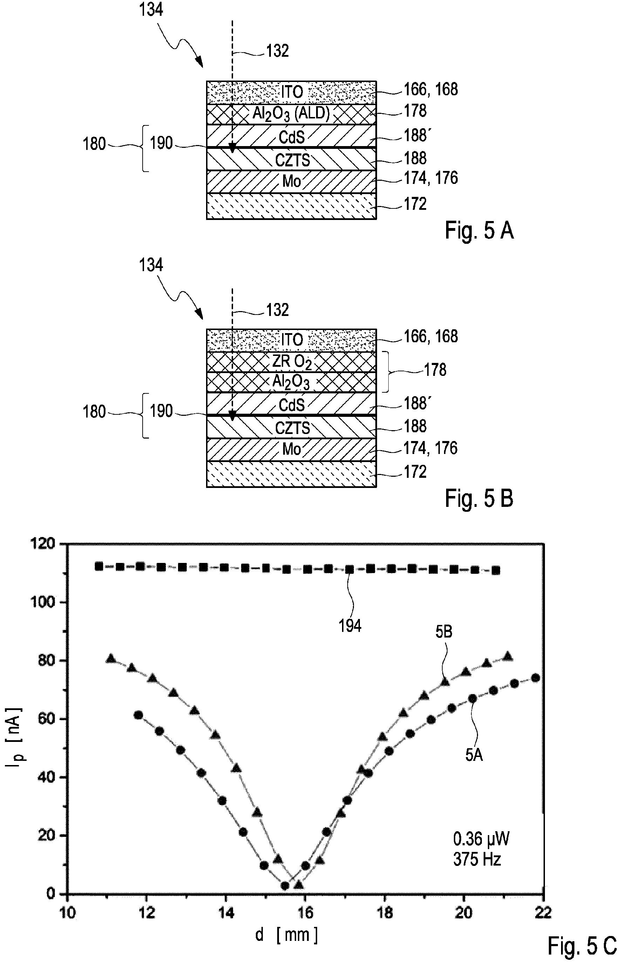

Figures 5A and 5B each illustrate a cross section of a preferred example of a third exemplary embodiment of the capacitive device 134, in particular for use in the longitudinal optical sensor 114, in a schematic fashion while Figures 5C to 5I provide experimental results obtained for the capacitive device 134 exhibiting an arrangement according to this embodiment in comparison to a solar cell arrangement using similar materials having, however, a divergent setup.

In both examples of this particular embodiment, the metal electrode 176 is provided as intransparent molybdenum (Mo) electrode which may be deposited on a substrate 170, wherein the substrate can exhibit intransparent optical properties, too. However, it may also be feasible to employ a transparent substrate, such as a glass substrate as described elsewhere in this document.

Similar to the second exemplary embodiment of the capacitive device 134 as depicted in Figure 4A, the third exemplary embodiment of Figures 5A and 5B comprises the junction 190 which is formed by the boundary between the two individual photoconductive layers 188, 188' comprising here a layer of cadmium sulfide (CdS) and a layer of copper zinc tin sulfide (CZTS), respectively. Thus, the CZTS layer can be considered as replacing the CdTe of the embodiment according to Figure 4A. As an alternative to CZTS, copper zinc tin selenide (CZTSe), the corresponding sulfur-selenium alloy CZTSSe, or a further quaternary chalcogenide photoconductive $I_2$-II-IV-$VI_4$ compound can also be applied for this purpose. Further alternatives may include copper indium gallium selenide (CIGS) or other chalcogenide photoconductors which are known as thin-film solar cell absorber layers.

Similar to the second exemplary embodiment of the capacitive device 134 according to Figure 4A, a thin $Al_2O_3$ layer, which may, preferably, have a thickness of approximately 70 mm, can, as schematically depicted in Figure 5A, again be used as the insulator layer 178. Figure 5B shows an alternative for the insulator layer 178, in which a double layer comprising an individual $ZrO_2$ layer and an individual $Al_2O_3$ layer provided on top of each other were applied. Herein, each of both individual layers exhibited a thickness of approximately 70 mm. In addition, both individual layers exhibit a high transparency, thus, allowing the incident light beam 132 to reach the junction 190 within the photosensitive layer 180. However, other kinds of combinations of individual layers used as the insulator layer 178 and thicknesses thereof may also be feasible.

The capacitive devices 134 according to Figures 5A and 5B may be finalized by a deposition of ITO as the first electrode 166 which, in contrast to the embodiments of Figures 2A, 2B, 3A, 3B, 4A, 6A, 7A, 7B, 10A, 10B or 10C is designed as a top contact electrode in this particular embodiment. However, the first electrode 166 in third exemplary embodiment of the capacitive device 134 according to Figures 5A and 5B can also be provided as a bottom contact electrode while the first electrode 166 in the other embodiments may also be designated as a top contact electrode provided that this arrangement may still capable of allowing the incident light beam 132 to reach the photosensitive layer 180.

As can be derived from Figures 5C to 5I, the detector 110 comprising the capacitive device 134 of the third embodiment according to both examples of Figures 5A and 5B, exhibits a strong non-linear behavior of the ac photocurrent $I_p$ with a variation of a size of the impinging light spot, hence producing the FiP effect. As particularly shown in Figures 5C to 5G, the FiP effect is significant even at low light intensities of the incident light beam 132. In contrast hereto, a CZTS-based solar cell 194 being provided in form of a photodiode for optimized photovoltaic performance was proved to show a negative FiP effect, predominantly at rather large light intensities. Herein, a particular difference between the capacitive device 134 of the third embodiment and the solar cell 194 as a solar cell reference device consists in that the capacitive device 134 comprises the insulating layer 178 while the insulating layer 178 is absent in the solar cell 194. In addition, the FiP effect in the solar cell 194 may only be observable in a narrow range around the focus of the detector 110. The data in Figures 5C to 5I was obtained with red light of a wavelength of 660 nm provided by the bare LED 140 focused with a 50 mm objective.

Figure 5C illustrates that an appreciable FiP effect could be observed in the capacitive device 134 of the third embodiment, even at a low intensity of the incident light beam 132 of 0,36 $\mu$W, while, in contrast hereto, the CZTS-based solar cell 194 did not exhibit an appreciable FiP effect at the same intensity. Herein, the current level applied to the LED 140 was comparable for both the capacitive device 134 and the reference solar cell 194.

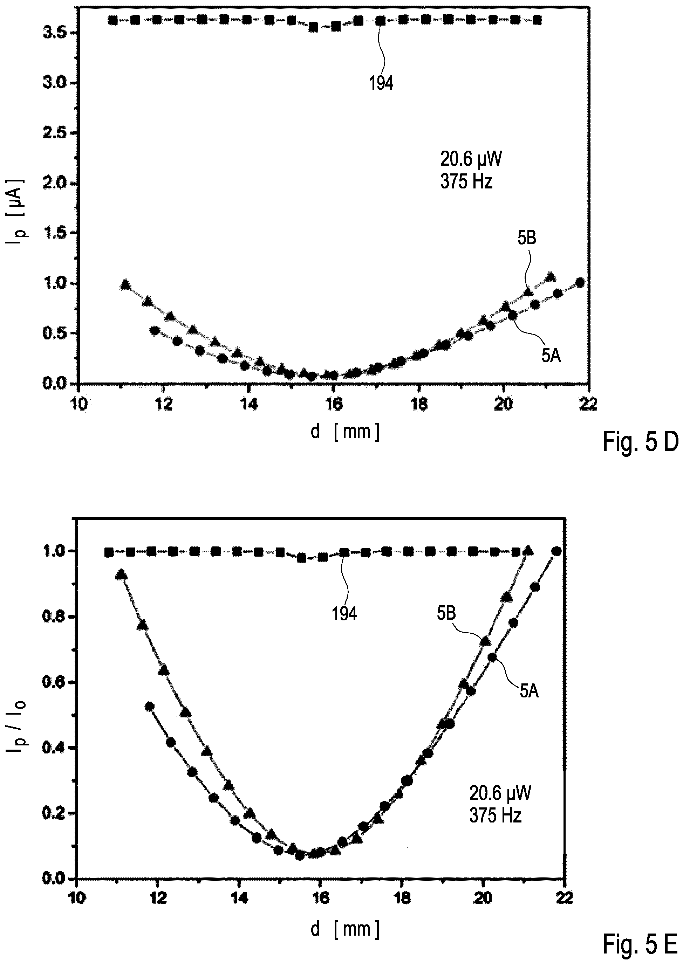

Figures 5D and 5E show that, with increasing intensity of the incident light beam 132 to 20.6 $\mu$W, the FiP response becomes broader and hence the discrepancy between the current levels of the capacitive device 134 and the CZTS-based solar cell 194 used as a reference widens. Herein, the photocurrent $I_p$ response at 375 Hz is provided as absolute numbers in Figure 5D and as normalized to the maximum value in Figure 5E, respectively.

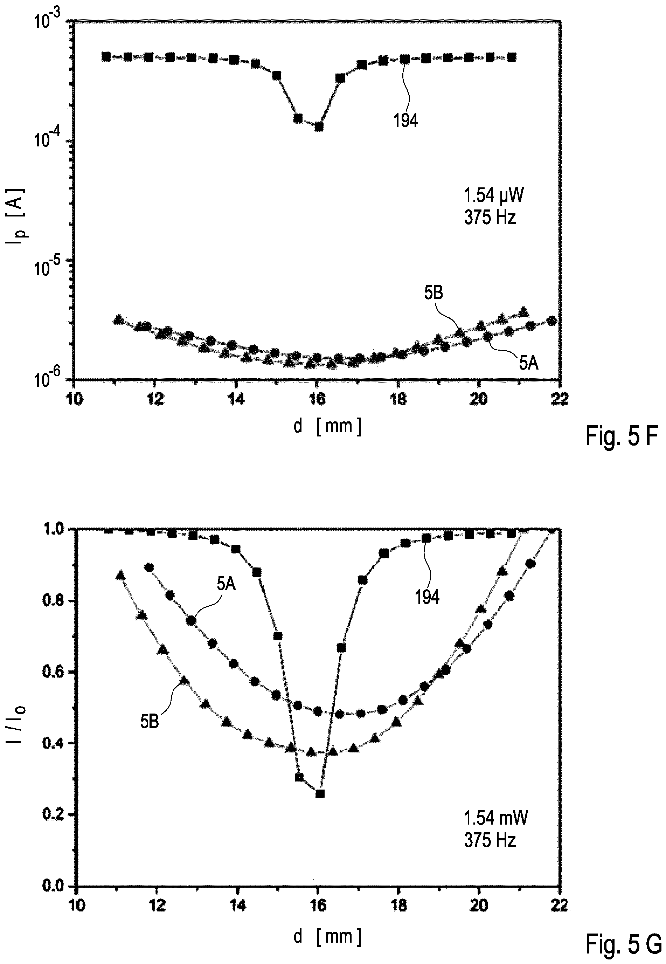

Figures 5F and 5G illustrate that the capacitive device 134 shows very low photo-current levels at high intensities of the incident light beam 132 at 1.54 mW, probably owing to an extremely broad negative FiP. At the same intensity level, the negative FiP effect in the CZTS-based solar cell 194 provides a significant response as well. The photocurrent $I_p$ response at 375 Hz is provided as absolute numbers in Figure 5F and as normalized to the maximum value in Figure 5G, respectively.

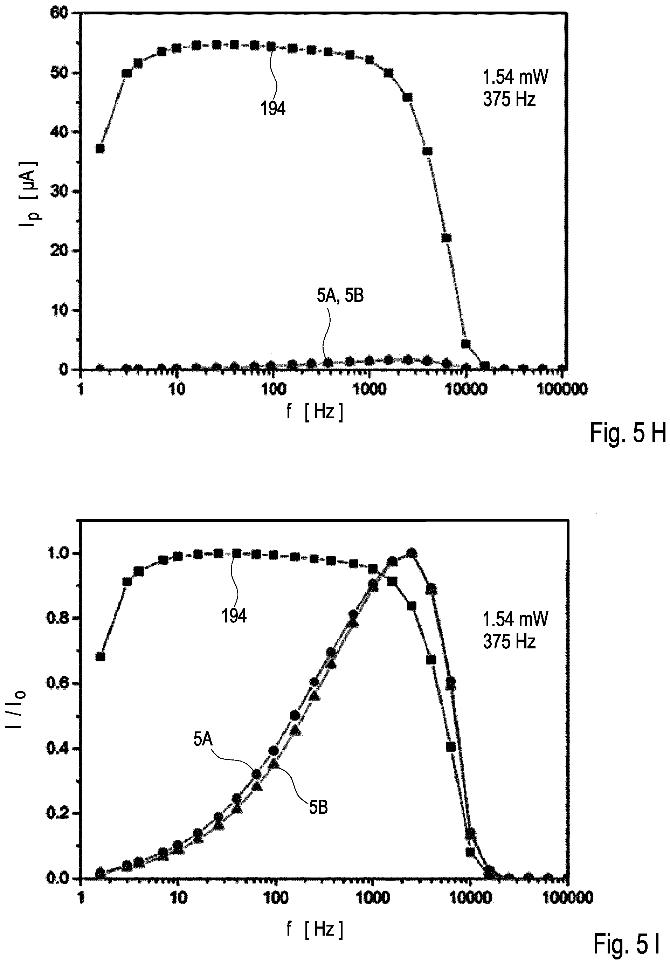

The spectral response of the modulated photocurrent $I_p$ at high intensities of the incident light beam 132 at 1.54 mW is provided as absolute values in Figure 5H as well as normalized to the maximum value in Figure 5I. While the CZTS-based solar cell 194 shows a broad and almost constant frequency response between ca. 10 Hz and ca. 10 kHz, the capacitive device 134 exhibits a pronounced peak above 1 kHz demonstrating its capacitive behavior.

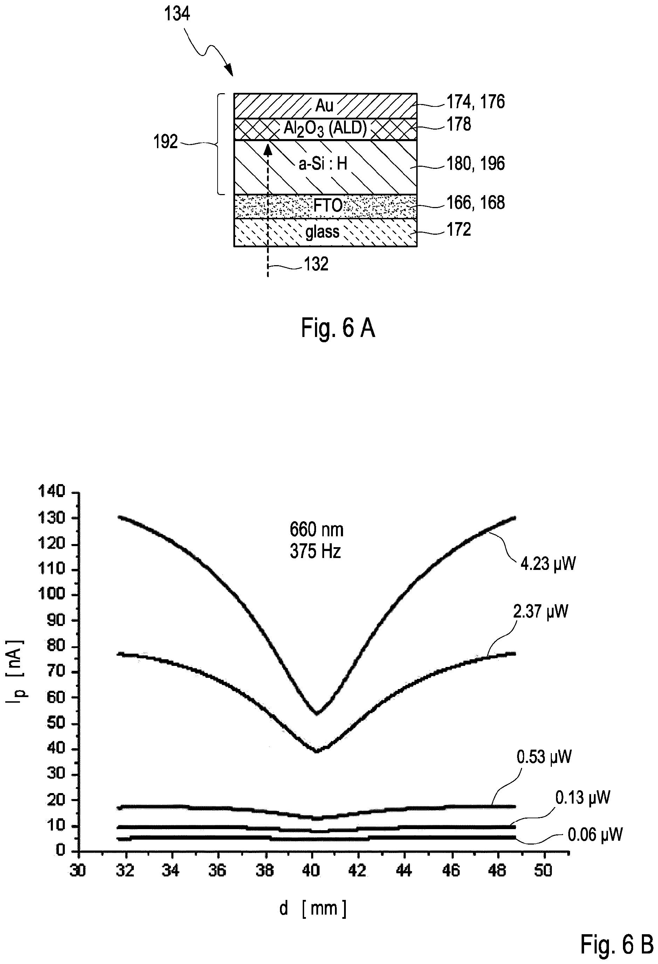

Figure 6A illustrates a cross section of a preferred example of a forth exemplary embodiment of the capacitive device 134, in particular for use in the longitudinal optical sensor 114, in a schematic fashion while Figures 6B to 6E provide experimental results obtained for the capacitive device 134 exhibiting this kind of arrangement.

According to Figure 6A this example of the forth exemplary embodiment of the capacitive device 134 exhibits an arrangement in which the FTO electrode 168 located on the glass substrate 172 acts as the first electrode 166 while the second electrode 174 comprises a gold (Au) electrode 176 which is deposited on the approximately 90 nm thick insulating layer 178 of $Al_2O_3$ obtained by low temperature atomic layer deposition (ALD) at the temperature of around 60°C.

In further contrast to the other embodiments as presented herein, the photosensitive layer 180 comprises here a semiconductor absorber layer 196, in particular, a hydrogenated amorphous silicon (a-Si:H) absorber layer having a thickness of approximately 500 nm. As a result, the capacitive device 134 of this embodiment, thus, again constitutes the metal-insulator-semiconductor (MIS) device 192 which comprises the Au electrode 176, the thin insulating $Al_2O_3$ (ALD) layer 178 and the photosensitive layer 180 of the amorphous Silicon (a-Si:H). As particularly shown in Figures 6B to 6E, this particular embodiment of the capacitive device 134, again, shows a strong non-linear behavior of the ac photocurrent $I_p$ with a variation of a size of the impinging light spot, hence providing evidence of the FIP effect. The data in Figures 6B to 6E were recorded by using a 50 mm objective, whereby a distance between the LED 140 to the objective was adjusted to 0.8 m.

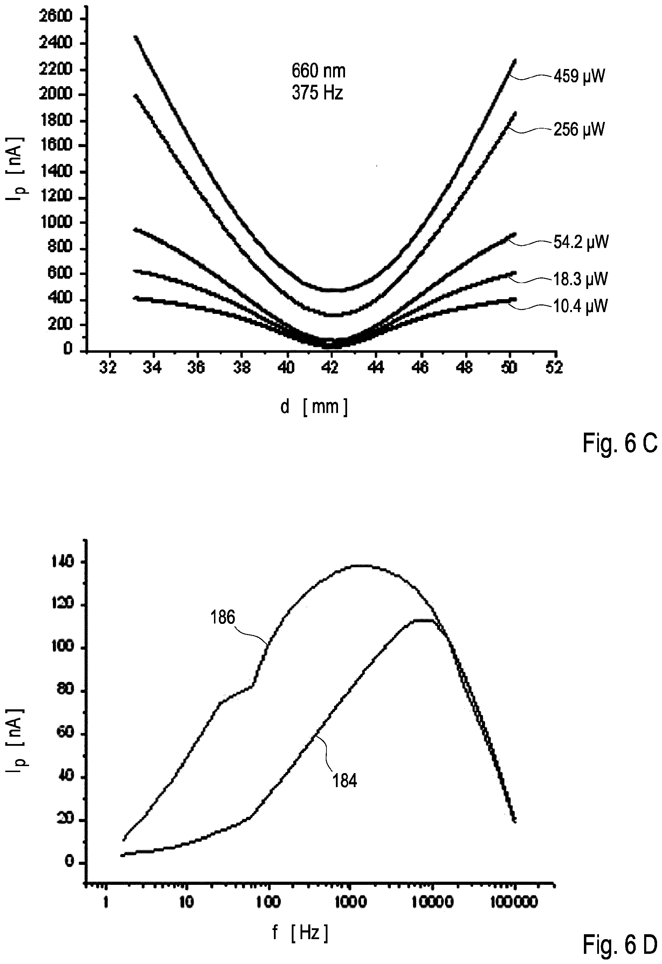

Figure 6B and 6C illustrate the occurrence of the FiP effect in a sample of the detector 110 comprising the forth embodiment of the capacitive device 134 by displaying a strong non-linear behavior of the ac photocurrent $I_p$ with a variation of a size of the impinging light spot. For the purpose of characterization, the LED 140 emitted at a wavelength of 660 nm at 375 Hz modulation frequency, the duty cycle hereby amounting to 50%. While Figure 6B shows the results with application of a diffuser disk having a diameter of 15 mm installed in front of the LED 140, Figure 6C displays the corresponding results obtained by using the bare LED 140 without applying the diffuser disk.

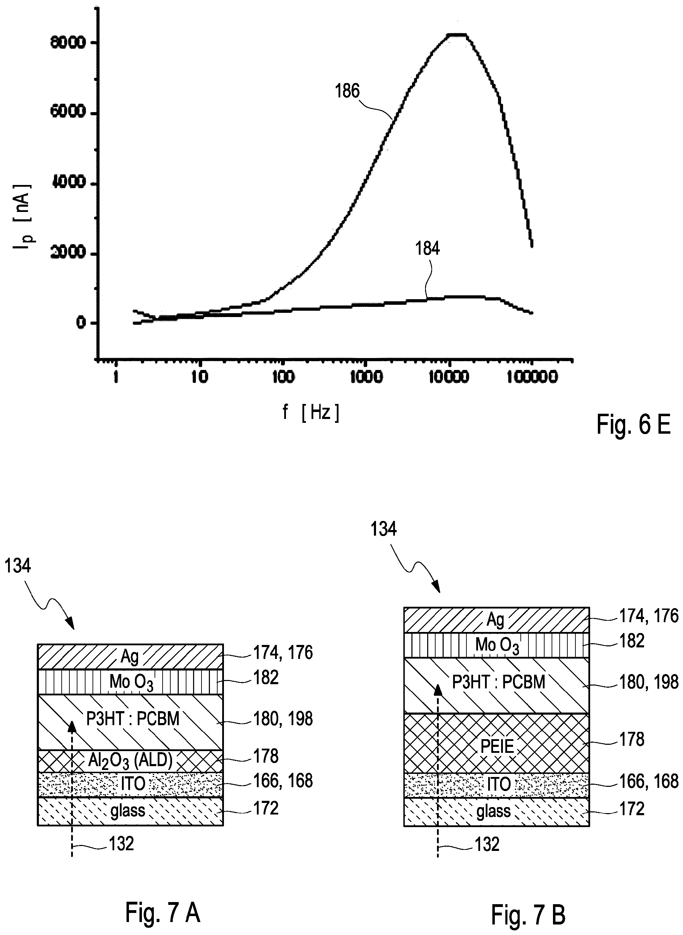

Figure 6D and 6E illustrate a difference in the photoresponse at the wavelength of 660 nm as a function of the modulation frequency of the incident modulated light beam 132 between the focused state 184 obtained by using the above-mentioned 50 mm objective and the defocused state 186, wherein the light spot, however, still assumed more than 50 % of the sensor region 130. While in Figure 6D the diffuser disk having the diameter of 15 mm was used and the illumination power, thus, amounted to 4.23 $\mu$W, in Figure 6E no diffuser disk was applied, resulting in the illumination power of approximately 459 $\mu$W.

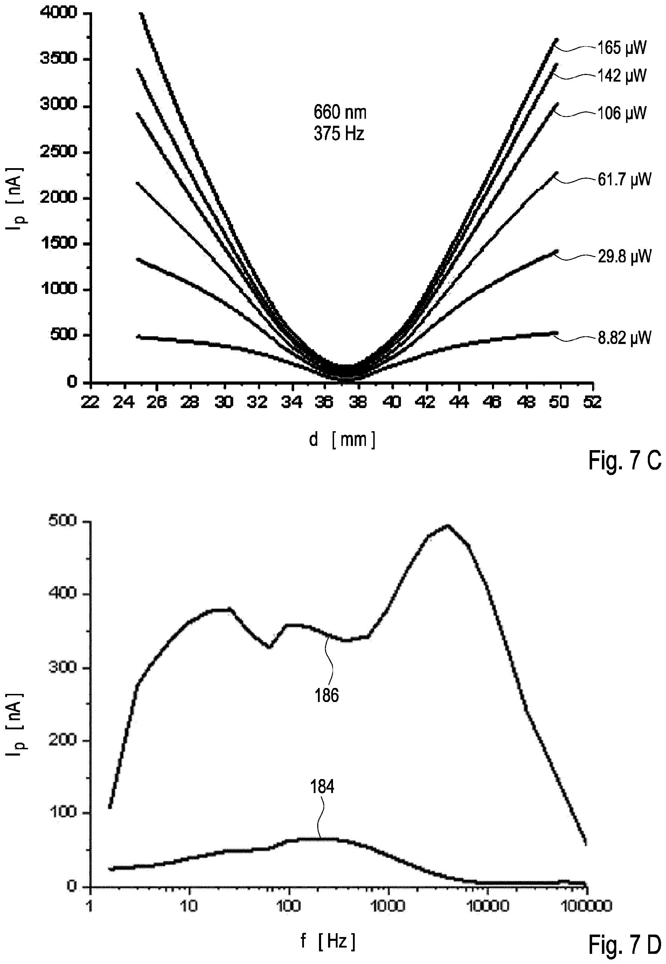

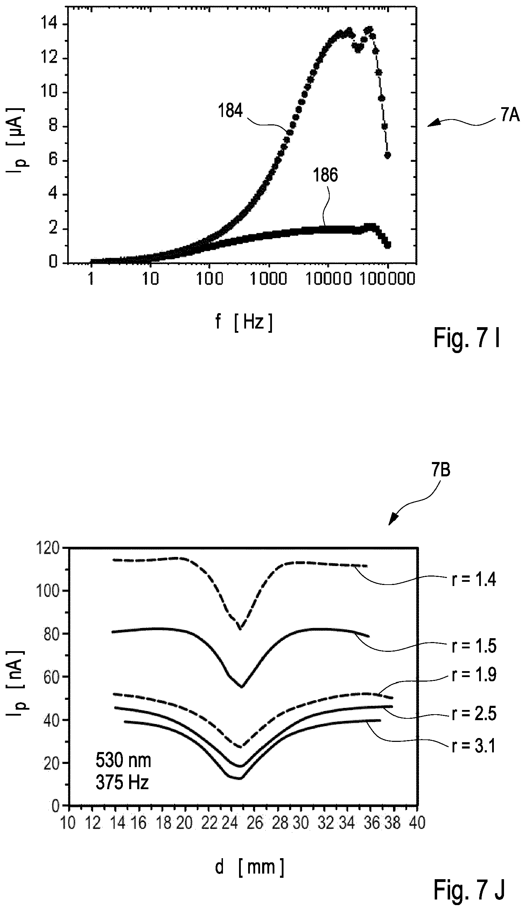

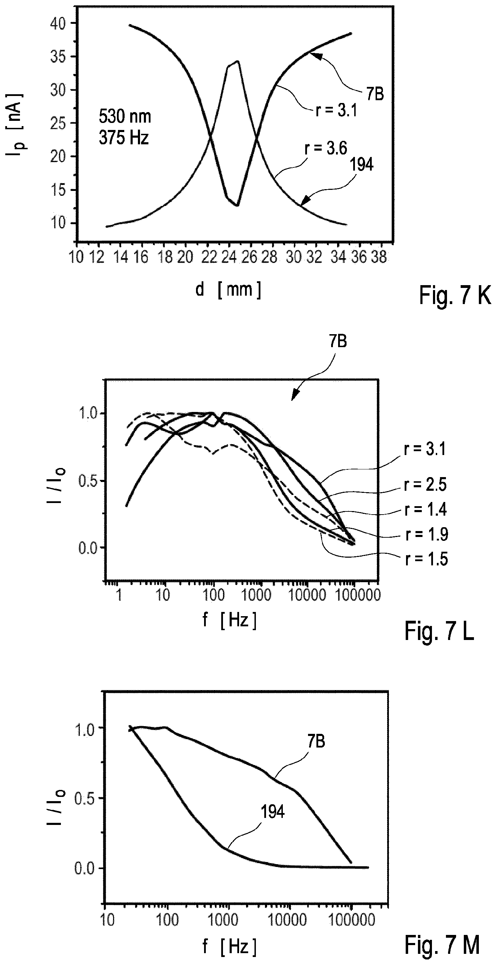

Figures 7A and 7B each illustrate a cross section of a preferred example of a fifth exemplary embodiment of the capacitive device 134, in particular for use in the longitudinal optical sensor 114, in a schematic fashion while Figures 7C to 7I provide experimental results obtained for the capacitive device 134 exhibiting an arrangement according to this embodiment.

Herein, the example of the capacitive device 134 as depicted in Figure 7A is similar to the example of the capacitive device 134 as shown in Figure 3B. Accordingly, the ITO electrode 168 located on the glass substrate 172 acts as the first electrode 166, on which a thin insulating layer 178 of $Al_2O_3$ obtained by atomic layer deposition (ALD) at the temperature of around 200°C is deposited, such as by applying 300 deposition cycles. Further, the second electrode 174 comprises an approximately 200 nm thick silver (Ag) electrode 176 which is deposited on the charge-carrier transporting layer 182, in particular on the above-described hole transporting layer of molybdenum oxide ($MoO_3$) exhibiting a thickness of approximately 15 nm $MoO_3$. For possible material alternatives reference may be made to the description of Figure 3B.

However, in contrast to the example of Figure 3B, the photosensitive layer 180 according to fifth exemplary embodiment of the capacitive device 134 has an organic photosensitive layer 198. Herein, the organic photosensitive layer 198, preferably, comprises at least one electron donor material and at least one electron acceptor material, especially, arranged within a single layer as an interpenetrating network of donor and acceptor domains, interfacial areas between the donor and acceptor domains, and percolation pathways connecting the domains to the electrodes, thereby generating a bulk heterojunction within the photosensitive layer 180.

In this particular embodiment, the electron donor material comprises an organic donor polymer and the electron acceptor material comprises a fullerene-based electron acceptor material. In both Figures 7A and 7B, the organic donor polymer used is poly(3-hexylthiophene-2,5-diyl) (**P3HT**) while the fullerene-based electron acceptor material [6,6]-phenyl-C61-butyric acid methyl ester (**PCBM**). However, as mentioned above in more detail, other kinds of electron donor materials and/or electron acceptor materials may also be feasible for the organic photosensitive layer 198 to be used in the capacitive device 134 according to the present invention. In particular, 50 mg/ml P3HT and 32 mg/ml PCBM were dissolved in chlorobenzene and cast by applying a spin rotation frequency of approximately 3000 rpm, whereby a solution-processed polymer: fullerene film was obtained on top of the insulating $Al_2O_3$ (ALD) layer 178.

As an alternative, Figure 7B illustrates a further example of the fifth exemplary embodiment of the capacitive device 134 in which, instead of using the insulating $Al_2O_3$ (ALD) layer 178, a thick layer comprising a film of polyethylenimine ethoxylate (**PEIE**) having a thickness of approximately 500 nm, was applied. As further alternatives, the insulating layer 178 may be selected from a film comprising at least one transparent organic dielectric material, in particular, selected from polyethylenimine (**PEI**), 2,9-dimethyl-4,7-diphenylphenanthroline (**BCP**), poly-(vinylalcohol) (**PVA**), poly(methylmethacrylate) (**PMMA**), tris-(8-hydroxyquinoline)aluminum (**Alq3**), or (3-(4-bi-phenylyl)-4-phenyl-5-(4-tert-butylphenyl)-1,2,4-triazole) (**TAZ**).

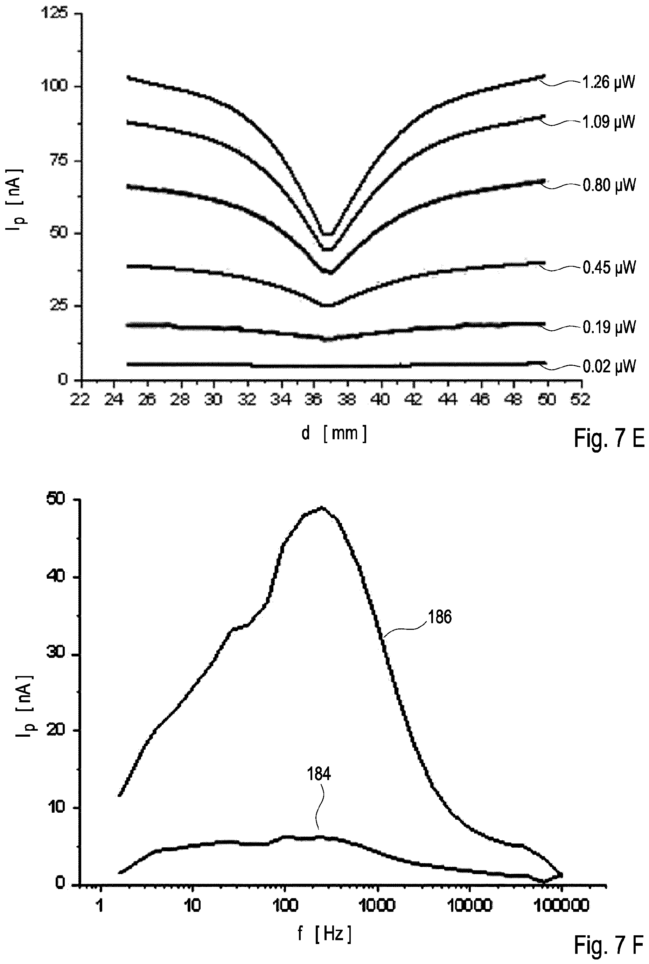

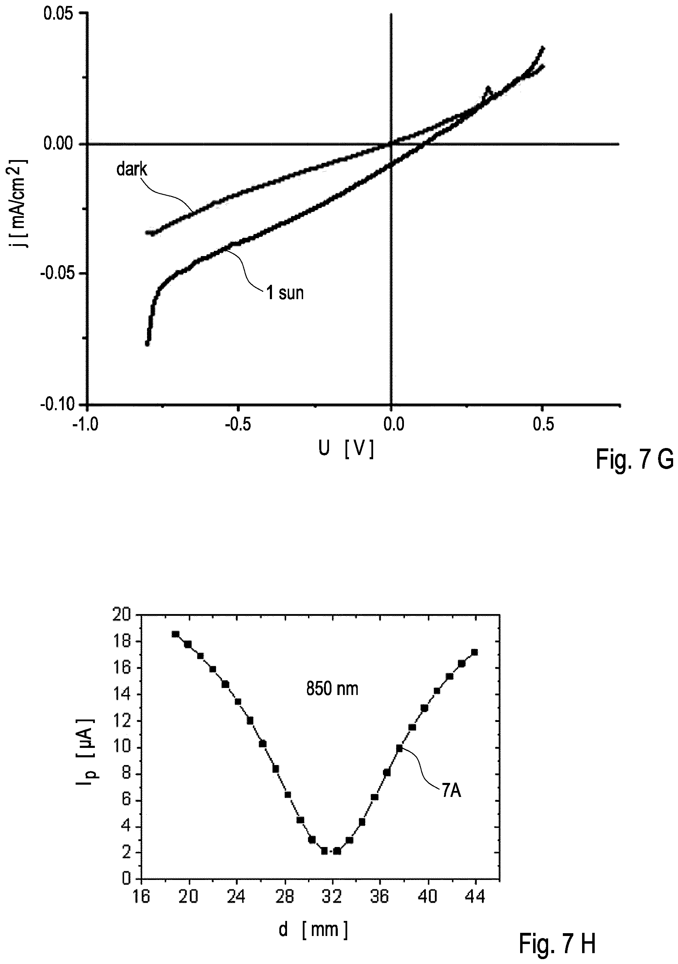

Figures 7C and 7E illustrate the occurrence of the FiP effect in a sample of the detector 110 comprising the embodiment of the capacitive device 134 as displayed in Figure 7A by displaying a strong non-linear behavior of the ac photocurrent $I_p$ with a variation of a size of the impinging light spot. Herein, each curve represents the variation of the photocurrent $I_p$ for a preset current as indicated in the corresponding Figure, wherein each preset current is used to operate the LED 140. As a result, a negative FiP response is always obtained, even at low light intensities. Further, Figures 7D and 7F display the ac photocurrent $I_p$ with the variation of the modulation frequency of the incident modulated light beam 132 in the focused state 184 and in the defocused state 186, the latter obtained by moving the LED 140 about 12.5 mm off focus. Further, Figure 7G shows the I-V characteristic of the capacitive device 134 illustrating the current density jwhich reveals that only a leakage current may be observed since the dc current is suppressed by at least two orders of magnitude compared to a known photodiode configuration.

For the purpose of characterization, the LED 140 used here emitted at a wavelength of 530 nm at 375 Hz modulation frequency. While Figures 7C and 7D show the results obtained by using the bare LED 140 without applying the diffuser disk, thus, providing the illumination power of 165 μW, Figures 7E and 7F display the corresponding results with application of a diffuser disk installed in front of the LED 140, thus, reducing the illumination power to 1.26 μW. Herein, the diffuser disk is adapted to allow having a larger light spot in the sensor region 130 at lower illumination power, thus, resulting in a less concentrated illumination when imaged onto the sensor region 130.

Further Figures 7H and 7I illustrate the photocurrent as a function of the distance of the sensor region 130 to the object and as a function of the modulation frequency of the incident modulated light beam132, respectively, for a further sample of the detector 110 comprising the embodiment of the capacitive device 134 as displayed in Figure 7A which was recorded at a wavelength of 850 nm for the incident light beam 132.

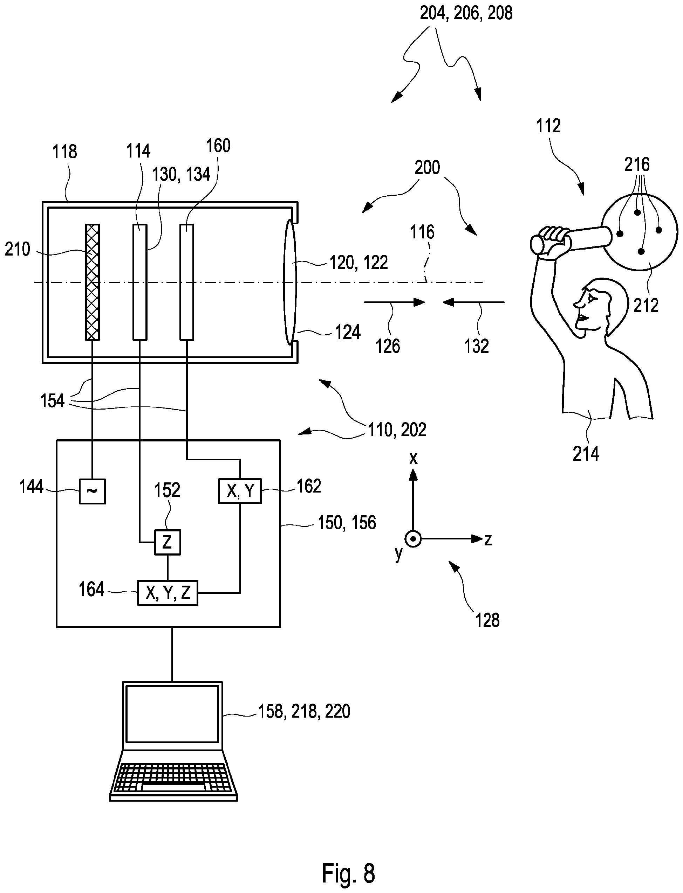

Figure 8 shows an exemplary embodiment of a detector system 200, comprising at least one optical detector 110, such as the optical detector 110 comprising the capacitive device 134 as disclosed in one or more of the embodiments shown in Figures 2A, 2B, 3A, 3B, 4A, 5A, 5B, 6A, 7A or 7B or a combination thereof. Herein, the optical detector 110 may be employed as a camera 202, specifically for 3D imaging, which may be made for acquiring images and/or image sequences, such as digital video clips. Further, Figure 8 shows an exemplary embodiment of a human-machine interface 204, which comprises the at least one detector 110 and/or the at least one detector system 200, and, further, an exemplary embodiment of an entertainment device 206 comprising the human-machine interface 204. Figure 8 further shows an embodiment of a tracking system 208 adapted for tracking a position of at least one object 112, which comprises the detector 110 and/or the detector system 200.

With regard to the optical detector 110 and to the detector system 200, reference may be made to the full disclosure of this application. Basically, all potential embodiments of the detector 110 may also be embodied in the embodiment shown in Figure 8. The evaluation device may be connected to each of the at least two longitudinal optical sensors, in particular, by the signal leads154. As described above, one or more longitudinal optical sensors 114 are used in order to provide the longitudinal sensor signals. The evaluation device 150 may further be connected to the at least one optional transversal optical sensor 160, in particular, by the signal leads 154. By way of example, the signal leads 154 may be provided and/or one or more interfaces, which may be wireless interfaces and/or wire-bound interfaces. Further, the signal leads 154 may comprise one or more drivers and/or one or more measurement devices for generating sensor signals and/or for modifying sensor signals. Further, again, the at least one transfer device 120 may be provided, in particular as the refractive lens 122 or convex mirror. The optical detector 110 may further comprise the at least one housing 118 which, as an example, may encase one or more of components.

Further, the evaluation device 150 may fully or partially be integrated into the optical sensors and/or into other components of the optical detector 110. The evaluation device 150 may also be enclosed into the housing 118 and/or into a separate housing. The evaluation device 150 may comprise one or more electronic devices and/or one or more software components, in order to evaluate the sensor signals, which are symbolically denoted by the longitudinal evaluation unit 152 (denoted by "z") and a transversal evaluation unit 162 (denoted by "x y"). By combining results derived by these evolution units, a position information 164, preferably a three-dimensional position information, may be generated (denoted by "x y z").

The at least one optional transversal optical sensor 160 may, preferably, be provided in a setup as illustrated below in the exemplary embodiment of Figure 9. However, other setups may also be feasible, such as by using a known PSD, in particular a photodetector as disclosed e.g. in WO 2012/110924 A1 or WO 2014/097181 A1 or a photoconductor as disclosed e.g. in WO 2016/120392 A1. However, other setups of the transversal optical sensor 160 may also be feasible.

Further, the optical detector 110 and/or to the detector system 200 may comprise an imaging device 210 which may be configured in various ways. Thus, as depicted in Figure 8, the imaging device can for example be part of the detector 110 within the detector housing 118. Herein, the imaging device signal may be transmitted by one or more signal leads 154 to the evaluation device 150 of the detector 110. Alternatively, the imaging device 210 may be separately located outside the detector housing 118. The imaging device 210 may be fully or partially transparent or intransparent. The imaging device 210 may be or may comprise an organic imaging device or an inorganic imaging device. Preferably, the imaging device 210 may comprise at least one matrix of pixels, wherein the matrix of pixels may particularly be selected from the group consisting of: an inorganic semiconductor sensor device such as a CCD chip and/or a CMOS chip; an organic semiconductor sensor device.

In the exemplary embodiment as shown in Figure 8, the object 112 to be detected, as an example, may be designed as an article of sports equipment and/or may form a control element 212, the position and/or orientation of which may be manipulated by a user 214. Thus, generally, in the embodiment shown in Figure 8 or in any other embodiment of the detector system 200, the human-machine interface 204, the entertainment device 206 or the tracking system 208, the object 112 itself may be part of the named devices and, specifically, may comprise the at least one control element 212, specifically, wherein the at least one control element 212 has one or more beacon devices 216, wherein a position and/or orientation of the control element 212 preferably may be manipulated by user 214. As an example, the object 112 may be or may comprise one or more of a bat, a racket, a club or any other article of sports equipment and/or fake sports equipment. Other types of objects 112 are possible. Further, the user 214 may be considered as the object 112, the position of which shall be detected. As an example, the user 214 may carry one or more of the beacon devices 216 attached directly or indirectly to his or her body.

The optical detector 110 may be adapted to determine at least one item on a longitudinal position of one or more of the beacon devices 216 and, optionally, at least one item of information regarding a transversal position thereof, and/or at least one other item of information regarding the longitudinal position of the object 112 and, optionally, at least one item of information regarding a transversal position of the object 112. Particularly, the optical detector 110 may be adapted for identifying colors and/or for imaging the object 112, such as different colors of the object 112, more particularly, the color of the beacon devices 216 which might comprise different colors. The opening in the housing, which, preferably, may be located concentrically with regard to the optical axis of the detector 110, may preferably define a direction of a view of the optical detector 110.

The optical detector 110 may be adapted for determining the position of the at least one object 112. Additionally, the optical detector 110, specifically an embodiment including the camera 202, may be adapted for acquiring at least one image of the object 112, preferably a 3D-image. As outlined above, the determination of a position of the object 112 and/or a part thereof by using the optical detector 110 and/or the detector system 200 may be used for providing a human-machine interface 204, in order to provide at least one item of information to a machine 218. In the embodiments schematically depicted in Figure 8, the machine 218 may be or may comprise at least one computer and/or a computer system comprising the data processing device 158. Other embodiments are feasible. The evaluation device 150 may be a computer 156 and/or may comprise a computer 156 and/or may fully or partially be embodied as a separate data processing device 158 and/or may fully or partially be integrated into the machine 218, particularly the computer. The same holds true for a track controller 220 of the tracking system 208, which may fully or partially form a part of the evaluation device 150 and/or the machine 218.

Similarly, as outlined above, the human-machine interface 204 may form part of the entertainment device 206. Thus, by means of the user 214 functioning as the object 112 and/or by means of the user 214 handling the object 112 and/or the control element 212 functioning as the object 112, the user 214 may input at least one item of information, such as at least one control command, into the machine 218, particularly the separate data processing device 158, thereby varying the entertainment function, such as controlling the course of a computer game.

Figure 9 illustrates a cross section of a preferred example of a sixth exemplary embodiment of the capacitive device 134, in particular for use in the transversal optical sensor 160, in a schematic fashion while Figures 9B and 9C provide experimental results obtained for the capacitive device 134 exhibiting an arrangement according to this embodiment.

Herein, the example of the capacitive device 134 as depicted in Figure 9A is similar to the example of the capacitive device 134 as shown in Figure 3A. Accordingly, the ITO electrode 168 located on the glass substrate 172 acts as the first electrode 166, on which a thin insulating layer 178 of $Al_2O_3$ obtained by atomic layer deposition (ALD) is deposited. Further, the capacitive device 134 comprises a layer of nanoparticulate lead sulfide (np-PbS) which acts as the photosensitive layer 180. For further details and possible material alternatives for the first electrode 166, the glass substrate 172, the insulating layer 178, and the photosensitive layer 180, reference may be made to the description of Figures 3A, 3B, 4A, 5A, 5B, 6A, 7A and 7B.

However, in contrast to the example of Figure 3B, instead of a high electrical conductivity metal layer 176 the sixth exemplary embodiment of the capacitive device 134 has an electrode layer 222 having a low electrical conductivity which is used here as the second electrode 174. In particular, the electrode layer 222 may exhibit a sheet resistance of 100 $\Omega$/sq to 20 000 $\Omega$/sq, preferably of 100 $\Omega$/sq to 10 000 $\Omega$/sq, more preferred 125 of $\Omega$/sq to 1000 $\Omega$/sq, specifically of 150 of $\Omega$/sq to 500 $\Omega$/sq, thus, allowing determining at which position the charge was actually generated within the photosensitive layer 180 and concluding the position at which the incident light beam impinged the sensor region 130. As a result of the sheet resistance being in the indicated range, the capacitive device 134, in which the second electrode 174 may further be equipped with the at least one split electrode 224, may act as the transversal detector 160. Consequently, the capacitive device 134 as depicted in Figure 9A shows an in-plane sensitivity with respect to the position of the impinging light beam 132 by using a similar approach as in a known position-sensitive device (PSD). This feature can be employed for this purpose by using modulated light which may be capable of inducing an ac current through the insulator layer 178.

Preferably, the electrode layer 222 of low electrical conductivity may comprise a layer of a transparent electrically conducting organic polymer which may be suitable for this purpose. In particular, poly(3,4-ethylenedioxy-thiophene) (**PEDOT**) or a dispersion of **PEDOT** and a polystyrene sulfonic acid (**PEDOT:PSS**) may be selected as the transparent electrically conducting polymer. On the other hand, since the first electrode 166 may already be at least partially transparent, a larger variety of different materials, including optically intransparent materials, may be employed for this purpose.

Figure 9B shows experimental results which demonstrate the applicability of the transversal optical sensor 160 a schematically illustrated in Figure 9A for this purpose. Herein, the transversal optical sensor 160 which comprises a layer of nanoparticulate lead sulfide (np-PbS) as the photosensitive layer 180, has been illuminated by an near-infrared (NIR) laser diode which is adapted to emit a wavelength of 850 nm with a power of 1 mW at an applied voltage of 5 V. Further, a modulation frequency of 375 Hz for NIR the laser diode has been used. Herein, a distance between the laser diode and the sensor region 130 was 20 cm.

Figure 9B schematically illustrates the sensor region 130 of the transversal optical sensor 160 in an x-direction and a y-direction. Herein, for a number of measurement point positions 226 as determined by application of the evaluation device 150 of the detector 110 according to the present invention have been compared with actual positions 228 which have been available by other kinds of methods, such as by employing geometrical considerations in using a known setup of the transversal optical sensor 160.

In order to determine a position 226 of a measurement point by application of the transversal optical sensor 160, the following procedure may be used. By way of example (not depicted here), a split electrode 224 may be applied. In particular, the split electrode 224 may comprise partial electrodes, in particular four partial electrodes which may, for example, be located on top of four rims of the second electrode 174, wherein the second electrode 174 may exhibit a square or a rectangular form, may be employed. However, other kinds of arrangements may also be feasible.

Herein, by generating charges in the photosensitive layer 180, ac electrode currents may be obtained, which, in each case, may be denoted by $i1$ to $i4$. As used herein, electrode currents $i1, i2$ may denote ac electrode currents through the partial electrodes being located in y-direction while electrode currents $i3, i4$ may denote ac electrode currents through the partial electrodes which are located in x-direction. The electrode currents may be measured by one or more appropriate electrode measurement devices in a simultaneous or a sequential fashion. By evaluating the electrode currents, the desired x- and y-coordinates of the position 226 of the measurement point under investigation, i.e. $x_0$ and $y_0$, may be determined. Thus, the following equations may be used:

$$x_0 = f\left(\frac{i_3 - i_4}{i_3 + i_4}\right) \quad \text{and} \quad y_0 = f\left(\frac{i_1 - i_2}{i_1 + i_2}\right).$$

Herein, $f$ might be an arbitrary known function, such as a simple multiplication of the quotient of the currents with a known stretch factor and/or an addition of an offset. Thus, generally, the electrode currents $i1$ to $i4$ might provide transversal sensor signals generated by the transversal optical sensor 114, whereas the evaluation device 140 might be adapted to generate information on a transversal position, such as at least one x-coordinate and/or at least one y-coordinate, by transforming the transversal sensor signals by using a predetermined or determinable transformation algorithm and/or a known relationship.

The results as shown in Figure 9B demonstrate that for the number of the measurement points as presented there, the positions 226 as determined by the application of the transversal optical sensor 160 according to the sixth embodiment of the present invention are reasonably comparable with the actual positions 228 as recorded by another kind of method.

As already mentioned above, the transversal optical sensor 160 according to the sixth embodiment of the present invention may concurrently be employed as a longitudinal optical sensor 114 which may, additionally, be adapted for determining a z-position. For this purpose, a sum of the electrode currents $i1, i2$ through the partial electrodes located in y-direction and of the electrode currents $i3, i4$ through the partial electrodes located in x-direction may be used in a preferred embodiment, wherein the electrode currents may be measured by one or more appropriate electrode measurement devices in a simultaneous or a sequential fashion, for determining the z-coordinate. By evaluating these electrode currents, the desired z-coordinate of the position 226 of the measurement point under investigation, i.e. $z_0$, may be determined by using the following Equation:

$$z_0 = f(i_1 + i_2 + i_3 + i_4)$$

For further details with respect to evaluating electrode currents in order to obtain the desired z-coordinate reference may be made to WO 2012/ 110924 A1 or WO 2014/097181 A1.

Figure 9C shows a segment of Figure 9B covering a center 230 of the sensor region 130. As a result, Figure 9C demonstrates that excellent correlation between the measurement point positions 226 and the actual positions 228 as otherwise determined could be observed, in particular within the center 230 of the sensor region 130. Deviations towards the edges 232 of the sensor region 130 which can be observed as shown in Figure 9B behave as expected for this type of device and may be remedied by a suitable correction algorithm.

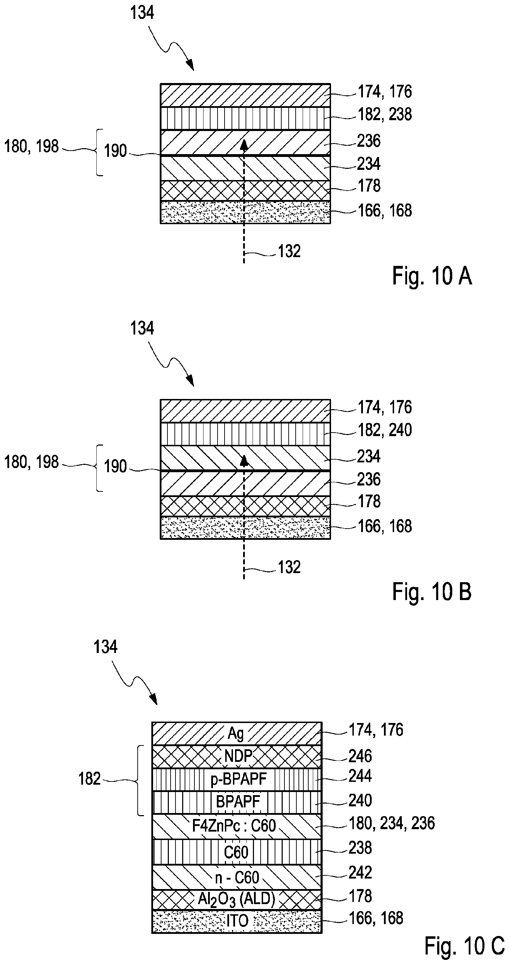

Figures 10A to 10C illustrate cross sections of preferred examples of a seventh exemplary embodiment of the capacitive device 134, wherein the photosensitive layer 180 of the capacitive device 134 is or comprises at least one organic photosensitive layer 198, wherein the donor material and the acceptor material in the organic photosensitive layer 198 is arranged in form of at least two individual layers each comprising one of the donor material and of the acceptor material.

As schematically depicted in Figures 10A and 10B, the capacitive device 134, again, comprises the layer of the transparent conductive oxide (TCO) 168 as the first electrode 166 and the metal electrode 174 as the second electrode 174, between which the insulating layer 178 and the photosensitive layer 180 are provided. For reasons of convenience, the insulating layer 178 can be deposited directly onto a substrate comprising a conductive coating and being suited as the first electrode 166. However, according to this particular example of the seventh exemplary embodiment, the organic photosensitive layer 198, in particular contrast to the embodiments of Figures 7A and 7B, has a donor material layer 234 and an acceptor material layer 236 which are arranged as two individual layers stacked on top of each other. In the particular embodiments of Figures 10A and 10B, the donor material layer 234 and the acceptor material layer 236 are separated by the junction 190, which here forms a heterojunction due to the different kinds of materials. Hence, two different kinds of layer stacks as illustrated in in Figures 10A and 10B are feasible which are adapted in order to provide the capacitive device 134 while maintaining an efficient extraction of one type of charge carriers.

A comparison between the examples of Figures 10A and 10B reveals that both examples differ by their respective arrangement of the donor material layer 234 and the acceptor material layer 236 with respect to the configuration of the electrode, in particular, with regard to the second electrode 174. While in the example of Figure 10A the acceptor material layer 236 is being placed adjacently to the second electrode 174, only separated by the charge-carrier extracting layer 182, in the example of Figure 10B the donor material layer 234 is being placed adjacently to the second electrode 174, again, only separated by the charge-carrier extracting layer 182. In order to be capable of extracting and transporting the corresponding charges as provided by the adjacent charge-carrier material, the charge-carrier extracting layer 182 in the example of Figure 10A is, thus, adapted as an electron extracting layer 238 while the charge-carrier extracting layer 182 in the example of Figure B is, consequently, adapted as a hole extracting layer 240.

Figures 10C illustrates a further example based on the embodiment as depicted in Figure 10B. Herein, the same kind of layers is used in the same type of arrangement as shown in Figure 10B, wherein, however, the donor material layer 234 and the acceptor material layer 236 are comprised in a single photosensitive layer 180, whereby, similar to the embodiments of Figures 7A and 7B, a bulk heterojunction is generated within this kind of photosensitive layer 180. In addition, further layers are introduced into the capacitive device 134 for increasing its function. In particular, a further n-doped acceptor layer 242 and a further electron extraction layer 238 are introduced between the insulating layer 178 and the acceptor material layer 236 while a p-doped extraction layer 244, wherein a dopant is provided by an additional p-dopant layer 246, is introduced between the hole extracting layer 240 and the second electrode 174. Introducing the further a further n-doped acceptor layer 242 or, depending on the particular arrangement of the capacitive device, alternatively an additional p-doped acceptor layer may be used for adjusting a distance from the ITO layer 168 to the reflecting second electrode 174, in particular, in order to improve a matching of a phase of the incident light beam 132 and of a light beam being reflected at the second electrode 174, thus, optimizing the performance of the capacitive layer 134 with regard to the power of the illumination within the organic photosensitive layer 198.

More particular, the mentioned layers in the exemplary capacitive device 134 of Figure 10C, may, in an order starting from the bottom to the top of the capacitive device 134 as depicted in Figure 10C, preferably, comprise the following materials, each forming a respective layer:

- a layer of indium-doped tin oxide (ITO) as the first electrode 166, such as described above;
- an $Al_2O_3$ layer, preferably provided by ALD, in particular processed at approx. 200 °C, having a preferred thickness of ca. 70 nm, as the insulating layer 178, such as described above;
- an n-C60 layer, i.e. an n-doped buckminsterfullerene layer, treated with an n-dopant, in particular with 10% NDN-26, processed at approx. 140 °C, preferably having a thickness of ca. 15 nm, as the n-doped acceptor layer 242;
- a C60 layer, i.e. an undoped buckminsterfullerene layer, processed at approx. 400 °C, preferably having a thickness of ca. 10 nm, as the electron extraction layer 238;
- a F4ZnPc:C60 layer, i.e. a layer comprising a 1:1 blend of a fluorinated zinc phthalocyanine derivative (**F4ZnPc**) and buckminsterfullerene, processed at approx. 335 °C and deposited on a substrate having a temperature of 110 °C, preferably exhibiting a thickness of ca. 70 nm as the single photosensitive layer 180 consolidating the donor material layer 234 and the acceptor material layer 236 in a single layer exhibiting a bulk heterojunction;
- a layer of undoped 9,9-bis[4-(N,N-bis-biphenyl-4-yl-amino)phenyl]-9H-fluorene (**BPAPF**), preferably having a thickness of ca. 10 nm, as the hole extraction layer 240;
- p-**BPAPF**, i.e. p-doped **BPAPF**, treated with a p-dopant, in particular NDP-9, processed at approx. 140°C, preferably having a thickness of ca. 30-40 nm, as p-doped extraction layer 244; and
- an NDP-9 layer, preferably having a thickness of ca. 1-2 nm, as the additional p-dopant layer 246; and
- a silver (Ag) layer as the second electrode 174, such as described above.

However, other kinds of materials suited for the respective layers in the capacitive device may also be feasible. Hereby, reference may, in particular, be made to the other embodiments as described herein.

Further, N,N'-diphenyl-N,N'-bis(4'-(N,N-bis(naphth-1-yl)-amino)-biphenyl-4-yl)-benzidine (**DiNPB**) may be used as an alternative for **BPAPF** in the hole extraction layer 240. Similarly, Bathophenantroline (**BPhen**) may be used as the electron extraction layer 238 in a comparable arrangement which may be based on the example of Figure 10A.

Further, the terms "NDN" and "NDP" refer to n-side or d-side dopants, respectively, which are provided by Novaled GmbH. Thus, NDN-26 and NDP-9 refer to specific n-side or d-side dopant. However other kinds of n-dopants or -p-dopants may also be feasible, respectively.

List of reference numbers

[0243]

| 110 | detector |
| 112 | object |
| 114 | longitudinal optical sensor |
| 116 | optical axis |
| 118 | housing |
| 120 | transfer device |
| 122 | refractive lens |

| | |
|---|---|
| 124 | opening |
| 126 | direction of view |
| 128 | coordinate system |
| 130 | sensor region |
| 132 | modulated light beam |
| 134 | capacitive device |
| 136 | illumination source |
| 138 | artificial illumination source |
| 140 | light-emitting diode |
| 142 | modulated illumination source |
| 144 | modulation device |
| 146 | first beam path |
| 148 | second beam path |
| 150 | evaluation device |
| 152 | longitudinal evaluation unit |
| 154 | signal leads |
| 156 | computer |
| 158 | data processing device |
| 160 | transversal optical sensor |
| 162 | transversal evaluation unit |
| 164 | position information |
| 166 | first electrode |
| 168 | transparent conductive oxide |
| 170 | optically transparent substrate |
| 172 | glass substrate |
| 174 | second electrode |
| 176 | metal electrode |
| 178 | insulating layer |
| 180 | photosensitive layer |
| 182 | charge-carrier transporting layer or charge-carrier extracting layer |
| 184 | focused state |
| 186 | defocused state |
| 188, 188' | individual photoconductive layer |
| 190 | junction |
| 192 | metal-insulator-semiconductor device |
| 194 | solar cell (reference device) |
| 196 | semiconductor absorber layer |
| 198 | organic photosensitive layer |
| 200 | detector system |
| 202 | camera |
| 204 | human-machine interface |
| 206 | entertainment device |
| 208 | tracking system |
| 210 | imaging device |
| 212 | control element |
| 214 | user |
| 216 | beacon device |
| 218 | machine |
| 220 | track controller |
| 222 | electrode layer |
| 224 | split electrode |
| 226 | measurement point position |
| 228 | actual position |
| 230 | center |
| 232 | edge |
| 234 | donor material layer |
| 236 | acceptor material layer |
| 238 | electron extraction layer |

| 240 | hole extraction layer |
| 242 | n-doped acceptor layer |
| 244 | p-doped hole extraction layer |
| 246 | p-dopant layer |

**Claims**

1. A detector (110) for optically detecting at least one object (112), comprising

   - at least one optical sensor, wherein the optical sensor has at least one sensor region (130), wherein the optical sensor is designed to generate at least one sensor signal in a manner dependent on an illumination of the sensor region (130) by an incident modulated light beam (132), wherein the sensor signal is dependent on a modulation frequency of the light beam (132), wherein the sensor region (130) comprises at least one capacitive device (134), the capacitive device (134) comprising at least two electrodes (166, 174), wherein at least one insulating layer (178) and at least one photosensitive layer (180) are embedded between the electrodes (166, 174), wherein at least one of the electrodes (166, 174) is at least partially optically transparent for the light beam (132); and
   - at least one evaluation device (150), wherein the evaluation device (150) is designed to generate at least one item of information on a position of the object (112) by evaluating the sensor signal.

2. The detector (110) according to the preceding claim, wherein the optical sensor is selected from

   - at least one longitudinal optical sensor (114), wherein the longitudinal optical sensor (114) is designed to generate at least one longitudinal sensor signal, wherein the longitudinal sensor signal, given the same total power of the illumination, is further dependent on a beam cross-section of the light beam (132) in the sensor region (130), wherein the evaluation device (150) is designed to generate at least one item of information on a longitudinal position of the object (112) by evaluating the longitudinal sensor signal; or
   - at least one transversal optical sensor (160), wherein one of the electrodes (166, 174) is an electrode layer (222) having a low electrical conductivity designated to determine a position at which the incident light beam (132) impinged the sensor region (130), wherein the transversal optical sensor (160) is designed to generate at least one transversal sensor signal dependent on the position at which the incident light beam (132) impinged the sensor region (130), wherein the evaluation device (150) is designed to generate at least one item of information on a transversal position of the object (112) by evaluating the transversal sensor signal.

3. The detector (110) according to any one of the preceding claims, wherein the insulating layer (178) comprises an insulating material or an electrically insulating component.

4. The detector (110) according to the preceding claim, wherein the insulating material comprises at least one transparent insulating metal-containing compound, wherein the metal-containing compound comprises a metal selected from the group consisting of Al, Ti, Ta, Mn, Mo, Zr, Hf, La, Y, and W, wherein the at least one metal-containing compound is selected from the group comprising an oxide, a hydroxide, a chalcogenide, a pnictide, a carbide, or a combination thereof.

5. The detector (110) according to the preceding claim, wherein the insulating material is obtainable by atomic layer deposition.

6. The detector (110) according to any one of the preceding claims, wherein the photosensitive layer (180) is provided as one or more of

   - at least one layer comprising at least one photoconductive material in a nanoparticulate form;
   - at least two individual photoconductive layers (188, 188') comprising at least one photoconductive material and provided as adjacent layers having at least one boundary, wherein the photoconductive layers are adapted to generate a junction (190) at the boundary between the adjacent layers;
   - at least one semiconductor absorber layer (196); and
   - at least one organic photosensitive layer (198) comprising at least one electron donor material and at least one electron acceptor material.

7. The detector (110) according to the preceding claim, wherein the photoconductive material is an inorganic photoconductive material selected from a group consisting of group IV elements, group IV compounds, III-V compounds, group II-VI compounds, and chalcogenides.

8. The detector (110) according to claim 6, wherein the semiconductor absorber layer (196) comprises one or more of crystalline silicon (c-Si), microcrystalline silicon ($\mu$c-Si), hydrogenated microcrystalline silicon ($\mu$c-Si:H), amorphous silicon (a-Si), hydrogenated amorphous silicon (a-Si:H), an amorphous silicon carbon alloy (a-SiC), a hydrogenated amorphous silicon carbon alloy (a-SiC:H), a germanium silicon alloy (a-GeSi), or a hydrogenated amorphous germanium silicon alloy (a-GeSi:H).

9. The detector (110) according to claim 6, wherein the organic photosensitive layer (198) comprises an individual donor material layer (234) comprising the donor material and an individual acceptor material layer (236) comprising the acceptor material or wherein the donor material and the acceptor material in the organic photosensitive layer (198) are arranged as a single layer comprising the donor material and the acceptor material.

10. The detector (110) according to the preceding claim, wherein the donor material is selected from a small organic molecule comprising a phthalocyanine derivative, an oligothiophene, an oligothiophene derivative, a 4,4-difluoro-4-bora-3a,4a-diaza-s-indacene (**BODIPY**) derivative, an aza-**BODIPY** derivative, a squaraine derivative, a diketopyrrolopyrrol derivative, or a benzdithiophene derivative, and wherein the acceptor material is selected from C60, C70, or a perylene derivative.

11. The detector (110) according to claim 8, wherein the electron donor material comprises an organic donor polymer and wherein the electron acceptor material comprises a fullerene-based electron acceptor material, wherein the organic donor polymer is selected from one or more of

   - poly[3-hexylthiophene-2,5.diyl] (**P3HT**),
   - poly[3-(4-n-octyl)-phenylthiophene] (**POPT**),
   - poly[3-10-n-octyl-3-phenothiazine-vinylenethiophene-co-2,5-thiophene] (**PTZV-PT**), poly[4,8-bis[(2-ethylhexyl)oxy]benzo[1,2-*b*:4,5-*b'*]dithiophene-2,6-diyl][3-fluoro-2-[(2-ethylhexyl)carbonyl]thieno[3,4-*b*]thiophenediyl] (**PTB7**),
   - poly[thiophene-2,5-diyl-*alt*-[5,6-bis(dodecyloxy)benzo[c][1,2,5]thiadiazole]-4,7-diyl] (**PBT-T1**),
   - poly[2,6-(4,4-bis-(2-ethylhexyl)-4*H*-cyclopenta[2,1-*b*;3,4-*b*]dithiophene)-*alt*-4,7(2,1,3-benzothiadiazole)] (**PCPDTBT**),
   - poly[5,7-bis(4-decanyl-2-thienyl)-thieno(3,4-*b*)diathiazolethiophene-2,5] (PDDTT),
   - poly[N-9'-heptadecanyl-2,7-carbazole-alt-5,5-(4',7'-di-2-thienyl-2',1',3'-benzothiadiazole)] (**PCDTBT**), or
   - poly[(4,4'-bis(2-ethylhexyl)dithieno[3,2-*b*;2',3'-*d*]silole)-2,6-diyl-*alt*-(2,1,3-benzothiadiazole)-4,7-diyl] (**PSBTBT**),
   - poly[3-phenyl hydrazone thiophene] (**PPHT**),
   - poly[2-methoxy-5-(2-ethylhexyloxy)-1,4-phenylenevinylene] (**MEH-PPV**),
   - poly[2-methoxy-5-(2'-ethylhexyloxy)-1,4-phenylene-1,2-ethenylene-2,5-dimethoxy-1,4-phenylene-1,2-ethenylene] (**M3EH-PPV**),
   - poly[2-methoxy-5-(3',7'-dimethyloctyloxy)-1,4-phenylenevinylene] (**MDMO-PPV**),
   - poly[9,9-di-octylfluorene-co-bis-N,N-4-butylphenyl-bis-N,N-phenyl-1,4-phenylenediamine] (**PFB**),
   or a derivative, a modification, or a mixture thereof, and
   wherein the fullerene-based electron acceptor material is selected from one or more of
   - [6,6]-phenyl-C61-butyric acid methyl ester (**PC60BM**),
   - [6,6]-Phenyl-C71-butyric acid methyl ester (**PC70BM**),
   - [6,6]-phenyl C84 butyric acid methyl ester (**PC84BM**),
   - an indene-C60 bisadduct (**ICBA**),
   or a derivative, a modification, or a mixture thereof.

12. The detector (110) according to any one of the preceding claims, wherein the capacitive device (134) further comprises at least one charge-carrier transporting layer (182), wherein the charge-carrier transporting layer (182) is located between the photosensitive layer (180) and one of the electrodes (166, 174).

13. The detector (110) according to any one of the preceding claims, wherein the detector furthermore comprises at least one modulation device (144) for modulating the illumination.

14. A method for an optical detection of at least one object (112), the method comprising:

- generating at least one sensor signal by using at least one optical sensor having a sensor region (130), wherein the sensor signal is dependent on an illumination of the sensor region (130) of the optical sensor by an incident modulated light beam (132), wherein the sensor signal is further dependent on a modulation frequency of the light beam (132), wherein the sensor region (130) comprises at least one capacitive device (134), the capacitive device (134) comprising at least two electrodes (166, 174), wherein at least one insulating layer (178) and at least one photosensitive layer (180) are embedded between the electrodes (166, 174), wherein at least one of the electrodes (166, 174) is at least partially optically transparent for the light beam (132); and
- evaluating the sensor signal of the optical sensor by determining an item of information on the position of the object (112) from the sensor signal.

15. A use of a detector (110) according to any one of the preceding claims referring to a detector (110), for a purpose of use, selected from the group consisting of: a distance measurement, in particular in traffic technology; a position measurement, in particular in traffic technology; an entertainment application; a security application; a human-machine interface application; a tracking application; a logistics application; a machine vision application; a safety application; a surveillance application; a data collection application; a scanning application, a photography application; an imaging application or camera application; a mapping application for generating maps of at least one space.

**Patentansprüche**

1. Detektor (110) zum optischen Detektieren von mindestens einem Objekt (112), Folgendes umfassend

- mindestens einen optischen Sensor, wobei der optische Sensor mindestens einen Sensorbereich (130) aufweist, wobei der optische Sensor entworfen ist, um mindestens ein Sensorsignal in einer Weise zu erzeugen, die von einer Beleuchtung des Sensorbereichs (130) durch einen einfallenden modulierten Lichtstrahl (132) abhängig ist, wobei das Sensorsignal von einer Modulationsfrequenz des Lichtstrahls (132) abhängig ist, wobei der Sensorbereich (130) mindestens eine kapazitive Vorrichtung (134) umfasst, wobei die kapazitive Vorrichtung (134) mindestens zwei Elektroden (166, 174) umfasst, wobei mindestens eine Isolierschicht (178) und mindestens eine lichtempfindliche Schicht (180) zwischen den Elektroden (166, 174) eingebettet sind, wobei mindestens eine der Elektroden (166, 174) für den Lichtstrahl (132) mindestens teilweise optisch durchsichtig ist; und
- mindestens eine Auswertungsvorrichtung (150), wobei die Auswertungsvorrichtung (150) entworfen ist, um mindestens eine Informationseinheit über eine Position des Objekts (112) durch Auswerten des Sensorsignals zu erzeugen.

2. Detektor (110) nach dem vorhergehenden Anspruch, wobei der optische Sensor ausgewählt ist aus

- mindestens einem longitudinalen optischen Sensor (114), wobei der longitudinale optische Sensor (114) entworfen ist, um mindestens ein longitudinales Sensorsignal zu erzeugen, wobei das longitudinale Sensorsignal, bei der gleichen Gesamtleistung der Beleuchtung, weiterhin von einem Strahlquerschnitt des Lichtstrahls (132) in dem Sensorbereich (130) abhängig ist, wobei die Auswertungsvorrichtung (150) entworfen ist, um mindestens eine Informationseinheit über eine longitudinale Position des Objekts (112) durch Auswerten des longitudinalen Sensorsignals zu erzeugen; oder
- mindestens einen transversalen optischen Sensor (160), wobei eine der Elektroden (166, 174) eine Elektrodenschicht (222) mit einer geringen elektrischen Leitfähigkeit ist, die vorgesehen ist, um eine Position zu bestimmen, auf die der einfallende Lichtstrahl (132) auf den Sensorbereich (130) auftrifft, wobei der transversale optische Sensor (160) entworfen ist, um mindestens ein transversales Sensorsignal zu erzeugen, das von der Position abhängig ist, auf die der einfallende Lichtstrahl (132) auf den Sensorbereich (130) auftrifft, wobei die Auswertungsvorrichtung (150) entworfen ist, um mindestens eine Informationseinheit über eine transversale Position des Objekts (112) durch Auswerten des transversalen Sensorsignals zu erzeugen.

3. Detektor (110) nach einem der vorhergehenden Ansprüche, wobei die Isolierschicht (178) ein isolierendes Material oder eine elektrisch isolierende Komponente umfasst.

4. Detektor (110) nach dem vorhergehenden Anspruch, wobei das isolierende Material mindestens eine durchsichtige isolierende metallenthaltende Verbindung umfasst, wobei die metallenthaltende Verbindung ein Metall umfasst, das aus der Gruppe ausgewählt ist, bestehend aus Al, Ti, Ta, Mn, Mo, Zr, Hf, La, Y und W, wobei die mindestens eine metallenthaltende Verbindung aus der Gruppe ausgewählt ist, die ein Oxid, ein Hydroxid, ein Chalkogenid, ein Pniktid, ein Carbid oder eine Kombination davon umfasst.

5. Detektor (110) nach dem vorhergehenden Anspruch, wobei das isolierende Material durch Atomlagenabscheidung erhältlich ist.

6. Detektor (110) nach einem der vorhergehenden Ansprüche, wobei die lichtempfindliche Schicht (180) als eine oder mehrere der Folgenden bereitgestellt ist

- mindestens eine Schicht, die mindestens ein photoleitendes Material in einer Nanopartikelgestalt umfasst;
- mindestens zwei individuelle photoleitende Schichten (188, 188'), die mindestens ein photoleitendes Material umfassen und als benachbarte Schichten mit mindestens einer Begrenzung bereitgestellt sind, wobei die photoleitenden Schichten eingerichtet sind, um einen Übergang (190) an der Begrenzung zwischen den benachbarten Schichten zu erzeugen;
- mindestens eine Halbleiterabsorberschicht (196); und
- mindestens eine organische lichtempfindliche Schicht (198), die mindestens ein Elektronendonormaterial und mindestens ein Elektronenakzeptormaterial umfasst.

7. Detektor (110) nach dem vorhergehenden Anspruch, wobei das photoleitende Material ein anorganisches photoleitendes Material ist, das aus einer Gruppe ausgewählt ist, bestehend aus Elementen der Gruppe IV, Verbindungen der Gruppe IV, Verbindungen der Gruppen III und V, Verbindungen der Gruppen II und VI und Chalkogeniden.

8. Detektor (110) nach Anspruch 6, wobei die Halbleiterabsorberschicht (196) ein oder mehrere Stoffe aus kristallinem Silizium (c-Si), mikrokristallinem Silizium ($\mu$c-Si), hydriertem mikrokristallinem Silizium ($\mu$c-Si:H), amorphem Silizium (a-Si), hydriertem amorphem Silizium (a-Si:H), einer amorphen Silizium-KohlenstoffLegierung (a-SiC), einer hydrierten amorphen Silizium-Kohlenstoff-Legierung (a-SiC:H), einer Germanium-Silizium-Legierung (a-GeSi) oder einer hydrierten amorphen Germanium-Silizium-Legierung (a-GeSi:H) umfasst.

9. Detektor (110) nach Anspruch 6, wobei die organische lichtempfindliche Schicht (198) eine individuelle Donormaterialschicht (234), die das Donormaterial umfasst, und eine individuelle Akzeptormaterialschicht (236) umfasst, die das Akzeptormaterial umfasst, oder wobei das Donormaterial und das Akzeptormaterial in der organischen lichtempfindlichen Schicht (198) als eine einzelne Schicht angeordnet sind, die das Donormaterial und das Akzeptormaterial umfasst.

10. Detektor (110) nach dem vorhergehenden Anspruch, wobei das Donormaterial ausgewählt ist aus einem kleinen organischen Molekül, umfassend ein Phthalocyanin-Derivat, ein Oligothiophen, ein Oligothiophen-Derivat, ein 4,4-Difluor-4-bor-3a,4a-diaza-s-indacen-(**BODIPY**)-Derivat, ein Aza-**BODIPY**-Derivat, ein Squarain-Derivat, ein Diketopyrrolpyrrol-Derivat oder ein Benzdithiophen-Derivat, und wobei das Akzeptormaterial ausgewählt ist aus C60, C70 oder einem Perylen-Derivat.

11. Detektor (110) nach Anspruch 8, wobei das Elektronendonormaterial ein organisches Donor-Polymer umfasst und wobei das Elektronenakzeptormaterial ein Fulleren-basiertes Elektronenakzeptormaterial umfasst, wobei das organische Donor-Polymer ausgewählt ist aus einem oder mehreren der Folgenden

- Poly-[3-Hexylthiophen-2,5-diyl] (**P3HT**),
- Poly-[3-(4-n-Octyl)-phenylthiophen] **(POPT),**
- Poly-[3-10-n-Octyl-3-phenothiazinvinylenthiophen-co-2,5-thiophen] (**PTZV-PT**), Poly-[4,8-bis-[(2-Ethylhexyl)oxy]benzo[1,2-b:4,5-b]dithiophen-2,6-diyl][3-Fluor-2-[(2-ethylhexyl)carbonyl]thieno[3,4-*b*]thiophendiyl] (**PTB7**),
- Poly-[Thiophen-2,5-diyl-*alt*-[5,6-bis-(dodecyloxy)benzo[c][1,2,5]thiadiazol]-4,7-diyl] (**PBT-T1**),
- Poly-[2,6-(4,4-bis-(2-Ethylhexyl)-4H-cyclopenta[2,1-*b*;3,4-*b*]dithiophen)-*alt*-4,7(2,1,3-benzothiadiazol)] (**PCPDTBT**),
- Poly-[5,7-bis-(4-Decanyl-2-thienyl)-thieno(3,4-*b*)diathiazolthiophen-2,5] (**PDDTT**),
- Poly-[N-9'-Heptadecanyl-2,7-carbazol-*alt*-5,5-(4',7'-di-2-thienyl-2',1',3'-benzothiadiazol)] (**PCDTBT**) oder
- Poly-[(4,4'-bis-(2-Ethylhexyl)dithieno[3,2-*b*;2',3'-*d*]silol)-2,6-diyl-*alt*-(2,1,3-benzothiadiazol)-4,7-diyl] (**PSBTBT**),
- Poly-[3-Phenylhydrazonthiophen] (**PPHT**),
- Poly-[2-Methoxy-5-(2-ethylhexyloxy)-1,4-phenylenvinylen] (**MEH-PPV**),

- Poly-[2-Methoxy-5-(2'-ethylhexyloxy)-1,4-phenylen-1,2-ethenylen-2,5-dimethoxy-1,4-phenylen-1,2-ethenylen] (**M3EH-PPV**),
- Poly-[2-Methoxy-5-(3',7'-dimethyloctyloxy)-1,4-phenylenvinylen] (**MDMO-PPV**),
- Poly-[9,9-dioctylfluoren-co-bis-N,N-4-butylphenyl-bis-N,N-phenyl-1,4-phenylendiamin] (**PFB**),
oder ein Derivat, eine Modifizierung oder eine Mischung davon, und
wobei das Fulleren-basierte Elektronenakzeptormaterial ausgewählt ist aus einem oder mehreren der Folgenden
- [6,6]-Phenyl-C61-buttersäuremethylester (**PC60BM**),
- [6,6]-Phenyl-C71-buttersäuremethylester (**PC70BM**),
- [6,6]-Phenyl-C84-buttersäuremethylester (**PC84BM**),
- ein Inden-C60-bis-Addukt (**ICBA**),
oder ein Derivat, eine Modifizierung oder eine Mischung davon.

**12.** Detektor (110) nach einem der vorhergehenden Ansprüche, wobei die kapazitive Vorrichtung (134) weiterhin mindestens eine Ladungsträgertransportschicht (182) umfasst, wobei die Ladungsträgertransportschicht (182) zwischen der lichtempfindlichen Schicht (180) und einer der Elektroden (166, 174) angeordnet ist.

**13.** Detektor (110) nach einem der vorhergehenden Ansprüche, wobei der Detektor weiterhin mindestens eine Modulationsvorrichtung (144) zum Modulieren der Beleuchtung umfasst.

**14.** Verfahren für eine optische Detektion von mindestens einem Objekt (112), das Verfahren Folgendes umfassend:

- Erzeugen mindestens eines Sensorsignals unter Verwendung mindestens eines optischen Sensors mit einem Sensorbereich (130), wobei das Sensorsignal von einer Beleuchtung des Sensorbereichs (130) des optischen Sensors durch einen einfallenden modulierten Lichtstrahl (132) abhängig ist,
wobei das Sensorsignal weiterhin von einer Modulationsfrequenz des Lichtstrahls (132) abhängig ist, wobei der Sensorbereich (130) mindestens eine kapazitive Vorrichtung (134) umfasst, wobei die kapazitive Vorrichtung (134) mindestens zwei Elektroden (166, 174) umfasst, wobei mindestens eine Isolierschicht (178) und mindestens eine lichtempfindliche Schicht (180) zwischen den Elektroden (166, 174) eingebettet sind, wobei mindestens eine der Elektroden (166, 174) für den Lichtstrahl (132) mindestens teilweise optisch durchsichtig ist; und
- Auswerten des Sensorsignals des optischen Sensors durch Bestimmen einer Informationseinheit über die Position des Objekts (112) aus dem Sensorsignal.

**15.** Verwenden eines Detektors (110) nach einem der vorhergehenden Ansprüche unter Bezugnahme auf einen Detektor (110), der zu einem Zweck einer Verwendung aus der Gruppe ausgewählt ist, bestehend aus: einer Entfernungsmessung, insbesondere in der Verkehrstechnik; einer Positionsmessung, insbesondere in der Verkehrstechnik; einer Unterhaltungsanwendung; einer Sicherheitsanwendung; einer Mensch-Maschine-Schnittstellenanwendung; einer Nachverfolgungsanwendung; einer Logistikanwendung; einer Maschinensehen-Anwendung; einer Sicherheitsanwendung; einer Überwachungsanwendung; eine Datensammelanwendung; einer Scan-Anwendung, einer Photographieanwendung; einer Abbildungsanwendung oder Kameraanwendung; einer Kartographieanwendung zum Erzeugen von topographischen Darstellungen von mindestens einem Raum.

**Revendications**

**1.** Détecteur (110) destiné à détecter optiquement au moins un objet (112), comprenant

- au moins un capteur optique, le capteur optique ayant au moins une région de capteur (130), le capteur optique étant conçu pour générer au moins un signal de capteur d'une manière dépendant d'un éclairage de la région de capteur (130) par un faisceau lumineux modulé incident (132), le signal de capteur dépendant d'une fréquence de modulation du faisceau lumineux (132), la région de capteur (130) comprenant au moins un dispositif capacitif (134), le dispositif capacitif (134) comprenant au moins deux électrodes (166, 174), au moins une couche isolante (178) et au moins une couche photosensible (180) étant incorporées entre les électrodes (166, 174), au moins une des électrodes (166, 174) étant au moins partiellement optiquement transparente pour le faisceau lumineux (132) ; et
- au moins un dispositif d'évaluation (150), le dispositif d'évaluation (150) étant conçu pour générer au moins un élément d'information sur une position de l'objet (112) en évaluant le signal de capteur.

**2.** Détecteur (110) selon la revendication précédente, dans lequel le capteur optique est choisi parmi

- au moins un capteur optique longitudinal (114), le capteur optique longitudinal (114) étant conçu pour générer au moins un signal de capteur longitudinal, le signal de capteur longitudinal, étant donné la même puissance totale de l'éclairage, dépendant en outre d'une section transversale de faisceau du faisceau lumineux (132) dans la région de capteur (130), le dispositif d'évaluation (150) étant conçu pour générer au moins un élément d'information sur une position longitudinale de l'objet (112) en évaluant le signal de capteur longitudinal ; ou
- au moins un capteur optique transversal (160), une des électrodes (166, 174) étant une couche d'électrode (222) ayant une faible conductivité électrique conçue pour déterminer une position à laquelle le faisceau lumineux incident (132) a frappé la région de capteur (130), le capteur optique transversal (160) étant conçu pour générer au moins un signal de capteur transversal dépendant de la position à laquelle le faisceau lumineux incident (132) a frappé la région de capteur (130), le dispositif d'évaluation (150) étant conçu pour générer au moins un élément d'information sur une position transversale de l'objet (112) en évaluant le signal de capteur transversal.

**3.** Détecteur (110) selon l'une quelconque des revendications précédentes, dans lequel la couche isolante (178) comprend un matériau isolant ou un composant électriquement isolant.

**4.** Détecteur (110) selon la revendication précédente, dans lequel le matériau isolant comprend au moins un composé contenant un métal transparent isolant, le composé contenant un métal comprenant un métal choisi dans le groupe constitué par Al, Ti, Ta, Mn, Mo, Zr, Hf, La, Y et W, l'au moins un composé contenant un métal étant choisi dans le groupe comprenant un oxyde, un hydroxyde, un chalcogénure, un pnicture, un carbure, ou une combinaison de ceux-ci.

**5.** Détecteur (110) selon la revendication précédente, dans lequel le matériau isolant peut être obtenu par dépôt de couches atomiques.

**6.** Détecteur (110) selon l'une quelconque des revendications précédentes, dans lequel la couche photosensible (180) est obtenue sous une ou plusieurs formes parmi

- au moins une couche comprenant au moins un matériau photoconducteur sous forme de nanoparticules ;
- au moins deux couches photoconductrices individuelles (188, 188') comprenant au moins un matériau photoconducteur et obtenues sous forme de couches adjacentes ayant au moins une frontière, les couches photoconductrices étant adaptées pour générer une jonction (190) à la frontière entre les couches adjacentes ;
- au moins une couche d'absorbeur semi-conducteur (196) ; et
- au moins une couche photosensible organique (198) comprenant au moins un matériau donneur d'électrons et au moins un matériau accepteur d'électrons.

**7.** Détecteur (110) selon la revendication précédente, dans lequel le matériau photoconducteur est un matériau photoconducteur inorganique choisi dans un groupe constitué par les éléments du groupe IV, les composés du groupe IV, les composés III-V, les composés des groupes II-VI, et les chalcogénures.

**8.** Détecteur (110) selon la revendication 6, dans lequel la couche d'absorbeur semi-conducteur (196) comprend un ou plusieurs éléments parmi du silicium cristallin (c-Si), du silicium microcristallin (μc-Si), du silicium microcristallin hydrogéné (μc-Si:H), du silicium amorphe (a-Si), du silicium amorphe hydrogéné (a-Si:H), un alliage silicium-carbone amorphe (a-SiC), un alliage silicium-carbone amorphe hydrogéné (a-SiC:H), un alliage germanium-silicium (a-GeSi), et un alliage germanium-silicium amorphe hydrogéné (a-GeSi:H).

**9.** Détecteur (110) selon la revendication 6, dans lequel la couche photosensible organique (198) comprend une couche de matériau donneur individuelle (234) comprenant le matériau donneur et une couche de matériau accepteur individuelle (236) comprenant le matériau accepteur, ou dans lequel le matériau donneur et le matériau accepteur dans la couche photosensible organique (198) sont agencés comme une seule couche comprenant le matériau donneur et le matériau accepteur.

**10.** Détecteur (110) selon la revendication précédente, dans lequel le matériau donneur est choisi à partir d'une petite molécule organique comprenant un dérivé de phtalocyanine, un oligothiophène, un dérivé d'oligothiophène, un dérivé de 4,4-difluoro-4-bora-3a,4a-diaza-s-indacène (**BODIPY**), un dérivé d'aza-**BODIPY**, un dérivé de squaraïne, un dérivé de dicétopyrrolopyrrole, ou un dérivé de benzodithiophène, et dans lequel le matériau accepteur est choisi parmi un C60, un C70, et un dérivé de pérylène.

**11.** Détecteur (110) selon la revendication 8, dans lequel le matériau donneur d'électrons comprend un polymère donneur organique et dans lequel le matériau accepteur d'électrons comprend un matériau accepteur d'électrons à base de fullerène, le polymère donneur organique étant choisi à partir d'un ou plusieurs composés parmi

- le poly[3-hexylthiophène-2,5-diyle] (**P3HT**),
- le poly[3-(4-n-octyl)-phénylthiophène] (**POPT**),
- le poly[3-10-n-octyl-3-phénothiazine-vinylène-thiophène-co-2,5-thiophène] (**PTZV-PT**),
- le poly[4,8-bis[(2-éthylhexyl)oxy]benzo[1,2-*b*:4,5-*b*]dithiophène-2,6-diyl][3-fluoro-2-[(2-éthyl-hexyl)carbonyl]thiéno[3,4-*b*]thiophènediyle] (**PTB7**),
- le poly[thiophène-2,5-diyl-*alt*-[5,6-bis(dodécyl-oxy)benzo[c][1,2,5]thiadiazole]-4,7-diyle] (**PBT-T1**),
- le poly[2,6-(4,4-bis-(2-éthylhexyl)-4H-cyclopenta[2,1-*b*;3,4-*b*]dithiophène)-*alt*-4,7-(2,1,3-benzothiadiazole)] (**PCPDTBT**),
- le poly[5,7-bis(4-décanyl-2-thiényl)-thiéno(3,4-b)diathiazolethiophène-2,5] (**PDDTT**),
- le poly[N-9'-heptadécanyl-2,7-carbazole-*alt*-5,5-(4',7'-di-2-thiényl-2',1',3'-benzothiadiazole)] (**PCDTBT**), ou
- le poly[(4,4'-bis(2-éthylhexyl)dithiéno[3,2-*b*;2',3'-*d*]silole)-2,6-diyl-*alt*-(2,1,3-benzothiadiazole)-4,7-diyle] (**PSBTBT**),
- le poly[3-phényl-hydrazone-thiophène] (**PPHT**),
- le poly[2-méthoxy-5-(2-éthylhexyloxy)-1,4-phénylènevinylène] (**MEH-PPV**),
- le poly[2-méthoxy-5-(2'-éthylhexyloxy)-1,4-phénylène-1,2-éthénylène-2,5-diméthoxy-1,4-phénylène-1,2-éthénylène] (**M3EH-PPV**),
- le poly[2-méthoxy-5-(3',7'-diméthyloctyloxy)-1,4-phénylènevinylène] (**MDMO-PPV**),
- la poly[9,9-di-octylfluorène-co-bis-N,N-4-butylphényl-bis-N,N-phényl-1,4-phénylènediamine] (**PFB**), ou un dérivé, une modification ou un mélange de ceux-ci, et
dans lequel le matériau accepteur d'électrons à base de fullerène est choisi à partir d'un ou plusieurs composés parmi
- l'ester méthylique d'acide [6,6]-phényl-C61-butyrique (**PC60BM**),
- l'ester méthylique d'acide [6,6]-phényl-C71-butyrique (**PC70BM**),
- l'ester méthylique d'acide [6,6]-phényl-C84-butyrique (**PC84BM**),
- un bisadduit d'indène-C60 (**ICBA**),
ou un dérivé, une modification ou un mélange de ceux-ci.

**12.** Détecteur (110) selon l'une quelconque des revendications précédentes, dans lequel le dispositif capacitif (134) comprend en outre au moins une couche de transport de porteurs de charge (182), la couche de transport de porteurs de charge (182) étant située entre la couche photosensible (180) et une des électrodes (166, 174).

**13.** Détecteur (110) selon l'une quelconque des revendications précédentes, le détecteur comprenant en outre au moins un dispositif de modulation (144) pour moduler l'éclairage.

**14.** Procédé de détection optique d'au moins un objet (112), le procédé comprenant :

- la génération d'au moins un signal de capteur au moyen d'au moins un capteur optique ayant une région de capteur (130), le signal de capteur dépendant d'un éclairage de la région de capteur (130) du capteur optique par un faisceau lumineux modulé incident (132), le signal de capteur dépendant en outre d'une fréquence de modulation du faisceau lumineux (132), la région de capteur (130) comprenant au moins un dispositif capacitif (134), le dispositif capacitif (134) comprenant au moins deux électrodes (166, 174), au moins une couche isolante (178) et au moins une couche photosensible (180) étant incorporées entre les électrodes (166, 174), au moins une des électrodes (166, 174) étant au moins partiellement optiquement transparente pour le faisceau lumineux (132) ; et
- l'évaluation du signal de capteur du capteur optique par détermination d'un élément d'information sur la position de l'objet (112) à partir du signal de capteur.

**15.** Utilisation d'un détecteur (110) selon l'une quelconque des revendications précédentes se référant à un détecteur (110), en vue d'une utilisation choisie dans le groupe constitué par : la mesure d'une distance, en particulier dans la technologie du trafic ; la mesure d'une position, en particulier dans la technologie du trafic ; une application de divertissement ; une application de sécurité ; une application d'interface homme-machine ; une application de poursuite ; une application de logistique ; une application de vision industrielle ; une application de sûreté ; une application de surveillance ; une application de collecte de données ; une application de balayage ; une application photographique ; une application d'imagerie ou une application de caméra ; une application de cartographie pour générer des cartes d'au moins un espace.

Fig. 1

Fig. 2 A

Fig. 2 B

134

174, 176 — Ag
180 — np-PbS
178 — Al$_2$O$_3$ (ALD)
166, 168 — ITO
172 — glass
132

Fig. 3 A

134

174, 176 — Ag
182 — Mo O$_3$
180 — np-PbS
178 — Al$_2$O$_3$ (ALD)
166, 168 — FTO
172 — glass
132

Fig. 3 B

$I_p$ [nA]

d [mm]

3B

850 nm

Fig. 3 C

Fig. 3 D

Fig. 3 E

Fig. 3 F

Fig. 3 G

Fig. 3 H

Fig. 3 I

Fig. 3 J

Fig. 3 K

Fig. 3 L

Fig. 3 M

3A

$I_p$ [nA]

3B

d [ mm ]

Fig. 3 N

134

| Ag | 174, 176 |
|---|---|
| Al$_2$O$_3$ (ALD) | 178 |
| CdTe | 188 |
| CdS | 188′ |
| Sn O$_2$ | 182 |
| ITO | 166, 168 |
| glass | 172 |

192

180 190

132

Fig. 4 A

EP 3 580 584 B1

850 nm
375 Hz

1000 mA
750 mA
500 mA
250 mA
100 mA
20 mA
1 mA

Fig. 4 B

850 nm
375 Hz

1000 mA
750 mA
500 mA
250 mA
100 mA
20 mA
1 mA

Fig. 4 C

Fig. 4 D

Fig. 4 E

Fig. 4 F

Fig. 4 G

134

132

| ITO | 166, 168 |
| Al₂O₃ (ALD) | 178 |
| CdS | 188′ |
| CZTS | 188 |
| Mo | 174, 176 |
| | 172 |

180 { 190

**Fig. 5 A**

134

132

| ITO | 166, 168 |
| ZR O₂ | |
| Al₂O₃ | 178 |
| CdS | 188′ |
| CZTS | 188 |
| Mo | 174, 176 |
| | 172 |

180 { 190

**Fig. 5 B**

194

5B

5A

0.36 µW
375 Hz

**Fig. 5 C**

Fig. 5 D

Fig. 5 E

Fig. 5 F

Fig. 5 G

Fig. 5 H

Fig. 5 I

Fig. 6 A

Fig. 6 B

Fig. 6 C

Fig. 6 D

Fig. 6 E

Fig. 7 A

Fig. 7 B

660 nm
375 Hz

165 µW
142 µW
106 µW
61.7 µW
29.8 µW
8.82 µW

d [mm]

Fig. 7 C

186

184

f [Hz]

Fig. 7 D

Fig. 7 E

Fig. 7 F

Fig. 7 G

Fig. 7 H

Fig. 7 I

Fig. 7 J

Fig. 7 K

Fig. 7 L

Fig. 7 M

Fig. 8

Fig. 9 A

Fig. 9 B

Fig. 9 C

134

174, 176
182, 238
180, 198 {190} 236
234
178
166, 168

132

Fig. 10 A

134

174, 176
182, 240
180, 198 {190} 234
236
178
166, 168

132

Fig. 10 B

134

| Ag | 174, 176 |
| NDP | 246 |
| p-BPAPF | 244 |
| BPAPF | 240 |
| F4ZnPc : C60 | 180, 234, 236 |
| C60 | 238 |
| n - C60 | 242 |
| Al₂O₃ (ALD) | 178 |
| ITO | 166, 168 |

$Al_2O_3$ (ALD)

182

Fig. 10 C

## REFERENCES CITED IN THE DESCRIPTION

**Patent documents cited in the description**

- WO 2012110924 A1
- WO 2014097181 A1
- WO 2016092454 A1
- WO 2016120392 A1
- EP 2818493 A1
- WO 2014086722 A1
- US 20150132887 A1
- US 20150111337 A1
- US 20140217329 A1

**Non-patent literature cited in the description**

- **J. ROBERTSON.** High dielectric constant oxides. *The European Physical Journal Applied Physics,* 2004, vol. 28 (3), 265-291
- **L. BIANA ; E. ZHUA ; J. TANGA ; W. TANGA ; FU-JUN ZHANG.** *Progress in Polymer Science,* 2012, vol. 37, 1292-1331
- **A. FACCHETTI.** *Materials Today,* 2013, vol. 16 (4), 123-132
- **GEORGE.** *Chem. Rev.,* 2010, vol. 110, 111-131
- **J. ROBERTSON.** High dielectric constant oxides. *Eur. Phys. J. Appl. Phys.,* 2004, vol. 28, 265-291
- **J.A. KITTL et al.** High-k Dielectrics for Future Generation Memory Devices. *Microelectronic Engineering,* 2009, vol. 86, 1789-1795
- **L. BIANA ; E. ZHUA ; J. TANGA ; W. TANGA ; F. ZHANG.** *Progress in Polymer Science,* 2012, vol. 37, 1292-1331
- **A. FACCHETTI.** *Materials Today,* 2013, vol. 16 (4
- **S. GÜNES ; N. S. SARICIFTCI.** *Inorganica Chimica Acta,* 2008, vol. 361, 581-588
- **F.A. SPERLICH.** Electron Paramagnetic Resonance Spectroscopy of Conjugated Polymers and Fullerenes for Organic Photovoltaics. Julius-Maximilians-Universitat Würzburg, 2013
- **J.E. ANTHONY ; A. FACCHETTI ; M. HEENY ; S.R. MARDER ; X. ZHAN.** n-Type Organic Semiconductors in Organic Electronics. *Adv. Mater.,* 2010, vol. 22, 3876-3892
- **T.-Y. LI ; T. MEYER ; Z. MA ; J. BENDUHN ; C. KÖRNER ; O. ZEIKA ; K. VANDEWAL ; L. LEO.** Small Molecule Near-Infrared Boron Dipyrromethene Donors for Organic Tandem Solar Cells,. *J. Am. Chem. Soc.,* 2017, vol. 139, 13636-13639
- **C. UHRICH ; R. SCHUEPPEL ; A. PETRICH ; M. PFEIFFER ; K. LEO ; E. BRIER ; P. KILICKIRAN ; P. BAEUERLE.** Organic Thin-Film Photovoltaic Cells Based on Oligothiophenes with Reduced Bandgap. *Adv. Funct. Mater.,* 2007, vol. 17, 2991-2999
- **R. GRESSER ; M. HUMMERT ; H. HARTMANN ; K. LEO ; M. RIEDE.** Synthesis and Characterization of Near-Infrared Absorbing Benzannulated Aza-BODIPY Dyes. *Chem. Eur. J.,* 2011, vol. 17, 2939-2947
- **A. MISHRA ; P. BAUERLE.** Small Molecule Organic Semiconductors on the Move: Promises for Future Solar Energy Technology. *Angew. Chem. Int. Ed.,* 2012, vol. 51, 2020-2067
- **H. YAO ; L. YE ; H. ZHANG ; S. LI ; S. ZHANG ; J. HOU.** Molecular Design of Benzodithiophene-Based Organic Photovoltaic Materials. *Chem. Rev.,* 2016, vol. 116, 7397-7457
- **M. RIEDE ; C. UHRICH ; J. WIDMER ; R. TIMMRECK ; D. WYNANDS ; G. SCHWARTZ ; W.-M. GNEHR ; D. HILDEBRANDT ; A. WEISS ; J. HWANG.** Efficient Organic Tandem Solar Cells based on Small Molecules. *Adv. Funct. Mater.,* 2011, vol. 21, 3019-3028
- **J. MEISS ; A. MERTEN ; M. HEIN ; C. SCHUENEMANN ; S. SCHAFER ; M. TIETZE ; C. UHRICH ; M. PFEIFFER ; K. LEO ; M. RIEDE.** Fluorinated Zinc Phthalocyanine as Donor for Efficient Vacuum-Deposited Organic Solar Cells. *Adv. Funct. Mater.,* 2012, vol. 22, 405-414
- **R. SCHUEPPEL ; R. TIMMRECK ; N. ALLINGER ; T. MUELLER ; M. FURNO ; C. UHRICH ; K. LEO ; M. RIEDE.** Controlled current matching in small molecule organic tandem solar cells using doped spacer layers. *J. Appl. Phys.,* 2010, vol. 107, 044503